(19) Europäisches Patentamt
European Patent Office
Office européen des brevets

(11) **EP 3 992 254 B1**

(12) **EUROPEAN PATENT SPECIFICATION**

(45) Date of publication and mention of the grant of the patent:
**21.02.2024 Bulletin 2024/08**

(21) Application number: **20830992.2**

(22) Date of filing: **22.06.2020**

(51) International Patent Classification (IPC):
***C08L 101/00*** *(2006.01)* ***C08F 2/44*** *(2006.01)*
***H01L 31/0232*** *(2014.01)* ***G02B 5/02*** *(2006.01)*
***C08K 3/013*** *(2018.01)*

(52) Cooperative Patent Classification (CPC):
(C-Sets available)
**C09D 151/003; C08F 2/44; C08F 265/06; C08K 3/013; G02B 5/0242;** C08K 2003/2227; C08K 2003/2241; C08K 2003/2244; C08K 2201/003; C08K 2201/011 (Cont.)

(86) International application number:
**PCT/JP2020/024280**

(87) International publication number:
**WO 2020/262270 (30.12.2020 Gazette 2020/53)**

(54) **COMPOSITION, FILM, AND OPTICAL SENSOR**

ZUSAMMENSETZUNG, FILM UND OPTISCHER SENSOR

COMPOSITION, FILM ET CAPTEUR OPTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.06.2019 JP 2019119230**
**27.04.2020 JP 2020077927**

(43) Date of publication of application:
**04.05.2022 Bulletin 2022/18**


(73) Proprietor: **FUJIFILM Corporation**
**Tokyo 106-8620 (JP)**

(72) Inventors:
- **MIYATA, Tetsushi**
  **Haibara-gun, Shizuoka 421-0396 (JP)**
- **MORI, Masahiro**
  **Haibara-gun, Shizuoka 421-0396 (JP)**
- **ARAYAMA, Kyohei**
  **Haibara-gun, Shizuoka 421-0396 (JP)**

(74) Representative: **HGF**
**HGF Limited**
**1 City Walk**
**Leeds LS11 9DX (GB)**


(56) References cited:
**EP-A1- 3 431 513** **WO-A1-2018/180116**
**JP-A- 2014 111 734** **US-A1- 2013 084 442**

EP 3 992 254 B1


Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 265/06, C08F 222/1006;**
**G02B 1/04, C08L 2666/72**

## Description

## BACKGROUND OF THE INVENTION

1. Field of the Invention

The present invention relates to a composition including particles having a high refractive index, a film, and an optical sensor.

2. Description of the Related Art

Titanium oxide is particles having a high refractive index. Attempts to use such particles having a high refractive index for a light scattering film or the like have been studied.

JP2016-161859A discloses an invention of a light scattering sheet including a plurality of polymers having different refractive indexes from each other and including a light scattering layer having a co-continuous phase structure in at least a part of a region, in which an incidence ray is isotropically transmitted and scattered, a scattering angle showing the maximal value of intensity of scattered light is 2° to 40°, and a total light transmittance is 70% to 100%. It is said that any continuous phase forming the co-continuous phase structure may include high refraction fine particles. EP 3 431 513 A1 discloses in the claims and the examples compositions comprising: - particles having a refractive index of 2.0 i.e. $TiO2$ or more and an average primary particle diameter of 200 nm or less; - a film-forming component including at least one selected from a resin or a polymerizable monomer; and - a solvent, a film having a light transmittance of the film in a wavelength range of 400 to 700 nm of 1% or more. EP 3 431 513 A1 does not disclose a composition which results in a phase-separated structure between a first phase including the particles and a second phase with a lower content of the particles than the first phase is formed in the film.

## SUMMARY OF THE INVENTION

In recent years, there has been an increasing demand for a film which appropriately blocks visible light and has high light scattering properties. In order to improve the light scattering properties of the film, a method of using particles having a large particle size and a high refractive index has been known. However, the particles having a high refractive index (hereinafter, also referred to as high-refractive particles) generally tend to have a large specific gravity. In a case where such particles having a large specific gravity are contained and used in a composition including a solvent, the particles may settle during storage of the composition. Therefore, with a known composition in the related art, it has been difficult to achieve both storage stability and light scattering properties of the obtained film at a high level.

In addition, since the light scattering sheet of the invention disclosed in JP2016-161859A is said to have a total light transmittance of 70% to 100%, the light scattering sheet of the invention disclosed in JP2016-161859A is not a member which appropriately blocks visible light, but rather has high visible light transmittance.

Accordingly, an object of the present invention is to provide a composition with which a film having good storage stability and excellent light scattering properties can be formed. In addition, another object of the present invention is to provide a film and an optical sensor.

As a result of thorough investigation under the above-described circumstances, the present inventor has found that the object of the present invention can be achieved by using a composition described below, thereby completing the present invention. The present invention provides the following.

<1> A composition comprising:

particles having a refractive index of 2.0 or more and an average primary particle diameter of 200 nm or less;
a film-forming component including at least one selected from a resin or a polymerizable monomer; and
a solvent,
in which the film-forming component includes two or more kinds of resins, or includes one or more kinds of resins and one or more kinds of polymerizable monomers, and
in a case where a film having a thickness of 4 μm is formed by heating the composition at 200°C for 5 minutes, a maximum value of a light transmittance of the film in a wavelength range of 400 to 700 nm is 80% or less, and a phase-separated structure between a first phase including the particles and a second phase with a lower content of the particles than the first phase is formed in the film.

<2> The composition according to <1>,
in which the film-forming component includes a resin as a dispersant for the particles, and a resin as a binder.

<3> The composition according to <1> or <2>,
in which the film-forming component includes two or more kinds of resins selected from a resin A1 having a structure in which a polymer chain is bonded to a tri- or higher valent linking group and a resin A2 having a repeating unit having a graft chain.
<4> The composition according to <3>,

in which the film-forming component includes a resin A1-1 having a structure in which a polymer chain is bonded to a tri- or higher valent linking group and a resin A1-2 having a structure in which a polymer chain including a repeating unit having a structure different from a structure of the polymer chain of the resin A1-1 is bonded to a tri- or higher valent linking group,
the film-forming component includes a resin A2-1 having a repeating unit having a graft chain and a resin A2-2 having a repeating unit having a graft chain, which includes a repeating unit having a structure different from a structure of the graft chain of the resin A2-1, or
the film-forming component includes a resin A1-3 having a structure in which a polymer chain is bonded to a tri- or higher valent linking group and a resin A2-3 having a repeating unit having a graft chain, which includes a repeating unit having a structure different from a structure of the polymer chain of the resin A1-3.

<5> The composition according to any one of <1> to <4>,
in which the film-forming component includes at least one kind selected from a resin having a structure in which a polymer chain including a repeating unit of a polyester structure is bonded to a tri- or higher valent linking group or a resin having a repeating unit having a graft chain, which includes a repeating unit of a polyester structure.
<6> The composition according to any one of <1> to <5>,
in which the film-forming component includes a polymerizable monomer including a ring structure.
<7> The composition according to <2>,
in which the resin as a binder is included in an amount of 40 to 250 parts by mass with respect to 100 parts by mass of the resin as a dispersant for the particles.
<8> The composition according to any one of <1> to <7>,
in which the particles are inorganic particles.
<9> The composition according to any one of <1> to <8>,
in which the average primary particle diameter of the particles is 100 nm or less.
<10> The composition according to any one of <1> to <9>,
in which the composition includes two or more kinds of the particles.
<11> A film which is formed of the composition according to any one of <1> to <10>.
<12> An optical sensor comprising:
the film according to <11>.

According to the present invention, it is possible to provide a composition with which a film having good storage stability and excellent light scattering properties can be formed. In addition, it is possible to provide a film and an optical sensor.

## BRIEF DESCRIPTION OF THE DRAWINGS

Fig. 1 is a schematic diagram showing an embodiment of an optical sensor according to an aspect of the present invention.
Fig. 2 is a schematic diagram showing another embodiment of the optical sensor according to the aspect of the present invention.

## DESCRIPTION OF THE PREFERRED EMBODIMENTS

Hereinafter, the details of the present invention will be described.
The following description regarding configuration requirements has been made based on a representative embodiment of the present invention. However, the present invention is not limited to the embodiment.
In this specification, numerical ranges represented by "to" include numerical values before and after "to" as lower limit values and upper limit values.
In this specification, unless specified as a substituted group or as an unsubstituted group, a group (atomic group) denotes not only a group (atomic group) having no substituent but also a group (atomic group) having a substituent.

For example, "alkyl group" denotes not only an alkyl group having no substituent (unsubstituted alkyl group) but also an alkyl group having a substituent (substituted alkyl group).

In this specification, "(meth)acrylate" represents acrylate or methacrylate, "(meth)acryl" represents acryl and methacryl, "(meth)allyl" represents allyl and methallyl, and "(meth)acryloyl" represents acryloyl and methacryloyl.

In this specification, in a chemical formula, Me represents a methyl group, Et represents an ethyl group, Pr represents a propyl group, Bu represents a butyl group, and Ph represents a phenyl group.

In this specification, unless specified otherwise, "exposure" denotes not only exposure using light but also drawing using a corpuscular beam such as an electron beam or an ion beam. Examples of the light used for exposure include an actinic ray or radiation, for example, a bright light spectrum of a mercury lamp, a far ultraviolet ray represented by excimer laser, an extreme ultraviolet ray (EUV ray), an X-ray, or an electron beam.

In this specification, a weight-average molecular weight and a number-average molecular weight are defined as values in terms of polystyrene measured by gel permeation chromatography (GPC). In this specification, the weight-average molecular weight (Mw) and the number-average molecular weight (Mn) can be obtained, for example, by using HLC-8220GPC (manufactured by Tosoh Corporation), using a column in which TOSOH TSK gel Super HZM-H, TOSOH TSK gel Super HZ4000, and TOSOH TSK gel Super HZ2000 are linked to each other, and using tetrahydrofuran as a developing solvent.

In this specification, a value of refractive index is a value of refractive index with refractive index to light at a wavelength of 589 nm at 23°C, unless otherwise specified.

<Composition>

A composition according to an embodiment of the present invention is a composition including particles having a refractive index of 2.0 or more and an average primary particle diameter of 200 nm or less, a film-forming component including at least one selected from a resin or a polymerizable monomer, and a solvent, in which the film-forming component includes two or more kinds of resins, or includes one or more kinds of resins and one or more kinds of polymerizable monomers, and in a case where a film having a thickness of 4 μm is formed by heating the composition at 200°C for 5 minutes, a maximum value of a light transmittance of the film in a wavelength range of 400 to 700 nm is 80% or less, and a phase-separated structure between a first phase including the particles and a second phase with a lower content of the particles than the first phase is formed in the film.

The composition according to the embodiment of the present invention has good storage stability. That is, many particles having a refractive index of 2.0 or more generally have a large specific gravity, but in the composition according to the embodiment of the present invention, since the particles having a relatively small particle diameter with an average primary particle diameter of 200 nm or less are used as the particles having a refractive index of 2.0 or more, sedimentation of the particles in the composition including a solvent can be suppressed, and as a result, excellent storage stability can be obtained. In addition, the composition according to the embodiment of the present invention is characterized in that, in a case where a film having a thickness of 4 μm is formed by heating the composition at 200°C for 5 minutes, the maximum value of the light transmittance in a wavelength range of 400 to 700 nm is 80% or less, and the phase-separated structure between the first phase including the particles and the second phase with a lower content of the particles than the first phase is formed in the film. Since such a phase-separated structure is formed in the film, in a case where the film formed of this composition is irradiated with light, scattering occurs between the first phase having a relatively high content of the particles and the second phase having a relatively low content of particles, and as a result, the light irradiated to the film can be efficiently scattered and transmitted. Therefore, by using the composition according to the embodiment of the present invention, a film having excellent light scattering properties can be formed. Furthermore, angle dependence of scattered light can be reduced.

A base material of the first phase and the second phase is the film-forming component or a cured substance derived from the film-forming component. In addition, mere aggregates of the above-described particles are one form of the particles, and the mere aggregates of the above-described particles themselves are not the first phase. The above-described first phase is a phase in which the above-described particles are present in the film-forming component or the cured substance derived from the film-forming component. In addition, it is sufficient that the second phase has a lower content of the above-described particles than the first phase, and the second phase may not substantially include the above-described particles. For the reason that it is easy to obtain more excellent light scattering properties, it is preferable that the second phase does not substantially include the above-described particles.

The formation of the phase-separated structure between the first phase and the second phase in the film can be observed using a scanning electron microscope (SEM), a transmission electron microscope (TEM), or an optical microscope. For example, the composition is applied to a support such as a glass substrate and heated at 200°C for 5 minutes to form a film having a thickness of 4 μm, and then a cross section of the obtained film in a thickness direction is observed using a scanning electron microscope (SEM), a transmission electron microscope (TEM), or an optical microscope. As a result, it is possible to investigate whether or not the phase-separated structure between the first phase

and the second phase is formed in the film.

The above-described formation of the phase-separated structure can be achieved by appropriately changing the type of the resin or the polymerizable monomer used in the film-forming component.

Examples of one aspect thereof include a method of using, as the film-forming component, a first resin and a second resin having low compatibility with the first resin. In a case where such a film-forming component is used, a phase-separated structure between a phase including the first resin as a main component and a phase including the second resin as a main component can be formed during film formation. For example, in a case where one of the first resin or the second resin is a resin as a particle dispersant and the other is a binder resin, many particles can be unevenly distributed in the phase including the resin as a dispersant as a main component.

In addition, examples of another aspect thereof include a method of using, as the film-forming component, a first resin and a polymerizable monomer having low compatibility with the first resin. In a case where such a film-forming component is used, a phase-separated structure between a phase including the first resin as a main component and a phase including a cured substance derived from the polymerizable monomer as a main component can be formed during film formation.

In addition, examples of still another aspect thereof include a method in which the type of the resin or the polymerizable monomer used in the film-forming component is appropriately changed, and the film-forming component is spinodally decomposed during film formation to form a phase-separated structure between the first phase and the second phase.

The phase-separated structure in the above-described film preferably has a phase interface isotropically present in the film, and for example, more preferably a sea-island structure or a co-continuous phase structure. By forming these phase-separated structures, light can be effectively scattered between the first phase and the second phase, and particularly excellent light scattering properties can be easily obtained. The sea-island structure is a structure formed by a sea region which is a continuous region and an island region which is a discontinuous region. In the sea-island structure, the second phase may form the sea and the first phase may form the island, or the first phase may form the sea and the second phase may form the island. The case where the first phase forms the sea and the second phase forms the island is preferable from the viewpoint of transmittance. The case where the first phase forms the island and the second phase forms the sea is preferable from the viewpoint of angle dependence. In addition, the co-continuous phase structure is a network structure in which the first phase and the second phase each form a continuous phase structure intrusive to each other.

In a case where a film having a thickness of 4 μm is formed by heating the composition according to the embodiment of the present invention at 200°C for 5 minutes, from the viewpoint of reducing wavelength dependence of light scattering, the maximum value of the light transmittance of the film in a wavelength range of 400 to 700 nm is preferably 70% or less, more preferably 60% or less, and still more preferably 50% or less. The lower limit of the above-described maximum value of the light transmittance is preferably 1% or more, more preferably 5% or more, and still more preferably 10% or more.

In addition, a maximum value of the light transmittance of the above-described film at 400 to 1000 nm is preferably 80% or less, more preferably 70% or less, still more preferably 60% or less, and particularly preferably 50% or less. The lower limit of the above-described maximum value of the light transmittance is preferably 1% or more, more preferably 5% or more, and still more preferably 10% or more.

The average value of a difference in refractive index between the phases in the above-described film is preferably 0.1 or more, more preferably 0.2 or more, still more preferably 0.3 or more, and particularly preferably 0.4 or more.

The haze of the above-described film based on JIS K 7136 is preferably 30% to 100%. The upper limit is preferably 99% or less, more preferably 95% or less, and still more preferably 90% or less. The lower limit is preferably 35% or more, more preferably 40% or more, and still more preferably 50% or more.

The formation of the film having such spectral characteristics can be achieved by appropriately adjusting a shape of the phase-separated structure, a refractive index of the particles, an abundance of the particles in the film, a degree of uneven distribution of the particles in the film, and the like. In this case, it is better to be a higher refractive index of the particles, abundance of the particles, and degree of uneven distribution of the particles.

For the reason that it is easy to obtain more excellent storage stability, the concentration of solid contents of the composition according to the embodiment of the present invention is preferably 5 to 80 mass%. The upper limit is preferably 75 mass% or less and more preferably 70 mass% or less. The lower limit is preferably 10 mass% or more, more preferably 15 mass% or more, and still more preferably 20 mass% or more. Hereinafter, each of the components used in the composition according to the embodiment of the present invention will be described.

«Particles P1 (particles having refractive index of 2.0 or more and average primary particle diameter of 200 nm or less)»

The composition according to the embodiment of the present invention includes particles (hereinafter, also referred to as particles P1) having a refractive index of 2.0 or more and an average primary particle diameter of 200 nm

or less.

The average primary particle diameter of the particles P1 is 200 nm or less, and from the viewpoint of storage stability of the composition, is preferably 100 mn or less. In addition, from the viewpoint of the storage stability of the composition and light scattering properties of a film to be obtained, the average primary particle diameter of the particles P1 is preferably 5 nm to 100 nm, more preferably 10 nm to 100 nm, still more preferably 20 nm to 100 nm, even more preferably 30 nm to 100 nm, even still more preferably 40 nm to 100 nm, and particularly preferably 50 nm to 100 nm.

In this specification, the average primary particle diameter of particles is a value measured by the following method. That is, the primary particle diameter of the particles can be obtained by observing the particles with a transmission electron microscope (TEM) and observing a portion (primary particle) where the particles do not aggregate. A particle size distribution of the particles can be obtained by photographing a transmission electron micrograph of the primary particles using a transmission electron microscope and measuring a particle size distribution with an image processing device using the micrograph. In this specification, the average primary particle diameter of the particles refers to the number average particle size calculated from the particle size distribution. In this specification, an electron microscope (H-7000, manufactured by Hitachi, Ltd.) is used as the transmission electron microscope, and a LUZEX AP (manufactured by Nireco Corporation) is used as the image processing device.

The refractive index of the particles P1 is 2.0 or more, preferably 2.2 or more and more preferably 2.4 or more. The upper limit of the refractive index of the particles P1 is not particularly limited, but may be 5 or less or 4 or less.

In this specification, the refractive index of particles is a value measured by the following method. First, a dispersion liquid is prepared using the particles, a resin (dispersant) having a known refractive index, and propylene glycol monomethyl ether acetate. Next, the prepared dispersion liquid and a resin having a known refractive index are mixed with each other to prepare coating liquids in which the concentrations of the particles is 10 mass%, 20 mass%, 30 mass%, and 40 mass% with respect to the total solid content of the coating liquids. Using each of the coating liquids, a film having a thickness of 300 nm is formed on a silicon wafer, and the refractive index of the obtained film is measured by ellipsometry (LAMBDA ACE RE-3300, manufactured by SCREEN Holdings Co., Ltd.). Next, the refractive index corresponding to the concentration of the particles is plotted on a graph to derive the refractive index of the particles.

The specific gravity of the particles P1 is preferably 1 to 7 g/$cm^3$. The upper limit is preferably 6 g/$cm^3$ or less and more preferably 5 g/$cm^3$ or less. The lower limit of the specific gravity is not particularly limited, but may be 1.5 g/$cm^3$ or more or 2 g/$cm^3$ or more.

In this specification, the specific gravity of particles is a value measured by the following method. First, 50 g of particles are put into a 100 mL volumetric flask. Subsequently, 100 mL of water is weighed using another 100 mL graduated cylinder. Thereafter, first, the weighed water is put into the volumetric flask to the extent that the particles are immersed, and then ultrasonic waves are applied to the volumetric flask to allow the particles and water to blend in. Next, additional water is added thereto until the marked line of the volumetric flask is reached, and the specific gravity is calculated as 50 g/(volume of water remaining in volumetric flask).

The particles P1 are preferably transparent or white particles. In addition, the particles P1 are preferably inorganic particles. Examples of the type of the inorganic particles include titanium oxide particles, strontium titanate particles, barium titanate particles, zinc oxide particles, magnesium oxide particles, zirconium oxide particles, aluminum oxide particles, barium sulfate particles, and zinc sulfide particles. The inorganic particles used as the particles P1 are preferably particles having a titanium atom and more preferably titanium oxide particles.

In the titanium oxide particles, the content (purity) of titanium dioxide ($TiO_2$) is preferably 70 mass% or more, more preferably 80 mass% or more, and still more preferably 85 mass% or more. In the titanium oxide particles, the content of lower titanium oxide represented by $Ti_nO_{2n-1}$ (n represents a number of 2 to 4), titanium nitride, or the like is preferably 30 mass% or less, more preferably 20 mass% or less, and still more preferably 15 mass% or less.

The titanium oxide may be rutile type titanium oxide or anatase type titanium oxide. From the viewpoint of colorability and the temporal stability of the dispersion liquid or the composition, rutile type titanium oxide is preferable. In particular, rutile type titanium oxide has a small change in color difference and excellent colorability even under heating. In addition, the rutile transformation rate of the titanium oxide is preferably 95% or more and more preferably 99% or more.

As rutile type titanium oxide, a well-known titanium oxide can be used. As a method of manufacturing rutile type titanium oxide, two methods including a sulfuric acid method and a chlorine method are present, and a titanium oxide manufactured using any one of the methods can be suitably used. Here, the sulfuric acid method refers to a manufacturing method including: dissolving ilmenite ore or titanium slug as a raw material in concentrated sulfuric acid to separate iron as iron sulfate; hydrolyzing the separated solution to obtain a precipitate of hydroxide; and calcinating the precipitate at a high temperature to extract rutile type titanium oxide. In addition, the chlorine method refers to a manufacturing method including: causing synthetic rutile or natural rutile as a raw material to react with chlorine gas or carbon at a high temperature of about 1000°C to synthesize of titanium tetrachloride; and oxidizing the titanium tetrachloride at a high temperature to extract rutile type titanium oxide. It is preferable that rutile type titanium oxide is obtained using the chlorine method.

As the specific surface area of titanium oxide particles, a value measured using a Brunauer, Emmett, Teller

(BET) method is preferably 10 to 400 $m^2/g$, more preferably 10 to 200 $m^2/g$, still more preferably 10 to 150 $m^2/g$, particularly preferably 10 to 40 $m^2/g$, and most preferably 10 to 20 $m^2/g$. The pH of titanium oxide is preferably 6 to 8. The oil absorption of titanium oxide is preferably 10 to 60 (g/100 g) and more preferably 10 to 40 (g/100 g).

In the titanium oxide particles, the total content of $Fe_2O_3$, $Al_2O_3$, $SiO_2$, NbzOs, and NazO is preferably 0.1 mass% or less, more preferably 0.05 mass% or less, still more preferably 0.02 mass% or less, and particularly preferably substantially 0 mass%.

The shape of the titanium oxide particles is not particularly limited. Examples of the shape of titanium oxide include an isotropic shape (for example, a spherical shape and a polyhedral shape), an anisotropic shape (for example, a needle shape, a rod shape, and a plate shape), and an unstructured shape. The hardness (Mohs hardness) of titanium oxide particles is preferably 5 to 8 and more preferably 7 to 7.5.

The inorganic particles such as the titanium oxide particles may be surface-treated with a surface treatment agent such as an organic compound. Examples of the surface treatment agent used for the surface treatment of the titanium oxide include polyol, aluminum oxide, aluminum hydroxide, silica (silicon oxide), water-containing silica, alkanolamine, stearic acid, organosiloxane, zirconium oxide, hydrogen dimethicone, a silane coupling agent, and a titanate coupling agent. In particular, a silane coupling agent is preferable. The surface treatment may be performed using one surface treatment agent alone or a combination of two or more surface treatment agents.

It is also preferable that the inorganic particles such as the titanium oxide particles are covered with a basic metal oxide or a basic metal hydroxide. Examples of the basic metal oxide or the basic metal hydroxide include a metal compound including magnesium, zirconium, cerium, strontium, antimony, barium, calcium, or the like.

In addition, as the titanium oxide particles, titanium oxide particles described in "Titanium Oxide - Physical Properties and Applied Technology, Manabu Kiyono, pp. 13 to 45, June 25, 1991, published by Gihodo Shuppan Co., Ltd.) can also be suitably used.

As the particles P1, a commercially available product can be preferably used. The commercially available product may be used as it is or may be used after a classification treatment. Examples of the commercially available product of titanium oxide particles include:

products manufactured by Ishihara Sangyo Kaisha Ltd. such as trade name TIPAQUE R-550, R-580, R-630, R-670, R-680, R-780, R-780-2, R-820, R-830, R-850, R-855, R-930, R-980, CR-50, CR-50-2, CR-57, CR-58, CR-58-2, CR-60, CR-60-2, CR-63, CR-67, CR-Super 70, CR-80, CR-85, CR-90, CR-90-2, CR-93, CR-95, CR-953, CR-97, PF-736, PF-737, PF-742, PF-690, PF-691, PF-711, PF-739, PF-740, PC-3, S-305, CR-EL, PT-301, PT-401M, PT-401L, PT-501A, PT-501R, UT771, TTO-51, TTO-80A, TTO-S-2, A-220, MPT-136, MPT-140, or MPT-141;
products manufactured by Sakai Chemical Industry Co., Ltd. such as trade names R-3L, R-5N, R-7E, R-11P, R-21, R-25, R-32, R-42, R-44, R-45M, R-62N, R-310, R-650, SR-1, D-918, GTR-100, FTR-700, TCR-52, A-110, A-190, SA-1, SA-1L, STR-100A-LP, STR-100C-LP, or TCA-123E1;
products manufactured by TAYCA Corporation such as trade name JR, JRNC, JR-301, JR-403, JR-405, JR-600A, JR-600E, JR-603, JR-605, JR-701, JR-800, JR-805, JR-806, JR-1000, MT-01, MT-05, MT-10EX, MT-100S, MT-100TV, MT-100Z, MT-100AQ, MT-100WP, MT-100SA, MT-100HD, MT-150EX, MT-150W, MT-300HD, MT-500B, MT-500SA, MT-500HD, MT-600B, MT-600SA, MT-700B, MT-700BS, MT-700HD, or MT-700Z;
products manufactured by Titan Kogyo Ltd. such as trade name KR-310, KR-380, KR-380N, or ST-485SA15;
products manufactured by Fuji Titanium Industry Co., Ltd. such as trade name TR-600, TR-700, TR-750, TR-840, or TR-900; and
products manufactured by Shiraishi Calcium Kaisha Ltd. such as trade name Brilliant 1500. In addition, titanium oxide particles described in paragraphs "0025" to "0027" of JP2015-067794A can also be used.

Examples of a commercially available product of strontium titanate particles include SW-100 (manufactured by Titan Kogyo Ltd.). Examples of a commercially available product of barium sulfate particles include BF-1L (manufactured by Sakai Chemical Industry Co., Ltd.). Examples of a commercially available product of zinc oxide particles include Zincox Super F-1 (manufactured by Hakusui Chemical Co., Ltd.). Examples of a commercially available product of zirconium oxide particles include Z-NX (manufactured by Taiyo Koko Co., Ltd.) and Zirconeo-Cp (manufactured by ITEC Co., Ltd.).

The content of the particles P1 in the total solid content of the composition is preferably 5 to 90 mass%. The upper limit is preferably 85 mass%% or less, more preferably 80 mass% or less, and still more preferably 70 mass% or less. The lower limit is preferably 6 mass% or more, more preferably 10 mass% or more, and still more preferably 15 mass% or more.

The composition according to the embodiment of the present invention may include only one kind of the particles P1 or two or more kinds of the particles P1. In a case where only one kind of the particles P 1 is included, more excellent storage stability is easily obtained. In addition, in a case where two or more kinds of the particles P1 are included, the angle dependence of light scattering can be further reduced. In a case where two or more kinds of the particles P1 are

included, the total content thereof is preferably within the above-described range.

«Particles P2»

The composition according to the embodiment of the present invention can contain particles (hereinafter, also referred to as particles P2) having a refractive index of less than 2.0, an average primary particle diameter of 500 nm or more, and a specific gravity smaller than that of the particles P1. In a case where the composition according to the embodiment of the present invention contains P2 in addition to P1, scattering occurs between the particles P1 and the particles P2, so that light irradiated to the film can be efficiently scattered and transmitted. Therefore, by using such a composition, a film having more excellent light scattering properties can be formed.

The average primary particle diameter of the particles P2 is 500 nm or more, preferably 500 nm to 6000 nm, more preferably 500 nm to 5000 nm, still more preferably 500 nm or more and less than 3000 nm, even more preferably 500 nm to 2500 nm, even still more preferably 500 nm to 2000 nm, particularly preferably 500 nm to 1500 nm, and most preferably 500 nm to 1000 nm.

The refractive index of the particles P2 is less than 2.0, preferably 1.9 or less, more preferably 1.8 or less, and particularly preferably 1.7 or less. The lower limit of the refractive index of the particles P2 is not particularly limited, and may be 1.0 or more or 1.1 or more.

For the reason that a film having excellent light scattering properties is easily obtained, the difference between the refractive index of the particles P1 and the refractive index of the particles P2 is preferably 0.5 or more, more preferably 0.7 or more, and still more preferably 0.9 or more. In a case where the composition according to the embodiment of the present invention includes two or more kinds of the particles P1, in calculating the difference in refractive index described above, the mass average value of the refractive indexes of two or more kinds of the particles P1 is used as the value of the refractive index of the particles P1. The same applies to a case where the composition according to the embodiment of the present invention includes two or more kinds of the particles P2.

The specific gravity of the particles P2 is preferably 2.5 g/cm$^3$ or less, more preferably 2.4 g/cm$^3$ or less, still more preferably 2.2 g/cm$^3$ or less, and particularly preferably 2.0 g/cm$^3$ or less. The lower limit of the specific gravity of the particles P2 is not particularly limited, but may be 0.5 g/cm$^3$ or more or 0.9 g/cm$^3$ or more.

The particles P2 are preferably transparent or white particles. Examples of the particles P2 include inorganic particles and resin particles. Examples of the type of the inorganic particles include silica particles, hollow titanium oxide particles, and hollow zirconia particles. Among these, silica particles are preferable. Examples of a commercially available product of the inorganic particles include Sylysia series manufactured by FUJI SILYSIA CHEMICAL LTD. (for example, Sylysia 310P and the like) and Seahostar series manufactured by NIPPON SHOKUBAI CO., LTD. (for example, Seahostar KE-S250).

Examples of the resin particles include particles consisting of a synthetic resin such as a (meth)acrylic resin, a styrene resin, a polyamide resin, a polyimide resin, a polyolefin resin, a polyurethane resin, a polyurea resin, a polyester resin, a melanin resin, and a silicone resin, and particles consisting of a natural polymer such as chitin, chitosan, cellulose, crosslinked starch, and crosslinked cellulose. Among these, the synthetic resin particles are preferably used because they have advantages such as easy control of particle size.

As a method of producing the resin particles, in a case of a relatively hard resin such as polymethylmethacrylate (PMMA), fine particles can be formed according to a crushing method, but a method of producing resin particles according to an emulsification and suspension polymerization method is preferable from the viewpoint of ease of controlling the particle diameter, and precision. The method of producing the resin particles is described in detail in "Ultrafine Particles and Materials" edited by Materials Science Society of Japan, published by SHOKABO Co., Ltd., published in 1993, "Manufacturing & Application of Microspheres & Powders" supervised by Haruma Kawaguchi, published by CMC Publishing Co., Ltd., published in 2005, and the like.

The resin particles are also available as commercially available products, and examples thereof include MX-40T, MX-80H3wT, MX-150, MX-180TA, MX-300, MX-500, MX-1000, MX-1500H, MR-2HG, MR-7HG, MR-10HG, MR-3GSN, MR-5GSN, MR-7G, MR-10G, MR-5C, and MR-7GC (all manufactured by Soken Chemical & Engineering Co., Ltd., acrylic resin particles); SX-130H, SX-350H, and SX-500H (all manufactured by Soken Chemical & Engineering Co., Ltd., styrene resin particles); MBX-5, MBX-8, MBX-12, MBX-15, MBX-20, MB20X-5, MB30X-5, MB30X-8, MB30X-20, SBX-6, SBX-8, SBX-12, and SBX-17 (all manufactured by Sekisui Plastics Co., Ltd., acrylic resin particles); CHEMIPEARL W100, W200, W300, W308, W310, W400, W401, W405, W410, W500, WF640, W700, W800, W900, W950, and WP100 (all manufactured by Mitsui Chemicals, Inc., polyolefin resin particles); Tospearl 120 (manufactured by Momentive Performance Technologies, silicone resin particles); and Optbeads 2000M (manufactured by Nissan Chemical Corporation, melanin resin particles).

The particles P2 are also preferably hollow particles. The hollow particles refer to particles having voids in which no material constituting the particles exists inside a surface of the particles. The size, shape, and number of voids are not particularly limited. The hollow particles may have an outer shell structure have a void in the central portion, or

a structure in which a plurality of fine voids are dispersed inside the particles.

The void ratio of the hollow particles is preferably 1% to 90%. The lower limit of the void ratio is preferably 5% or more and more preferably 10% or more. The upper limit of the void ratio is preferably 85% or less and more preferably 80% or less. The void ratio of the hollow particles refers to a proportion of the volume occupied by the voids to the total volume of the hollow particles. The void ratio of the hollow particles can be obtained by observing hollow particles using a transmission electron microscope, measuring an outer diameter and a void diameter, and calculating "the proportion of the volume occupied by the void to the total volume" according to the following expression.

$$\text{Expression: } \{(\text{Void diameter})^3/(\text{Outer diameter})^3\} \times 100\%$$

More specific examples thereof include a method in which 100 hollow particles observed by a transmission electron microscope are optionally selected, equivalent circle diameters of an outer and a void of each of these hollow particles are measured to obtain the outer diameter and the void diameter, and a void ratio is calculated according to the above expression and an average value thereof is determined as the void ratio. In addition, in a case where a material of a shell of the particles (refractive index thereof) is known and it is known that the particles are hollow, the void ratio can be also be known from the measurement of the refractive index of the particles.

The shape of the hollow particles is preferably spherical, but may be a shape other than the spherical shape, such as an amorphous shape.

The hollow particles may be hollow particles formed of an inorganic material (hereinafter, also referred to as hollow inorganic particles), or may be hollow particles formed of a resin material (hereinafter, also referred to as hollow resin particles).

Examples of the material constituting the hollow resin particles include a (meth)acrylic resin, a styrene resin, a polyamide resin, a polyimide resin, a polyolefin resin, a polyurethane resin, a polyurea resin, a polyester resin, a silicone resin, and a melanin resin. Among these, a (meth)acrylic resin or a styrene resin is preferable, and a (meth)acrylic resin is more preferable. Examples of a method for manufacturing the hollow resin particles include a method of containing a forming agent in the resin particles and foaming the forming agent, a method of encapsulating a volatile substance in the resin particles and gasifying the volatile substance to be expanded, a method of melting the resin particles and injecting a gas such as air into the resin particles, and a method (hereinafter, also referred to as a solvent removal method) in which a polymerizable monomer and a non-polymerizable solvent are mixed and polymerized to obtain resin particles encompassing the solvent, and the solvent is removed.

The hollow inorganic particles are preferably hollow silica particles. That is, the hollow inorganic particles are preferably silica particles having a void in the central portion. Specific examples of the hollow silica particles include hollow particles described in JP2013-237593A, WO2007/060884A, and the like.

The content of the particles P2 in the total solid content of the composition is preferably 1 to 90 mass%. The upper limit is preferably 80 mass%% or less, more preferably 70 mass% or less, and still more preferably 60 mass% or less. The lower limit is preferably 2 mass% or more, more preferably 5 mass% or more, and still more preferably 10 mass% or more. The composition according to the embodiment of the present invention may include only one kind of the particles P2 or two or more kinds of the particles P2. In a case where only one kind of the particles P2 is included, more excellent storage stability is easily obtained. In addition, in a case where two or more kinds of the particles P2 are included, the angle dependence of light scattering can be further reduced. In a case where two or more kinds of the particles P2 are included, the total content thereof is preferably within the above-described range.

The total content of the particles P 1 and the particles P2 in the total solid content of the composition is preferably 30 mass% or more, more preferably 35 mass% or more, and still more preferably 40 mass% or more. The upper limit is preferably 90 mass%% or less, more preferably 80 mass% or less, and still more preferably 70 mass% or less.

With regard to the proportion of the particles P 1 and the particles P2 in the composition, it is preferable that the particles P1 is 20 to 500 parts by mass with respect to 100 parts by mass of the particles P2. The upper limit is preferably 450 parts by mass or less, more preferably 400 parts by mass or less, and still more preferably 300 parts by mass or less. The lower limit is preferably 25 parts by mass or more, more preferably 30 parts by mass or more, and still more preferably 35 parts by mass or more.

«Film-forming component»

The composition according to the embodiment of the present invention includes a film-forming component including at least one selected from a resin or a polymerizable monomer. The film-forming component used in the present invention includes two or more kinds of resins, or includes one or more kinds of resins and one or more kinds of polymerizable monomers.

(Resin)

The resin is blended in, for example, an application for dispersing particles in a composition or an application as a binder. Mainly, a resin which is used for dispersing particles is also referred to as a dispersant. However, such applications of the resin are only exemplary, and the resin can also be used for other purposes in addition to such applications.

As the resin, any well-known resin can be used. Examples of the resin include a (meth)acrylic resin, a (meth)acrylamide resin, an epoxy resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamide resin, a polyolefin resin, a cyclic olefin resin, a polyester resin, a styrene resin, a silicone resin, and a urethane resin.

The weight-average molecular weight (Mw) of the resin is preferably 2000 to 2000000. The upper limit is preferably 1000000 or lower and more preferably 500000 or lower. The lower limit is preferably 3000 or higher, more preferably 4000 or higher, and still more preferably 5000 or higher.

As the resin, a resin having an acid group can be used. Examples of the resin having an acid group include a resin having a repeating unit having an acid group. Examples of the acid group include a carboxyl group, a phosphate group, a sulfo group, and a phenolic hydroxy group. Among these, a carboxyl group is preferable. In addition, the carboxyl group is preferably an aromatic carboxyl group. Here, the aromatic carboxyl group is a group having a structure in which one or more carboxyl groups are bonded to an aromatic ring. In the aromatic carboxyl group, the number of carboxyl groups bonded to an aromatic ring is preferably 1 to 4 and more preferably 1 or 2. Examples of the repeating unit having an aromatic carboxyl group include a repeating unit having the structures shown below.

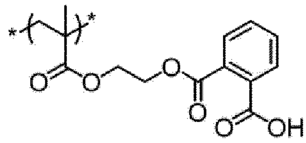
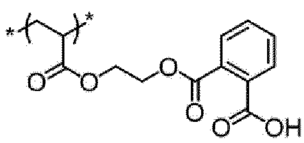
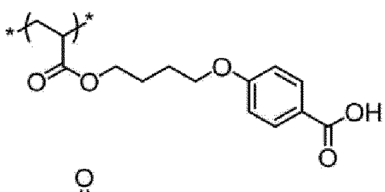
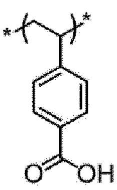
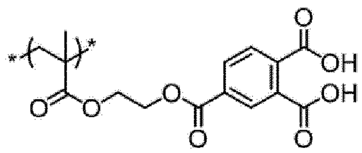
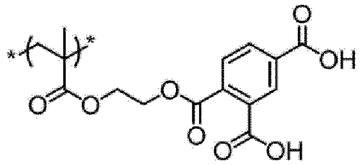

In addition, in the repeating unit having a carboxyl group, the number of atoms constituting the chain connecting the main chain of the resin and the carboxyl group is preferably 4 or more and more preferably 8 or more. The upper limit of the number of atoms constituting the chain connecting the main chain of the resin and the carboxyl group is not particularly limited, but is preferably 40 or less, more preferably 30 or less, and still more preferably 20 or less. Examples of a repeating unit in which the number of atoms constituting the chain connecting the main chain of the resin and the carboxyl group is 4 or more include repeating units having structures shown below. The numbers shown in the structural formula are the number of atoms constituting the chain connecting the main chain and the carboxyl group.

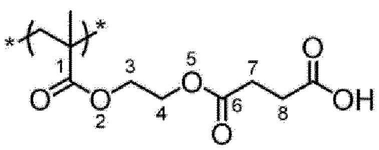
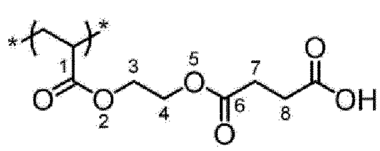
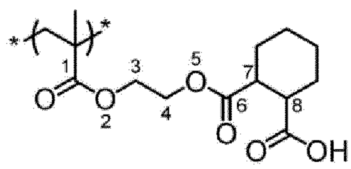
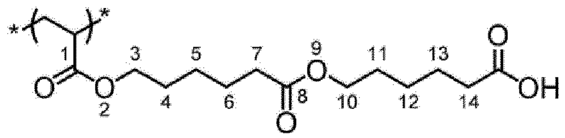
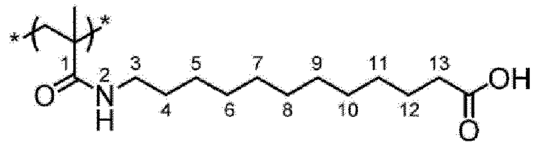

The resin having an acid group can also be used as an alkali-soluble resin or a dispersant. The acid value of the resin having an acid group is preferably 30 to 500 mgKOH/g. The lower limit is more preferably 50 mgKOH/g or more and still more preferably 70 mgKOH/g or more. The upper limit is more preferably 400 mgKOH/g or less, still more

preferably 200 mgKOH/g or less, even still more preferably 150 mgKOH/g or less, and most preferably 120 mgKOH/g or less. With regard to the resin having an acid group, reference can be made to the description in paragraph "0558" to "0571" of JP2012-208494A (paragraph "0685" to "0700" of the corresponding US2012/0235099A) and the description in paragraph "0076" to "0099" of JP2012-198408A, the contents of which are incorporated herein by reference.

As the resin, a resin including a repeating unit derived from a compound represented by Formula (ED1) and/or a compound represented by Formula (ED2) (hereinafter, these compounds will also be referred to as an "ether dimer") can be used.

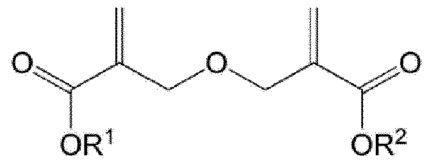

(ED1)

In Formula (ED1), $R^1$ and $R^2$ each independently represent a hydrogen atom or a hydrocarbon group having 1 to 25 carbon atoms, which may have a substituent.

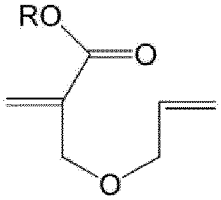

(ED2)

In Formula (ED2), R represents a hydrogen atom or an organic group having 1 to 30 carbon atoms. Specific examples of Formula (ED2) can be found in the description of JP2010-168539A.

Specific examples of the ether dimer can be found in paragraph "0317" of JP2013-029760A, the contents of which are incorporated herein by reference.

As the resin, a resin including a repeating unit derived from a compound represented by Formula (X) can be used.

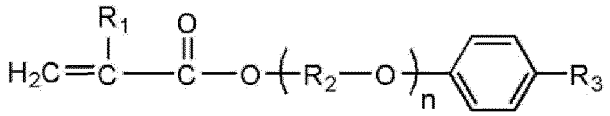

(X)

In Formula (X), $R_1$ represents a hydrogen atom or a methyl group, $R_2$ represents an alkylene group having 2 to 10 carbon atoms, and $R_3$ represents a hydrogen atom or an alkyl group having 1 to 20 carbon atoms, which may have a benzene ring. n represents an integer of 1 to 15.

As the resin, a resin including a repeating unit having a graft chain can also be used. In a case where the resin includes a repeating unit having a graft chain, due to steric hindrance caused by the graft chain, aggregation and the like of particles in the composition can be suppressed more effectively, and excellent storage stability can be obtained. In addition, it is possible to easily form a phase-separated structure in the film during film formation. The resin including the repeating unit having a graft chain may be used as a dispersant or a binder.

In the present invention, the graft chain means a polymer chain branched and extended from the main chain of the repeating unit. The length of the graft chain is not particularly limited, and in a case where the graft chain is longer, a steric repulsion effect is enhanced, and thus it is possible to improve dispersibility of the particles and facilitate the formation of the phase-separated structure. As the graft chain, the number of atoms excluding the hydrogen atoms is preferably 40 to 10000, the number of atoms excluding the hydrogen atoms is more preferably 50 to 2000, and the number of atoms excluding the hydrogen atoms is still more preferably 60 to 500.

It is preferable that the graft chain includes at least one structural repeating unit selected from a polyester structural repeating unit, a polyether structural repeating unit, a poly(meth)acrylic structural repeating unit, a polyurethane structural repeating unit, a polyurea structural repeating unit, or a polyamide structural repeating unit, it is more preferable that the graft chain includes at least one structural repeating unit selected from a polyester structural repeating unit, a polyether structural repeating unit, or a poly(meth)acrylic structural repeating unit, and it is still more preferable that the graft chain includes a polyester structural repeating unit. Examples of the polyester structural repeating unit include a repeating unit having a structure represented by Formula (G-1), Formula (G-4), or Formula (G-5). In addition, examples

of the polyether structural repeating unit include a repeating unit having a structure represented by Formula (G-2). In addition, examples of the poly(meth)acrylic structural repeating unit include a repeating unit having a structure represented by Formula (G-3).

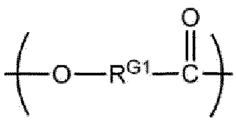
(G-1)

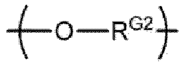
(G-2)

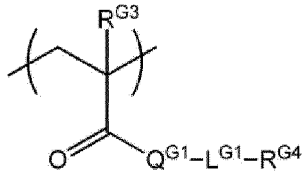
(G-3)

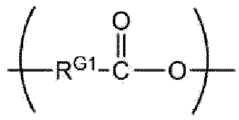
(G-4)

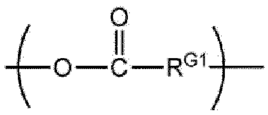
(G-5)

In the formulae, $R^{G1}$ and $R^{G2}$ each represent an alkylene group. The alkylene group represented by $R^{G1}$ and $R^{G2}$ is not particularly limited, but is preferably a linear or branched alkylene group having 1 to 20 carbon atoms, more preferably a linear or branched alkylene group having 2 to 16 carbon atoms, and still more preferably a linear or branched alkylene group having 3 to 12 carbon atoms.

In the formulae, $R^{G3}$ represents a hydrogen atom or a methyl group.

In the formulae, $Q^{G1}$ represents -O- or -NH-, and $L^{G1}$ represents a single bond or a divalent linking group. Examples of the divalent linking group include an alkylene group (preferably an alkylene group having 1 to 12 carbon atoms), an alkyleneoxy group (preferably an alkyleneoxy group having 1 to 12 carbon atoms), an oxyalkylenecarbonyl group (preferably an oxyalkylenecarbonyl group having 1 to 12 carbon atoms), an arylene group (preferably an arylene group having 6 to 20 carbon atoms), -NH-, -SO-, -SOz-, -CO-, -O-, -COO-, OCO-, -S-, and a group formed by a combination of two or more of these groups.

$R^{G4}$ represents a hydrogen atom or a substituent. Examples of the substituent include an alkyl group, an aryl group, a heteroaryl group, an alkoxy group, an aryloxy group, a heteroaryloxy group, an alkylthioether group, an arylthioether group, and a heteroarylthioether group.

A terminal structure of the graft chain is not particularly limited. The terminal structure may be a hydrogen atom or a substituent. Examples of the substituent include an alkyl group, an aryl group, a heteroaryl group, an alkoxy group, an aryloxy group, a heteroaryloxy group, an alkylthioether group, an arylthioether group, and a heteroarylthioether group. Among these, from the viewpoint of improvement of the dispersibility of the particles, a group having a steric repulsion effect is preferable, and an alkyl group or alkoxy group having 5 to 24 carbon atoms is preferable. The alkyl group and the alkoxy group may be linear, branched, or cyclic, and are preferably linear or branched.

The graft chain is preferably a structure represented by Formula (G-1a), Formula (G-2a), Formula (G-3a), Formula (G-4a), or Formula (G-5a).

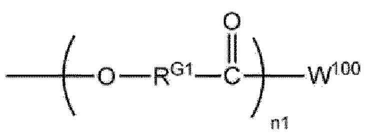
(G-1a)

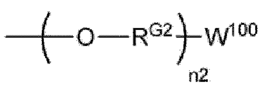
(G-2a)

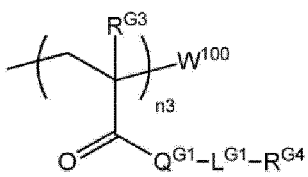
(G-3a)

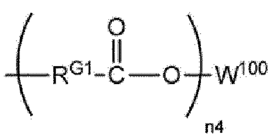
(G-4a)

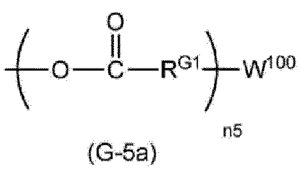
(G-5a)

In the formulae, $R^{G1}$ and $R^{G2}$ each independently represent an alkylene group, $R^{G3}$ represents a hydrogen atom or a methyl group, $Q^{G1}$ represents -O- or -NH-, $L^{G1}$ represents a single bond or a divalent linking group, $R^{G4}$ represents a hydrogen atom or a substituent, and $W^{100}$ represents a hydrogen atom or a substituent. n1 to n5 each independently represent an integer of 2 or more. $R^{G1}$ to $R^{G4}$, $Q^{G1}$, and $L^{G1}$ have the same meanings as $R^{G1}$ to $R^{G4}$, $Q^{G1}$, and $L^{G1}$ described in Formulae (G-1) to (G-5), and preferred ranges thereof are also the same.

In Formulae (G-1a) to (G-5a), it is preferable that $W^{100}$ represents a substituent. Examples of the substituent include an alkyl group, an aryl group, a heteroaryl group, an alkoxy group, an aryloxy group, a heteroaryloxy group, an alkylthioether group, an arylthioether group, and a heteroarylthioether group. Among these, from the viewpoint of improvement of the dispersibility of the pigment or the like, a group having a steric repulsion effect is preferable, and an alkyl group or alkoxy group having 5 to 24 carbon atoms is preferable. The alkyl group and the alkoxy group may be linear, branched, or cyclic, and are preferably linear or branched.

In Formulae (G-1a) to (G-5a), n1 to n5 each are preferably an integer of 2 to 100, more preferably an integer of 2 to 80, and still more preferably an integer of 8 to 60.

In Formula (G-1a), in a case where n1 is 2 or more, a plurality of $R^{G1}$'s in each repeating unit may be the same or different from each other. In a case where $R^{G1}$ includes two or more kinds of repeating units different from each other, the arrangement of the repeating units is not particularly limited, and may be performed in any of a random manner, an alternative manner, and a blocked manner. The same applies to Formulae (G-2a) to (G-5a). Among these, for the reason that the light scattering properties of the obtained film can be further improved, the graft chain preferably has a structure which is represented by Formula (G-1a), Formula (G-4a), or Formula (G-5a) and includes two or more repeating units having different $R^{G1}$'s. That is, it is preferable that n1 pieces of $R^{G1}$ in Formula (G-1a), n4 pieces of $R^{G1}$ in Formula (G-4a), and n5 pieces of $R^{G1}$ in Formula (G-5a) include two or more alkylene groups having different carbon atoms.

Examples of the repeating unit having a graft chain include a repeating unit represented by Formula (A-1-2).

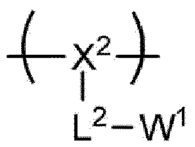

(A-1-2)

In Formula (A-1-2), $X^2$ represents the main chain of the repeating unit, $L^2$ represents a single bond or a divalent linking group, and $W^1$ represents a graft chain.

Examples of the main chain of the repeating unit represented by $X^2$ in Formula (A-1-2) include the structures described in the description of $X^1$ of Formula (A-1-1), and preferred ranges thereof are also the same. Examples of the divalent linking group represented by $L^2$ in Formula (A-1-2) include an alkylene group (preferably an alkylene group having 1 to 12 carbon atoms), an arylene group (preferably an arylene group having 6 to 20 carbon atoms), -NH-, -SO-, $-SO_2-$, -CO-, -O-, -COO-, -OCO-, -S-, and a group formed by a combination of two or more of these groups. Examples of the graft chain represented by $W^1$ in Formula (A-1-2) include the graft chains described above.

Specific examples of the repeating unit represented by Formula (A-1-2) include a repeating unit represented by Formula (A-1-2a) and a repeating unit represented by Formula (A-1-2b).

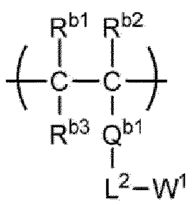

(A-1-2a)

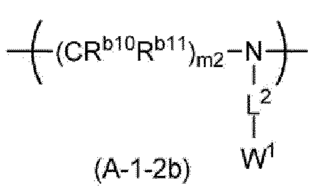

(A-1-2b)

In Formula (A-1-2a), $R^{b1}$ to $R^{b3}$ each independently represent a hydrogen atom or an alkyl group, $Q^{b1}$ represents -CO-, -COO-, -OCO-, -CONH-, or a phenylene group, $L^2$ represents a single bond or a divalent linking group, and $W^1$ represents a graft chain. The number of carbon atoms in the alkyl group represented by $R^{b1}$ to $R^{b3}$ is preferably 1 to 10, more preferably 1 to 3, and still more preferably 1. $Q^{b1}$ is preferably -COO- or -CONH- and more preferably -COO-.

In Formula (A-1-2b), $R^{b10}$ and $R^{b11}$ each independently represent a hydrogen atom or an alkyl group, m2

represents an integer of 1 to 5, $L^2$ represents a single bond or a divalent linking group, and $W^1$ represents a graft chain. The number of carbon atoms in the alkyl group represented by $R^{b10}$ and $R^{b11}$ is preferably 1 to 10 and more preferably 1 to 3.

The weight-average molecular weight (Mw) of the repeating unit having a graft chain is preferably 1000 or more, more preferably 1000 to 10000, and still more preferably 1000 to 7500. In the present invention, the weight-average molecular weight of the repeating unit having a graft chain is a value calculated from the weight-average molecular weight of the raw material monomer used for the polymerization of the repeating unit. For example, the repeating unit having a graft chain can be formed by polymerizing a macromonomer. Here, the macromonomer means a polymer compound in which a polymerizable group is introduced at a polymer terminal. In a case where the repeating unit having a graft chain is formed using a macromonomer, the weight-average molecular weight of the macromonomer corresponds to the repeating unit having a graft chain.

It is also preferable that the resin including the repeating unit having a graft chain further includes a repeating unit derived from (meth)acrylic acid ester. According to this aspect, the light scattering properties of the obtained film can be further improved.

It is also preferable that the resin including the repeating unit having a graft chain further has a repeating unit having an acid group and a repeating unit having neither a graft chain nor an acid group, respectively. According to this aspect, it is possible to prevent a phase separation size from being excessively large in the film, and it is possible to form a film having more excellent light scattering properties. Examples of the acid group included in the repeating unit having an acid group include a carboxyl group, a phosphate group, a sulfo group, and a phenolic hydroxy group. Among these, a carboxyl group is preferable. In addition, the carboxyl group is preferably an aromatic carboxyl group. In addition, in the repeating unit having a carboxyl group, the number of atoms constituting the chain connecting the main chain of the resin and the carboxyl group is preferably 4 or more and more preferably 8 or more. The upper limit of the number of atoms constituting the chain connecting the main chain of the resin and the carboxyl group is not particularly limited, but is preferably 40 or less, more preferably 30 or less, and still more preferably 20 or less.

In the composition according to the embodiment of the present invention, it is preferable to use, as the resin, a resin having a structure in which a polymer chain is bonded to a tri- or higher valent linking group. Examples of such a resin include a resin (hereinafter, also referred to as a resin (SP-1)) having a structure represented by Formula (SP-1). The resin (SP-1) can be preferably used as a dispersant, but may also be used as a binder.

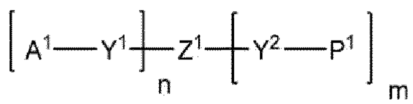

(SP-1)

In the formula, $Z^1$ represents an (m+n)-valent linking group, $Y^1$ and $Y^2$ each independently represent a single bond or a linking group,

$A^1$ represents a group including a substituent selected from a heterocyclic group, an acid group, a group having a basic nitrogen atom, a urea group, a urethane group, a group having a coordinating oxygen atom, a hydrocarbon group having 4 or more carbon atoms, an alkoxysilyl group, an epoxy group, an isocyanate group, and a hydroxy group,
$P^1$ represents a polymer chain,
n represents 1 to 20 and m represents 1 to 20, in which m+n is 3 to 21,
n pieces of $Y^1$'s and $A^1$'s each may be the same or different from each other, and
m pieces of $Y^2$'s and $P^1$'s each may be the same or different from each other.

At least one of $Z^1$, $A^1$, or $P^1$ in Formula (SP-1) may include an ethylenically unsaturated bond-containing group. Examples of the ethylenically unsaturated bond-containing group include a vinyl group, a vinyloxy group, an allyl group, a methallyl group, a (meth)acryloyl group, a styrene group, a cinnamoyl group, and a maleimide group. Among these, a (meth)acryloyl group, a styrene group, or a maleimide group is preferable, a (meth)acryloyl group is more preferable, and an acryloyl group is particularly preferable.

In a case where the resin (SP-1) includes the ethylenically unsaturated bond-containing group, such a resin corresponds to a polymerizable resin described later. It is sufficient that the ethylenically unsaturated bond-containing group is included in any of $Z^1$, $A^1$, or $P^1$ in Formula (SP-1), but it is preferable to be included in $P^1$. In addition, in a case where $P^1$ includes the ethylenically unsaturated bond-containing group, $P^1$ is preferably a polymer chain having a repeating unit including the ethylenically unsaturated bond-containing group in the side chain.

In Formula (SP-1), $A^1$ represents a group including the above-described substituent. As the substituent, a heterocyclic group, an acid group, a group having a basic nitrogen atom, a hydrocarbon group having 4 or more carbon atoms

atoms, or a hydroxy group is preferable, and an acid group is more preferable. Examples of the acid group include a carboxyl group, a sulfo group, and a phosphoric acid group, and a carboxyl group is preferable. In addition, the carboxyl group is preferably an aromatic carboxyl group.

It is sufficient that at least one of the above-described substituent is included in one $A^1$, and two or more substituents may be included in one $A^1$. $A^1$ preferably includes 1 to 10 of the above-described substituents, and more preferably includes 1 to 6 of the above-described substituents. In addition, as the group including the above-described substituent, which is represented by $A^1$, a group which is formed by the above-described substituent and a linking group including 1 to 200 carbon atoms, 0 to 20 nitrogen atoms, 0 to 100 oxygen atoms, 1 to 400 hydrogen atoms, and 0 to 40 sulfur atoms being bonded to each other can be used. Examples thereof include a group which is formed by one or more acid groups being bonded through a chain-like saturated hydrocarbon group having 1 to 10 carbon atoms, a cyclic saturated hydrocarbon group having 3 to 10 carbon atoms, or an aromatic hydrocarbon group having 5 to 10 carbon atoms. The chain-like saturated hydrocarbon group, the cyclic saturated hydrocarbon group, and the aromatic hydrocarbon group may further have a substituent. Examples of the substituent include an alkyl group having 1 to 20 carbon atoms, an aryl group having 6 to 16 carbon atoms, a hydroxy group, a carboxyl group, an amino group, a sulfonamide group, an N-sulfonylamide group, an acyloxy group having 1 to 6 carbon atoms, an alkoxy group having 1 to 20 carbon atoms, a halogen atom, an alkoxycarbonyl group having 2 to 7 carbon atoms, a cyano group, a carbonate group, and an ethylenically unsaturated bond-containing group. In addition, the above-described substituent itself may be $A^1$.

The chemical formula weight of $A^1$ is preferably 30 to 2000. The upper limit is preferably 1000 or lower and more preferably 800 or lower. The lower limit is preferably 50 or higher and more preferably 100 or higher.

In Formula (SP-1), $Z^1$ represents an (m+n)-valent linking group. Examples of the (m+n)-valent linking group include a group composed of 1 to 100 carbon atoms, 0 to 10 nitrogen atoms, 0 to 50 oxygen atoms, 1 to 200 hydrogen atoms, and 0 to 20 sulfur atoms. Examples of the (m+n)-valent linking group also include a group (which may form a ring structure) composed of the following structural unit or a combination of two or more the following structural units.

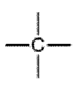 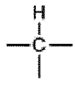 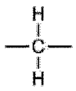 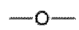 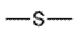 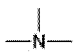 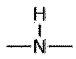 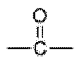 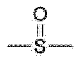 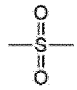 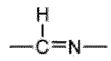 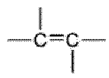

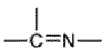 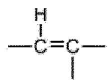 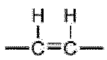 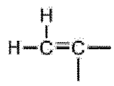 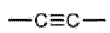 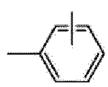 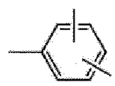 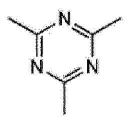

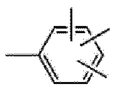 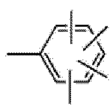 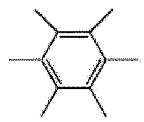 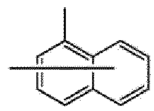 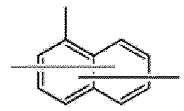 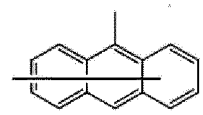

The (m+n)-valent linking group may have a substituent. Examples of the substituent include an alkyl group having 1 to 20 carbon atoms, an aryl group having 6 to 16 carbon atoms, a hydroxy group, an amino group, a carboxyl group, a sulfonamide group, an N-sulfonylamide group, an acyloxy group having 1 to 6 carbon atoms, an alkoxy group having 1 to 20 carbon atoms, a halogen atom, an alkoxycarbonyl group having 2 to 7 carbon atoms, a cyano group, a carbonate group, and an ethylenically unsaturated bond-containing group.

It is preferable that the (m+n)-valent linking group represented by $Z^1$ is a group represented by any one of the following formulae.

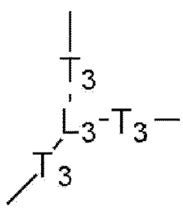 , 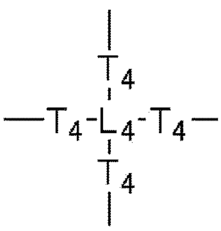 , 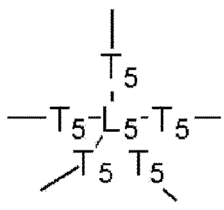 or 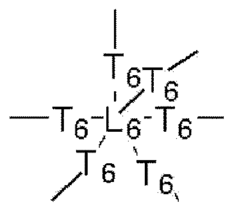

$L_3$ represents a trivalent group. $T_3$ represents a single bond or a divalent linking group, and in a case where three $T_3$'s are present, $T_3$'s may be the same as or different from each other.

$L_4$ represents a tetravalent group. $T_4$ represents a single bond or a divalent linking group, and in a case where four $T_4$'s are present, $T_4$'s may be the same as or different from each other.

$L_5$ represents a pentavalent group. $T_5$ represents a single bond or a divalent linking group, and in a case where five $T_5$'s are present, $T_5$'s may be the same as or different from each other.

$L_6$ represents a hexavalent group. $T_6$ represents a single bond or a divalent linking group, and in a case where six $T_6$'s are present, $T_6$'s may be the same as or different from each other.

Examples of the divalent linking group represented by $T_3$ to $T_6$ include $-CH_2-$, -O-, -CO-, -COO-, -OCO-, -NH-, an aliphatic ring group, an aromatic hydrocarbon ring group, a heterocyclic group, and a group consisting of a combination thereof. The aliphatic ring group, the aromatic hydrocarbon ring group, or the heterocyclic group may be a monocycle or a fused ring. The divalent linking group may further have the above-described substituent.

Examples of the trivalent group represented by $L_3$ include a group obtained by removing one hydrogen atom from the above-described divalent linking group. Examples of the tetravalent group represented by $L_4$ include a group obtained by removing two hydrogen atoms from the above-described divalent linking group. Examples of the pentavalent group represented by $L_5$ include a group obtained by removing three hydrogen atoms from the above-described divalent linking group. Examples of the hexavalent group represented by $L_6$ include a group obtained by removing four hydrogen atoms from the above-described divalent linking group. The trivalent to hexavalent groups represented by $L_3$ to $L_6$ may further have the above-described substituent.

The chemical formula weight of $Z^1$ is preferably 20 to 3000. The upper limit is more preferably 2000 or lower and still more preferably 1500 or lower. The lower limit is preferably 50 or higher and more preferably 100 or higher. In a case where the chemical formula weight of $Z^1$ is within the above-described range, the dispersibility of the pigment in the composition can be improved. The chemical formula weight of $Z^1$ is a value calculated from the structural formula.

Specific examples of the (m+n)-valent linking group can be found in paragraphs "0043" to "0055" of JP2014-177613A, the content of which is incorporated herein by reference.

In Formula (SP-1), $Y^1$ and $Y^2$ each independently represent a single bond or a linking group. Examples of the linking group include a group composed of 1 to 100 carbon atoms, 0 to 10 nitrogen atoms, 0 to 50 oxygen atoms, 1 to 200 hydrogen atoms, and 0 to 20 sulfur atoms. The above-described group may further have the above-described substituent. Specific examples of the linking group represented by $Y^1$ and $Y^2$ include a group composed of one of the following structural units or a combination of two or more of the structural units.

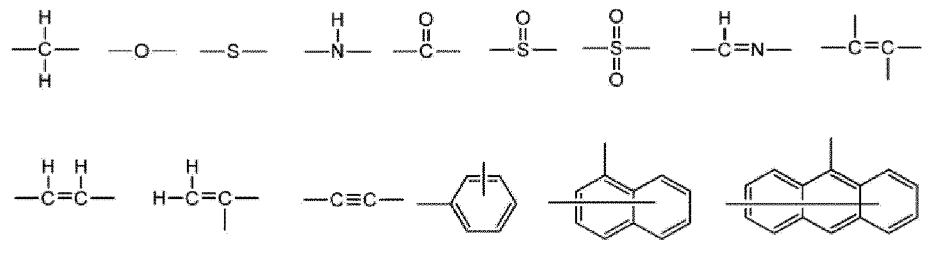

In Formula (SP-1), $P^1$ represents a polymer chain. As the polymer chain represented by $P^1$, a polymer chain which has, in the main chain, at least one repeating unit selected from a poly(meth)acrylic structural repeating unit, a polyether structural repeating unit, a polyester structural repeating unit, a polyamide structural repeating unit, a polyimide structural repeating unit, a polyimine structural repeating unit, or a polyurethane structural repeating unit is preferable. In addition, as the polymer chain represented by $P^1$, a polymer chain including a repeating unit represented by Formulae (P1-1) to (P1-5) is preferable.

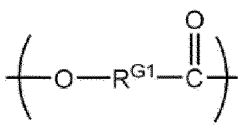

(P1-1)

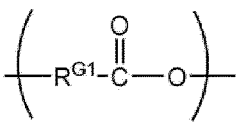

(P1-2)

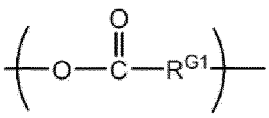

(P1-3)

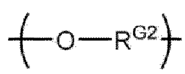

(P1-4)

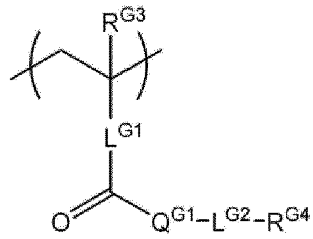

(P1-5)

In the formulae, $R^{G1}$ and $R^{G2}$ each represent an alkylene group. As the alkylene group represented by $R^{G1}$ and $R^{G2}$, and a linear or branched alkylene group having 1 to 20 carbon atoms is preferable, a linear or branched alkylene group having 2 to 16 carbon atoms is more preferable, and a linear or branched alkylene group having 3 to 12 carbon atoms is still more preferable. The alkylene group may have a substituent. Examples of the substituent include an aryl group, a heteroaryl group, an alkoxy group, an aryloxy group, a heteroaryloxy group, an alkylthioether group, an arylthioether group, a heteroarylthioether group, and an ethylenically unsaturated bond-containing group.

In the formulae, $R^{G3}$ represents a hydrogen atom or a methyl group.

In the formulae, $Q^{G1}$ represents -O- or -NH-, $L^{G1}$ represents a single bond or an arylene group, and $L^{G2}$ represents a single bond or a divalent linking group. It is preferable that $Q^{G1}$ represents -O-. It is preferable that $L^{G1}$ represents a single bond. Examples of the divalent linking group represented by $L^{G2}$ include an alkylene group (preferably an alkylene group having 1 to 12 carbon atoms), an arylene group (preferably an arylene group having 6 to 20 carbon atoms), -NH-, -SO-, $-SO_2-$, -CO-, -O-, -COO-, -OCO-, -S-, -NHCO-, -CONH-, and a group including a combination of two or more thereof.

$R^{G4}$ represents a hydrogen atom or a substituent. Examples of the substituent include an alkyl group, an aryl group, a heteroaryl group, an alkoxy group, an aryloxy group, a heteroaryloxy group, an alkylthioether group, an arylthioether group, a heteroarylthioether group, an ethylenically unsaturated bond-containing group, and an acid group.

The repetition number of repeating units in $P^1$ is preferably 3 to 2000. The upper limit is preferably 1500 or lower and more preferably 1000 or lower. The lower limit is preferably 5 or higher and more preferably 7 or higher. In addition, $P^1$ is preferably a polymer chain having a repeating unit including an ethylenically unsaturated bond-containing group in the side chain. In addition, the proportion of the repeating unit including an ethylenically unsaturated bond-containing group in the side chain with respect to the total repeating units constituting $P^1$ is preferably 1 mol% or more, more preferably 2 mol% or more, and still more preferably 3 mol% or more. The upper limit may be 100 mol%. In addition, in a case where $P^1$ is a polymer chain having a repeating unit including an ethylenically unsaturated bond-containing group in the side chain, it is also preferable that $P^1$ includes other repeating units in addition to the repeating unit including an ethylenically unsaturated bond-containing group in the side chain. Examples of the other repeating unit include a repeating unit having an acid group at a side chain. In a case where $P^1$ includes other repeating units including an acid group in the side chain, in addition to the repeating unit including an ethylenically unsaturated bond-containing group in the side chain, the generation of the development residue can be effectively suppressed in the formation of a pattern by a photolithography method. In a case where $P^1$ includes the repeating unit having an acid group at a side chain, the proportion of the repeating unit having an acid group at a side chain with respect to the total repeating units constituting $P^1$ is preferably 50 mol% or less, more preferably 2 to 48 mol%, and still more preferably 4 to 46 mol%.

The weight-average molecular weight of the polymer chain represented by $P^1$ is preferably 1000 or more and more preferably 1000 to 10000. The upper limit is preferably 9000 or lower, more preferably 6000 or lower, and still more preferably 3000 or lower. The lower limit is more preferably 1200 or higher and still more preferably 1400 or higher. The weight-average molecular weight of $P^1$ is a value calculated from the weight-average molecular weight of a raw material used for introducing into the polymer chain.

Specific examples of the resin (SP-1) include polymer compounds C-1 to C-31 described in paragraphs "0196" to "0209" of JP2013-043962A, polymer compounds (C-1) to (C-61) described in paragraphs "0256" to "0269" of JP2014-177613A, and a resin having a structure described in paragraph "0061" of WO2018/163668A, the contents of which are incorporated herein by reference.

In the composition according to the embodiment of the present invention, a resin having a polymerizable group (hereinafter, also referred to as a polymerizable resin) can be used as the resin. Examples of the polymerizable group include an ethylenically unsaturated bond-containing group, an epoxy group, and a cyclic ether group such as an oxetane group. By using the polymerizable resin, it is possible to suppress excessive progress of phase separation in a film after curing. The amount of a polymerizable group-containing group in the polymerizable resin is preferably 0.01 to 5.0 mmol/g. The upper limit is more preferably 4.0 mmol/g or lower, still more preferably 3.0 mmol/g or lower, even more preferably 2.0 mmol/g or lower, and particularly preferably 1.5 mmol/g or lower. The lower limit is preferably 0.1 mmol/g or higher and more preferably 0.2 mmol/g or higher. The amount of the polymerizable group in the polymerizable resin is a

numerical value representing a molar amount of polymerizable group per 1 g of the solid content of the polymerizable resin. In a case where the polymerizable group value in the polymerizable resin can be calculated from raw materials used for the synthesis of the polymerizable resin, a value calculated from the raw materials charged is used. In addition, in a case where the polymerizable group value in the polymerizable resin cannot be calculated from raw materials used for the synthesis of the polymerizable resin, for example, in a case of the ethylenically unsaturated bond-containing group, a value measured using a hydrolysis method is used. Specifically, a low-molecular-weight component (a) of polymerizable group site is extracted from the polymerizable resin by an alkali treatment, a content of the low-molecular-weight component is measured by high-performance liquid chromatography (HPLC), and the polymerizable group value in the polymerizable resin is calculated by the following expression. In a case where the polymerizable group cannot be extracted from the polymerizable resin by the alkali treatment, a value measured by a nuclear magnetic resonance (NMR) method is used.

Polymerizable Group Value [mmol/g] of Polymerizable Resin = (Content [ppm] of Low-Molecular-Weight Component (a)/Molecular Weight [g/mol] of Low-Molecular-Weight Component (a)/(Weighed Value [g] of Polymerizable Resin) × (Concentration of Solid Contents [mass%] of Polymerizable Resin/100) × 10)

Examples of the polymerizable resin include a resin including a repeating unit having a polymerizable group in the side chain and a resin which is represented by Formula (SP-1) described above and has a structure in which at least one of $Z^1$, $A^1$, or $P^1$ is a polymerizable group.

Examples of the repeating unit having a polymerizable group in the side chain include a repeating unit represented by Formula (A-1-1). The resin including the repeating unit represented by Formula (A-1-1) may be used as a dispersant or a binder. In the polymerizable resin, the content of the repeating unit having a polymerizable group is preferably 10 mol% or more, more preferably 10 to 80 mol%, and still more preferably 20 to 70 mol% with respect to the total repeating units of the polymerizable resin.

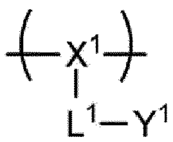

(A-1-1)

In Formula (A-1-1), $X^1$ represents the main chain of the repeating unit, $L^1$ represents a single bond or a divalent linking group, and $Y^1$ represents a polymerizable group.

In Formula (A-1-1), the main chain of the repeating unit represented by $X^1$ is not particularly limited. It is not particularly limited as long as it is a linking group formed from a known polymerizable monomer. Examples thereof include a poly(meth)acrylic linking group, a polyalkyleneimine-based linking group, a polyester-based linking group, a polyurethane-based linking group, a polyuria-based linking group, a polyamide-based linking group, a polyether-based linking group, and a polystyrene-based linking group. Among these, a poly(meth)acrylic linking group or a polyalkyleneimine-based linking group is preferable, and a poly(meth)acrylic linking group is more preferable from the viewpoint of availability of raw materials and manufacturing suitability.

In Formula (A-1-1), examples of the divalent linking group represented by $L^1$ include an alkylene group (preferably an alkylene group having 1 to 12 carbon atoms), an alkyleneoxy group (preferably an alkyleneoxy group having 1 to 12 carbon atoms), an oxyalkylenecarbonyl group (preferably an oxyalkylenecarbonyl group having 1 to 12 carbon atoms), an arylene group (preferably an arylene group having 6 to 20 carbon atoms), -NH-, -SO-, -SOz-, -CO-, -O-, -COO-, -OCO-, -S-, and a group formed by combination of two or more of these groups. The alkylene group, the alkylene group in the alkyleneoxy group, and the alkylene group in the oxyalkylenecarbonyl group may be linear, branched, or cyclic, and are preferably linear or branched. In addition, the alkylene group, the alkylene group in the alkyleneoxy group, and the alkylene group in the oxyalkylenecarbonyl group may have a substituent or may be unsubstituted. Examples of the substituent include a hydroxy group and an alkoxy group, and a hydroxy group is preferable from the viewpoint of manufacturing suitability.

In Formula (A-1-1), examples of the polymerizable group represented by $Y^1$ include an ethylenically unsaturated

bond-containing group and a cyclic ether group, and an ethylenically unsaturated bond-containing group is preferable. Examples of the ethylenically unsaturated bond-containing group include a vinyl group, a vinyloxy group, an allyl group, a methallyl group, a (meth)acryloyl group, a styrene group, a cinnamoyl group, and a maleimide group. Among these, a (meth)acryloyl group, a styrene group, or a maleimide group is preferable, a (meth)acryloyl group is more preferable, and an acryloyl group is particularly preferable.

The resin including the repeating unit represented by Formula (A-1-1) may further include a repeating unit having a graft chain. Examples of the repeating unit having a graft chain include the repeating unit represented by Formula (A-1-2) described above. In the polymerizable resin, the content of the repeating unit having a graft chain is preferably 1.0 to 60 mol% and more preferably 1.5 to 50 mol% with respect to the total repeating units of the polymerizable resin.

The resin including the repeating unit represented by Formula (A-1-1) described above may further include a repeating unit having an acid group. The content of the repeating unit having an acid group is preferably 80 mol% or less and more preferably 10 to 80 mol% with respect to the total repeating units of the polymerizable resin.

It is preferable that the film-forming component includes a resin as a dispersant for the particles and a resin as a binder, respectively. In addition, the resin as a binder preferably has low compatibility with the resin as a dispersant for the particles. By using such resins in combination, it is easy to form the phase-separated structure between the above-described first phase and the above-described second phase in the film formed of the composition, and it is easy to improve the light scattering properties of the obtained film.

As the resin as a dispersant and the resin as a binder, the above-described resins can be appropriately selected and used. The resin used as a dispersant is preferably a resin having an acid group. A commercially available product is also available as the dispersant, and specific examples thereof include DISPERBYK series (for example, DISPERBYK-111, 2001, and the like) manufactured by BYK-Chemie Japan K.K., Solsperse series (for example, Solsperse 20000, 76500, and the like) manufactured by Lubrizol Corporation, and AJISPER series manufactured by Ajinomoto Fine-Techno Co., Inc. In addition, products described in paragraph "0129" of JP2012-137564A and products described in paragraph "0235" of JP2017-194662A can also be used as the dispersant.

In addition, it is preferable that the film-forming component includes two or more kinds of resins selected from a resin A1 having a structure in which a polymer chain is bonded to a tri- or higher valent linking group and a resin A2 including a repeating unit having a graft chain. In this case, it is preferable that at least one of the two or more resins is the resin as a dispersant and the rest is the resin as a binder. That is, as the resin as a dispersant and the resin as a binder, the resin A1 having a structure in which a polymer chain is bonded to a tri- or higher valent linking group and the resin A2 including a repeating unit having a graft chain are preferably used.

Preferred aspects of the resin included in the film-forming component include the following aspects.

(1) aspect in which the film-forming component includes a resin A1-1 having a structure in which a polymer chain is bonded to a tri- or higher valent linking group and a resin A1-2 having a structure in which a polymer chain including a repeating unit having a structure different from a structure of the polymer chain of the resin A1-1 is bonded to a tri- or higher valent linking group

(2) aspect in which the film-forming component includes a resin A2-1 having a repeating unit having a graft chain and a resin A2-2 having a repeating unit having a graft chain, which includes a repeating unit having a structure different from a structure of the graft chain of the resin A2-1

(3) aspect in which the film-forming component includes a resin A1-3 having a structure in which a polymer chain is bonded to a tri- or higher valent linking group and a resin A2-3 having a repeating unit having a graft chain, which includes a repeating unit having a structure different from a structure of the polymer chain of the resin A1-3

The repeating unit having a different structure described above means that the repeating unit has a different type of main chain. Therefore, even in a case where the types of substituents bonded to the main chain are different, those with the same type of main chain of the repeating unit (for example, repeating units of poly (meth)acrylic structure, repeating units of polyester structure, and the like) correspond to repeating units having the same structure.

In addition, it is preferable that the main chain structure of the polymer chain included in the resin A1 used as a dispersant or the graft chain included in the resin A2 and the structure of the repeating unit of the polymer chain included in the resin A1 used as a binder or the graft chain included in the resin A2 are different from each other. Since resins having a polymer chain or a graft chain including repeating units with different structures tend to have low compatibility, in a case where such a combination of the dispersant and the binder is included, it is easy to form the phase-separated structure between the above-described first phase and the above-described second phase in the film formed of the composition, and it is easy to improve the light scattering properties of the obtained film.

Examples of the combination of resins having low compatibility include the following.

· combination of a resin A1 having a polymer chain including a poly(meth)acrylic structural repeating unit or a resin

A2 having a graft chain including a poly(meth)acrylic structural repeating unit, and a resin A1 having a polymer chain including a polyester structural repeating unit or a resin A2 having a graft chain including a polyester structural repeating unit

· combination of a polyamide resin and a phenol resin

In addition, the film-forming component also preferably includes at least one kind selected from a resin having a structure in which a polymer chain including a repeating unit of a polyester structure is bonded to a tri- or higher valent linking group or a resin including a repeating unit having a graft chain, which includes a repeating unit of a polyester structure. In a case where the film-forming component includes such a resin, the effect of improving phase separation efficiency can be expected.

The content of the resin in the total solid content of the composition is preferably 0.1 to 60 mass%. The lower limit is preferably 1 mass% or more and more preferably 5 mass% or more. The upper limit is preferably 50 mass% or less, and more preferably 45 mass% or less.

In addition, the resin used in the composition preferably includes 10 mass% or more of the polymerizable resin (preferably, a resin including an ethylenically unsaturated bond-containing group), more preferably includes 20 mass% or more of the polymerizable resin, and still more preferably 30 mass% or more of the polymerizable resin.

In addition, the resin used in the composition preferably includes 10 mass% or more of the resin as a dispersant, more preferably includes 20 mass% or more of the resin as a dispersant, and still more preferably 30 mass% or more of the resin as a dispersant.

In addition, the resin used in the composition preferably includes 40 to 250 parts by mass of the resin as a binder, more preferably 50 to 225 parts by mass of the resin as a binder, and still more preferably 60 to 200 parts by mass of the resin as a binder with respect to 100 parts by mass of the resin as a dispersant.

The content of the dispersant in the composition is preferably 5 to 150 parts by mass with respect to 100 parts by mass of the above-described particles. The upper limit is preferably 140 parts by mass or less, more preferably 125 parts by mass or less, and still more preferably 100 parts by mass or less. The lower limit is preferably 10 parts by mass or more, more preferably 15 parts by mass or more, and still more preferably 25 parts by mass or more.

In addition, it is also preferable that the composition according to the embodiment of the present invention includes a resin having a polymerizable group and a resin not having a polymerizable group. According to this aspect, the phase separation is easily promoted due to polymerizable phase separation. In this case, the content of the resin having a polymerizable group is preferably 5 to 90 parts by mass with respect to 100 parts by mass of the resin not having a polymerizable group. The upper limit is preferably 85 parts by mass or less, more preferably 80 parts by mass or less, and still more preferably 70 parts by mass or less. The lower limit is preferably 10 parts by mass or more, more preferably 15 parts by mass or more, and still more preferably 25 parts by mass or more.

In addition, it is also preferable that the composition according to the embodiment of the present invention includes the resin having a structure in which a polymer chain is bonded to a tri- or higher valent linking group and the resin including a repeating unit having a graft chain. In this case, among the resin having a structure in which a polymer chain is bonded to a tri- or higher valent linking group and the resin including a repeating unit having a graft chain, it is preferable that one resin is the dispersant and the other resin is the binder. In addition, the content of the resin having a structure in which a polymer chain is bonded to a tri- or higher valent linking group is preferably 40 to 250 parts by mass with respect to 100 parts by mass of the resin including a repeating unit having a graft chain. The upper limit is preferably 250 parts by mass or less, more preferably 225 parts by mass or less, and still more preferably 200 parts by mass or less. The lower limit is preferably 40 parts by mass or more, more preferably 50 parts by mass or more, and still more preferably 60 parts by mass or more. In addition, the total content of the resin having a structure in which a polymer chain is bonded to a tri- or higher valent linking group and the resin including a repeating unit having a graft chain in the resins included in the composition is preferably 20 mass% or more and more preferably 30 mass% or more.

(Polymerizable Monomer)

As the polymerizable monomer, a well-known compound which is crosslinkable by a radical, an acid, or heat can be used. Examples of the polymerizable monomer include a compound having an ethylenically unsaturated bond-containing group and a compound having a cyclic ether group. Examples of the ethylenically unsaturated bond-containing group include a vinyl group, a (meth)allyl group, and a (meth)acryloyl group. Examples of the cyclic ether group include an epoxy group and an oxetanyl group. As the polymerizable monomer, a radically polymerizable monomer or a cationically polymerizable monomer is preferable, and a radically polymerizable monomer is more preferable.

In addition, the polymerizable monomer used in the present invention may be a polymerizable monomer including a ring structure, and in this case, a radically polymerizable monomer including a ring structure is more preferable. In a case of using a polymerizable monomer including a ring structure, phase separation from the resin tends to occur. In particular, the above-described effect is remarkable in a case of using a radically polymerizable monomer including

a ring structure. For the reason that the above-described effect can be obtained more remarkably, the ring structure included in the polymerizable monomer is preferably an aliphatic ring. In addition, the aliphatic ring is preferably an aliphatic crosslinked ring. The aliphatic crosslinked ring is an aliphatic ring having a structure in which two or more atoms that are not adjacent to each other are linked to one aliphatic ring. Specific examples of the aliphatic crosslinked ring include a tricyclodecane ring and an adamantane ring, and a tricyclodecane ring is preferable. From the viewpoint of mobility of the monomer, the number of ring structures included in the polymerizable monomer is preferably 1 to 5, more preferably 1 to 3, and still more preferably 1. Specific examples of the radically polymerizable monomer including a ring structure include dimethylol-tricyclodecanediacrylate and 1,3-adamantananediol diacrylate.

The radically polymerizable monomer is not particularly limited as long as it is a compound which is polymerizable by the action of a radical. As the radically polymerizable monomer, a compound having an ethylenically unsaturated bond-containing group is preferable, a compound having two or more ethylenically unsaturated bond-containing groups is more preferable, and a compound having three or more ethylenically unsaturated bond-containing groups is still more preferable. The upper limit of the number of the ethylenically unsaturated bond-containing groups is, for example, preferably 15 or less and more preferably 6 or less. Examples of the ethylenically unsaturated bond-containing group include a vinyl group, a styryl group, a (meth)allyl group, and a (meth)acryloyl group. Among these, a (meth)acryloyl group is preferable. The radically polymerizable monomer is preferably a (meth)acrylate compound having 3 to 15 functional groups and more preferably a (meth)acrylate compound having 3 to 6 functional groups. In addition, it is also preferable that the radically polymerizable monomer includes a ring structure.

The molecular weight of the radically polymerizable monomer is preferably 200 to 3000. The upper limit of the molecular weight is preferably 2500 or less and still more preferably 2000 or less. The lower limit of the molecular weight is preferably 250 or more and still more preferably 300 or more.

In addition, it is also preferable that the radically polymerizable monomer is a compound having a group having an ethylenically unsaturated bond-containing group which has a boiling point at 100°C or higher under normal pressure and has at least one ethylene group capable of addition polymerization. Examples of the radically polymerizable monomer include: a monofunctional acrylate or methacrylate such as polyethylene glycol mono(meth)acrylate, polypropylene glycol mono(meth)acrylate, or phenoxyethyl (meth)acrylate; polyethylene glycol di(meth)acrylate, trimethylol ethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylol propane tri(acryloyloxypropyl)ether, or tri(acryloyloxyethyl)isocyanurate; and mixtures of the above-described compounds. Among these, pentaerythritol tetra(meth)acrylate is preferable.

In addition, as the radically polymerizable monomer, a compound represented by any one of the following Formulae (MO-1) to (MO-5) can also be suitably used. In a case where T in the formulae represents an oxyalkylene group, a terminal thereof on a carbon atom side in T is bonded to R.

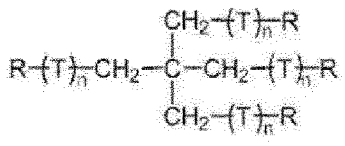

(MO-1)

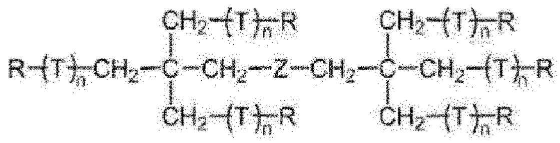

(MO-2)

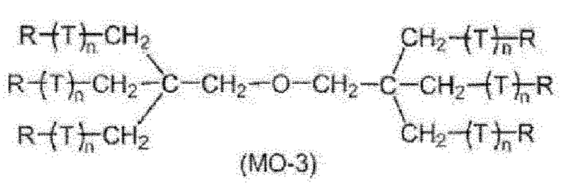

(MO-3)

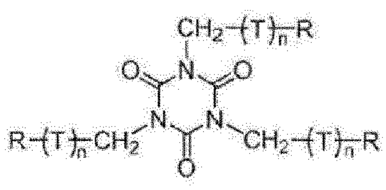

(MO-4)

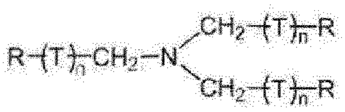

(MO-5)

R: 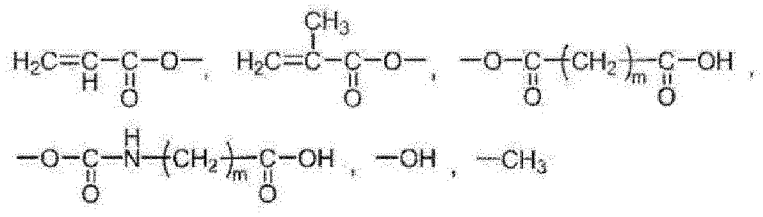

T: 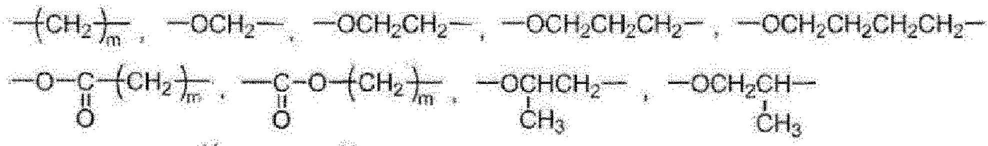

Z: 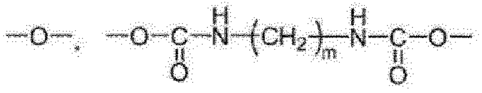

In the formulae, n represents 0 to 14, and m represents 1 to 8. A plurality of R's and a plurality of T's which are present in the same molecule may be the same as or different from each other. At least one of a plurality of R's which are present in each of the compounds represented by Formula (MO-1) to (MO-5) represents a group represented by $-OC(=O)CH=CH_2$ or $-OC(=O)C(CH_3)=CH_2$. Specific examples of the compounds represented by Formulae (MO-1) to (MO-5) include compounds described in paragraphs "0248" to "0251" of JP2007-269779A, the content of which is incorporated herein by reference.

As the radically polymerizable monomer, dipentaerythritol triacrylate (as a commercially available product, KAYARAD D-330 manufactured by Nippon Kayaku Co., Ltd.), dipentaerythritol tetraacrylate (as a commercially available product, KAYARAD D-320 manufactured by Nippon Kayaku Co., Ltd.), dipentaerythritol penta(meth)acrylate (as a commercially available product, KAYARAD D-310 manufactured by Nippon Kayaku Co., Ltd.), dipentaerythritol hexa(meth)acrylate (as a commercially available product, KAYARAD DPHA manufactured by Nippon Kayaku Co., Ltd. and NK ESTER A-DPH-12E manufactured by Shin-Nakamura Chemical Co., Ltd.), a compound having a structure in which a (meth)acryloyl group thereof is bonded through an ethylene glycol residue and/or a propylene glycol residue (for example, SR454 and SR499 available from Sartomer Japan Inc.), diglycerin ethylene oxide (EO)-modified (meth)acrylate (as a commercially available product, M-460 manufactured by TOAGOSEI CO., LTD.), pentaerythritol tetraacrylate (NK ESTER A-TMMT manufactured by Shin-Nakamura Chemical Co., Ltd.), 1,6-hexanediol diacrylate (KAYARAD HDDA manufactured by Nippon Kayaku Co., Ltd.), KAYARAD RP-1040 (manufactured by Nippon Kayaku Co., Ltd.), ARONIX TO-2349 (manufactured by TOAGOSEI CO., LTD.), NK OLIGO UA-7200 (manufactured by Shin-Nakamura Chemical Co., Ltd.), 8UH-1006 and 8UH-1012 (manufactured by Taisei Fine Chemical Co., Ltd.), Light Acrylate POB-A0 (manufactured by KYOEISHA CHEMICAL Co., Ltd.), or the like can also be used.

In addition, as the radically polymerizable monomer, it is also preferable to use a trifunctional (meth)acrylate compound such as trimethylolpropane tri(meth)acrylate, trimethylolpropane propyleneoxide-modified tri(meth)acrylate, trimethylolpropane ethyleneoxide-modified tri(meth)acrylate, isocyanuric acid ethyleneoxide-modified tri(meth)acrylate, and pentaerythritol tri(meth)acrylate. Examples of a commercially available product of the trifunctional (meth)acrylate compound include ARONIX M-309, M-310, M-321, M-350, M-360, M-313, M-315, M-306, M-305, M-303, M-452, and M-450 (manufactured by TOAGOSEI CO., LTD.), NK ESTER A9300, A-GLY-9E, A-GLY-20E, A-TMM-3, A-TMM-3L, A -TMM-3LM-N, A-TMPT, and TMPT (manufactured by Shin-Nakamura Chemical Co., Ltd.), and KAYARAD GPO-303, TMPTA, THE-330, TPA-330, and PET-30 (manufactured by Nippon Kayaku Co., Ltd.).

The radically polymerizable monomer may have an acid group such as a carboxyl group, a sulfo group, or a phosphate group. Examples of the radically polymerizable monomer having an acid group include an ester of an aliphatic polyhydroxy compound and an unsaturated carboxylic acid. Examples of a commercially available product include ARONIX series (for example, M-305, M-510, or M-520, manufactured by Toagosei Co., Ltd.). The acid value of the radically polymerizable monomer having an acid group is preferably 0.1 to 40 mgKOH/g. The lower limit is preferably 5 mgKOH/g or more. The upper limit is preferably 30 mgKOH/g or less.

Examples of the cationically polymerizable monomer include a compound having a cationically polymerizable group. Examples of the cationically polymerizable group include a cyclic ether group such as an epoxy group or an oxetanyl group. As the cationically polymerizable monomer, a compound having a cyclic ether group is preferable, and a compound having an epoxy group (also referred to as an "epoxy compound") is more preferable.

The molecular weight of the cationically polymerizable monomer is preferably 200 to 3000. The upper limit of the molecular weight is preferably 2500 or less and still more preferably 2000 or less. The lower limit of the molecular weight is preferably 250 or more and still more preferably 300 or more.

Examples of the epoxy compound include a compound having one or more epoxy groups in one molecule. Among these, a compound having two or more epoxy groups in one molecule is preferable. The number of epoxy groups in one molecule is preferably 1 to 100. The upper limit of the epoxy group may be, for example, 10 or less or 5 or less. The lower limit of the epoxy group is preferably 2 or more.

Examples of the epoxy compound include a compound represented by the following Formula (EP1).

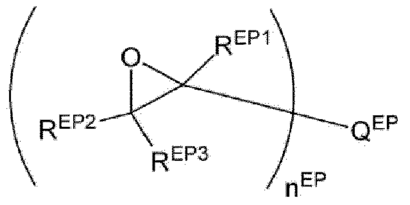

(EP1)

In Formula (EP1), $R^{EP1}$ to $R^{EP3}$ each independently represent a hydrogen atom, a halogen atom, or an alkyl group. The alkyl group may have a cyclic structure or may have a substituent. $R^{EP1}$ and $R^{EP2}$, or $R^{EP2}$ and $R^{EP3}$ may be bonded to each other to form a ring structure. $Q^{EP}$ represents a single bond or an $n^{EP}$-valent organic group. $R^{EP1}$ to $R^{EP3}$ may be bonded to $Q^{EP}$ to form a ring structure. $n^{EP}$ represents an integer of 2 or more, preferably 2 to 10 and more preferably 2 to 6. However, in a case where $Q^{EP}$ is a single bond, $n^{EP}$ is 2. The details of $R^{EP1}$ to $R^{EP3}$, and $Q^{EP}$ can be found in paragraphs "0087" and "0088" of JP2014-089408A, the content of which is incorporated herein by reference. Specific examples of the compound represented by Formula (EP1) include a compound described in paragraph "0090" of JP2014-089408A and a compound described in paragraph "0151" of JP2010-054632A, the contents of which are incorporated herein by reference.

As the cationically polymerizable monomer, a commercially available product can also be used. Examples of the commercially available product include ADEKA GLYCILOL series manufactured by Adeka Corporation (for example, ADEKA GLYCILOL ED-505) and EPOLEAD series manufactured by Daicel Corporation (for example, EPOLEAD GT401).

The content of the polymerizable monomer in the total solid content of the composition is preferably 0.1 to 40 mass%. The lower limit is preferably 0.5 mass% or more and more preferably 1 mass% or more. The upper limit is preferably 30 mass% or less and more preferably 20 mass% or less. As the polymerizable monomer, one kind may be used alone, or two or more kinds may be used in combination. In a case where two or more polymerizable monomers are used in combination, it is preferable that the total content of the two or more polymerizable monomers is within the above-described range. In addition, in a case where two or more polymerizable monomers are used in combination, two or more radically polymerizable monomers may be used in combination, or a radically polymerizable monomer and a cationically polymerizable monomer may be used in combination.

In addition, the total content of the polymerizable monomer and the resin in the total solid content of the composition is preferably 10 to 90 mass%. The upper limit is preferably 80 mass% or less, and more preferably 75 mass% or less. The lower limit is preferably 20 mass% or more and more preferably 30 mass% or more.

In addition, the ratio of the polymerizable monomer to the resin is preferably 10 to 400 parts by mass of the polymerizable monomer with respect to 100 parts by mass of the resin. The lower limit is preferably 15 parts by mass or more and more preferably 20 parts by mass or more. The upper limit is preferably 380 parts by mass or less and more preferably 350 parts by mass or less.

«Solvent»

The composition according to the embodiment of the present invention includes a solvent. Examples of the solvent include an organic solvent. Basically, the solvent is not particularly limited as long as it satisfies the solubility of the respective components and the application properties of the composition. Examples of the organic solvent include an ester solvent, a ketone solvent, an alcohol solvent, an amide solvent, an ether solvent, and a hydrocarbon solvent. The details of the organic solvent can be found in paragraph "0223" of WO2015/166779A, the content of which is incorporated herein by reference. In addition, an ester solvent in which a cyclic alkyl group is substituted or a ketone solvent in which a cyclic alkyl group is substituted can also be preferably used. Specific examples of the organic solvent include acetone, methyl ethyl ketone, cyclohexane, cyclohexanone, cyclopentanone, ethyl acetate, butyl acetate, cyclohexyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxy

propyl acetate, N,N-dimethylformamide, dimethyl sulfoxide, g-butyrolactone, methyl lactate, ethyl lactate, butyl diglycol acetate, 3-methoxy butyl acetate, 3-methoxy-N,N-dimethylpropanamide, and 3-butoxy-N,N-dimethylpropanamide. Among these organic solvents, one kind can be used alone, or a mixture of two or more kinds can be used.

In the present invention, an organic solvent having a low metal content is preferably used. For example, the metal content in the organic solvent is preferably 10 mass parts per billion (ppb) or less. Optionally, an organic solvent having a metal content at a mass parts per trillion (ppt) level may be used. For example, such an organic solvent is available from Toyo Gosei Co., Ltd. (The Chemical Daily, November 13, 2015).

Examples of a method of removing impurities such as metal from the organic solvent include distillation (for example, molecular distillation or thin-film distillation) and filtering using a filter. The pore size of a filter used for the filtering is preferably 10 μm or less, more preferably 5 μm or less, and still more preferably 3 μm or less. As a material of the filter, polytetrafluoroethylene, polyethylene, or nylon is preferable.

The organic solvent may include an isomer (a compound having the same number of atoms and a different structure). In addition, the organic solvent may include only one isomer or a plurality of isomers.

The organic solvent preferably has the content of peroxides of 0.8 mmol/L or less, and it is more preferable that the organic solvent does not substantially include peroxides.

The content of the solvent in the composition is preferably 10 to 95 mass%. The lower limit is preferably 20 mass% or more, more preferably 30 mass% or more, and still more preferably 40 mass% or more. The upper limit is preferably 90 mass%% or less, more preferably 85 mass% or less, and still more preferably 80 mass% or less. As the solvent, one kind may be used alone, or two or more kinds may be used in combination. In a case where two or more solvents are used in combination, it is preferable that the total content of the solvents is within the above-described range.

«Photopolymerization Initiator»

The composition according to the embodiment of the present invention may contain a photopolymerization initiator. Examples of the photopolymerization initiator include a photoradical polymerization initiator and a photocationic polymerization initiator. It is preferable that the photopolymerization initiator selected according to the type of the polymerizable monomer is used. In a case where a radically polymerizable monomer is used as the polymerizable monomer, it is preferable that the photoradical polymerization initiator is used as the photopolymerization initiator. In addition, in a case where a cationically polymerizable monomer is used as the polymerizable monomer, it is preferable that the photocationic polymerization initiator is used as the photopolymerization initiator. The photopolymerization initiator is not particularly limited and can be appropriately selected from well-known photopolymerization initiators. For example, a compound having photosensitivity to light in a range from an ultraviolet range to a visible range is preferable.

The content of the photopolymerization initiator in the total solid content of the composition is preferably 0.1 to 50 mass%, more preferably 0.5 to 30 mass%, and still more preferably 1 to 20 mass%. The composition according to the embodiment of the present invention may include one photopolymerization initiator or two or more photopolymerization initiators. In a case where the composition includes two or more photopolymerization initiators, it is preferable that the total content of the photopolymerization initiators is within the above-described range.

(Photoradical Polymerization Initiator)

Examples of the photoradical polymerization initiator include a halogenated hydrocarbon derivative (for example, a compound having a triazine skeleton or a compound having an oxadiazole skeleton), an acylphosphine compound, a hexaarylbiimidazole, an oxime compound, an organic peroxide, a thio compound, a ketone compound, an aromatic onium salt, an α-hydroxyketone compound, and an α-aminoketone compound. In addition, from the viewpoint of exposure sensitivity, as the photopolymerization initiator, a trihalomethyltriazine compound, a benzyldimethylketal compound, an α-hydroxyketone compound, an α-aminoketone compound, an acylphosphine compound, a phosphine oxide compound, a metallocene compound, an oxime compound, a triarylimidazole dimer, an onium compound, a benzothiazole compound, a benzophenone compound, an acetophenone compound, a cyclopentadiene-benzene-iron complex, a halomethyl oxadiazole compound, or a 3-aryl-substituted coumarin compound is preferable, a compound selected from the group consisting of an oxime compound, an α-hydroxyketone compound, an α-aminoketone compound, and an acylphosphine compound is more preferable, and an oxime compound is still more preferable. Examples of the photopolymerization initiator include compounds described in paragraphs 0065 to 0111 of JP2014-130173A, and JP6301489B, the contents of which are incorporated herein by reference.

Examples of a commercially available product of the α-hydroxyketone compound include Omnirad 184, Omnirad 1173, Omnirad 2959, and Omnirad 127 (all of which are manufactured by IGM Resins B.V.), Irgacure 184, Irgacure 1173, Irgacure 2959, and Irgacure 127 (all of which are manufactured by BASF). Examples of a commercially available product of the α-aminoketone compound include Omnirad 907, Omnirad 369, Omnirad 369E, and Omnirad 379EG (all of which are manufactured by IGM Resins B.V.), Irgacure 907, Irgacure 369, Irgacure 369E, and Irgacure 379EG (all of

which are manufactured by BASF). Examples of a commercially available product of the acylphosphine compound include Omnirad 819 and Omnirad TPO (both of which are manufactured by IGM Resins B.V.), Irgacure 819 and Irgacure TPO (both of which are manufactured by BASF).

Examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2000-080068A, the compounds described in JP2004-534797A, the compounds described in JP2006-342166A, the compounds described in JP2017-019766A, the compounds described in JP6065596B, the compounds described in WO2015/152153A, the compounds described in WO2017/051680A, the compounds described in JP2017-198865A, the compounds described in paragraph "0025" to 0038" of WO2017/164127A, and the compounds described in WO2013/167515A. Specific examples of the oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluene sulfonyloxy)iminobutan-2-one, and 2-ethoxycarbonyloxyimino-1-phenylpropan-1-one. Examples of a commercially available product thereof include Irgacure OXE01, Irgacure OXE02, Irgacure OXE03, and Irgacure OXE04 (all of which are manufactured by BASF), TR-PBG-304 (manufactured by TRONLY), and ADEKA OPTOMER N-1919 (manufactured by ADEKA Corporation; photopolymerization initiator 2 described in JP2012-014052A). In addition, as the oxime compound, it is also preferable to use a compound having no colorability or a compound having high transparency and being resistant to discoloration. Examples of a commercially available product of the oxime compound include ADEKA ARKLS NCI-730, NCI-831, and NCI-930 (all of which are manufactured by Adeka Corporation).

An oxime compound having a fluorene ring can also be used as the photopolymerization initiator. Specific examples of the oxime compound having a fluorene ring include a compound described in JP2014-137466A.

As the photopolymerization initiator, an oxime compound having a skeleton in which at least one benzene ring of a carbazole ring is a naphthalene ring can also be used. Specific examples of such an oxime compound include the compounds described in WO2013/083505A.

An oxime compound having a fluorine atom can also be used as the photopolymerization initiator. Specific examples of the oxime compound having a fluorine atom include a compound described in JP2010-262028A, Compound 24 and 36 to 40 described in JP2014-500852A, and Compound (C-3) described in JP2013-164471A.

An oxime compound having a nitro group can be used as the photopolymerization initiator. It is preferable that the oxime compound having a nitro group is a dimer. Specific examples of the oxime compound having a nitro group include a compound described in paragraphs "0031" to "0047" of JP2013-114249A and paragraphs "0008" to "0012" and "0070" to "0079" of JP2014-137466A, a compound described in paragraphs "0007" to 0025" of JP4223071B, and ADEKA ARKLS NCI-831 (manufactured by Adeka Corporation).

An oxime compound having a benzofuran skeleton can also be used as the photopolymerization initiator. Specific examples thereof include OE-01 to OE-75 described in WO2015/036910A.

Specific examples of the oxime compound which are preferably used in the present invention are shown below, but the present invention is not limited thereto.

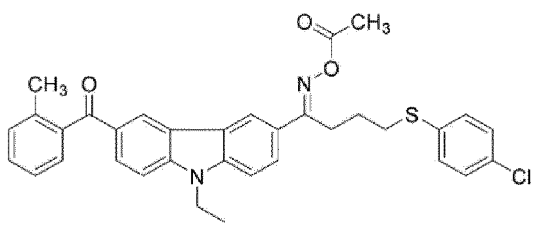

(C-1)

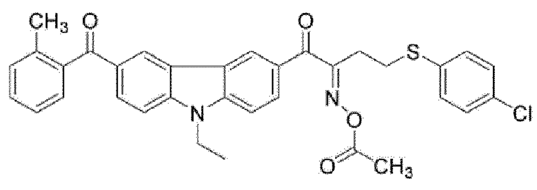

(C-2)

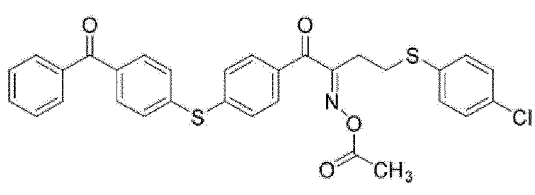

(C-3)

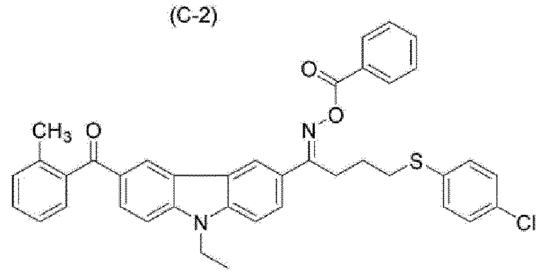

(C-4)

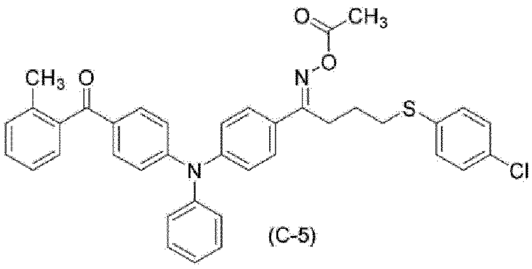

(C-5)

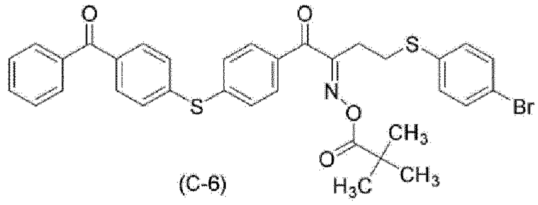

(C-6)

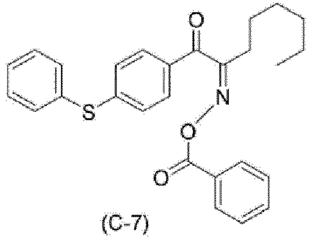

(C-7)

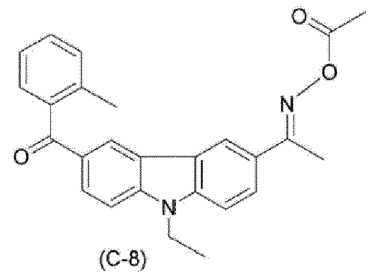

(C-8)

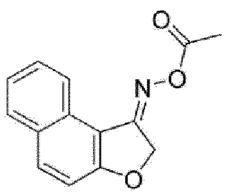

(C-9)

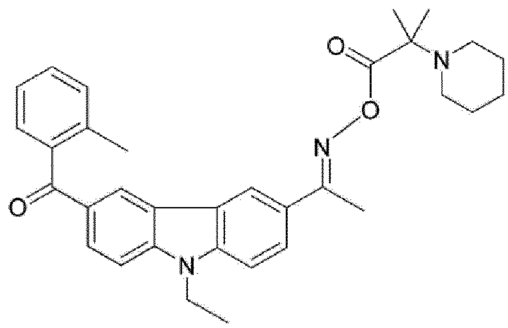

(C-10)

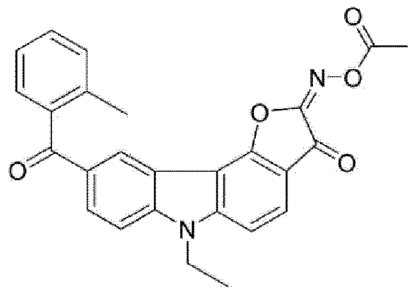

(C-11)

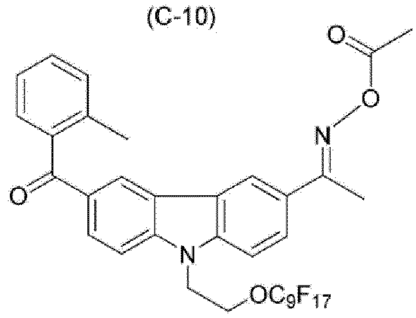

(C-12)

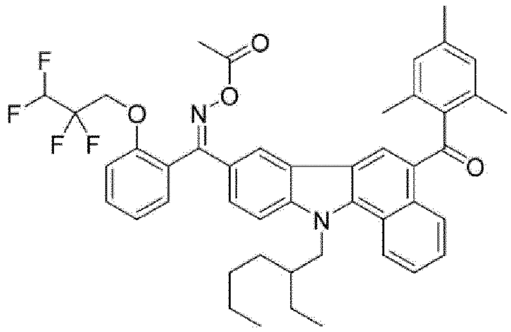

(C-13)

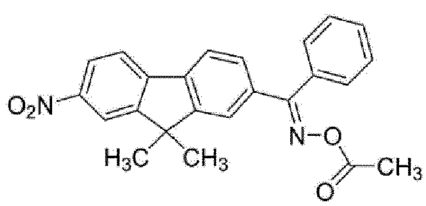

(C-14)

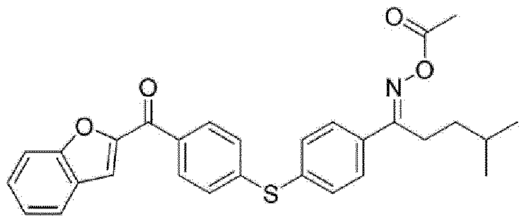

(C-15)

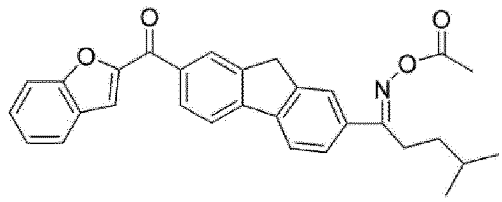

(C-16)

The oxime compound is preferably a compound having a maximal absorption wavelength in a wavelength range of 350 to 500 nm and more preferably a compound having a maximal absorption wavelength in a wavelength range of 360 to 480 nm. In addition, from the viewpoint of sensitivity, the molar absorption coefficient of the oxime compound at a wavelength of 365 nm or 405 nm is preferably high, more preferably 1000 to 300000, still more preferably 2000 to 300000, and particularly preferably 5000 to 200000. The molar absorption coefficient of the compound can be measured using a well-known method. For example, it is preferable that the molar absorption coefficient can be measured using a spectrophotometer (Cary-5 spectrophotometer, manufactured by Varian Medical Systems, Inc.) and ethyl acetate at a concentration of 0.01 g/L.

As the photopolymerization initiator, a bifunctional or tri- or higher functional photoradical polymerization initiator may be used. By using such a photoradical polymerization initiator, two or more radicals are generated from one molecule of the photoradical polymerization initiator, and as a result, good sensitivity is obtained. In addition, in a case of using a compound having an asymmetric structure, crystallinity is reduced so that solubility in a solvent or the like is improved, precipitation is to be difficult over time, and temporal stability of the coloring composition can be improved. Specific examples of the bifunctional or tri- or higher functional photoradical polymerization initiator include dimers of the oxime compounds described in JP2010-527339A, JP2011-524436A, WO2015/004565A, paragraphs "0407" to "0412" of JP2016-532675A, and paragraphs "0039" to "0055" of WO2017/033680A; the compound (E) and compound (G) described in JP2013-522445A; Cmpd 1 to 7 described in WO2016/034963A; the oxime ester photoinitiators described in paragraph "0007" of JP2017-523465A; the photoinitiators described in paragraphs "0020" to "0033" of JP2017-167399A; and the photopolymerization initiator (A) described in paragraphs "0017" to "0026" of JP2017-151342A.

The content of the photoradical polymerization initiator in the total solid content of the composition is preferably 0.1 to 50 mass%, more preferably 0.5 to 30 mass%, and still more preferably 1 to 20 mass%. The composition according to the embodiment of the present invention may include one photoradical polymerization initiator or two or more photoradical polymerization initiators. In a case where the composition includes two or more photoradical polymerization initiators, it is preferable that the total content of the photoradical polymerization initiators is within the above-described range.

(Photocationic Polymerization Initiator)

Examples of the photocationic polymerization initiator include a photoacid generator. Examples of the photoacid generator include compounds which are decomposed by light irradiation to generate an acid including: an onium salt compound such as a diazonium salt, a phosphonium salt, a sulfonium salt, or an iodonium salt; and a sulfonate compound such as imidosulfonate, oximesulfonate, diazodisulfone, disulfone, or o-nitrobenzyl sulfonate.

Examples of the photocationic polymerization initiator include compounds represented by the following Formulae (b1), (b2), and (b3).

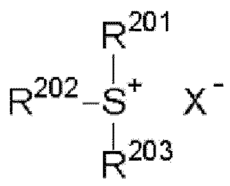

(b1)

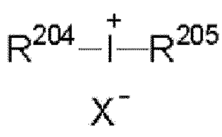

(b2)

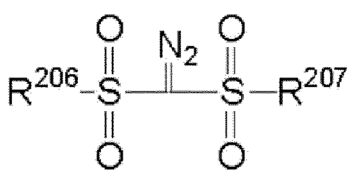

(b3)

In the formulae, $R^{201}$ to $R^{207}$ each independently represent an organic group. The number of carbon atoms in the organic group is preferably 1 to 30. Examples of the organic group include an alkyl group and an aryl group. In

Formula (b1), two of $R^{201}$ to $R^{203}$ may be bonded to each other to form a ring structure, and the ring may include an oxygen atom, a sulfur atom, an ester bond, an amide bond, or a carbonyl group. In the formulae, $X^-$represents a non-nucleophilic anion. Examples of the non-nucleophilic anion include a sulfonate anion, a carboxylate anion, a bis(alkylsulfonyl)amide anion, a tris(alkylsulfonyl)methide anion, $BF_4^-$, $PF_6^-$, and $SbF_6^-$. The details of the compound represented by Formulae (b1), (b2), and (b3) can be found in paragraphs "0139" to "0214" of JP2009-258603A, the content of which is incorporated herein by reference.

Specific examples of the photocationic polymerization initiator include a compound having the following structure.

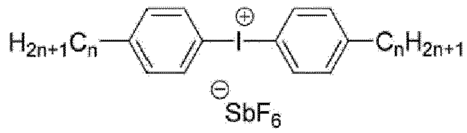

As the photocationic polymerization initiator, a commercially available product can also be used. Examples of the commercially available product of the photocationic polymerization initiator include ADEKA ARKLS SP series manufactured by Adeka Corporation (for example, ADEKA ARKLS SP-606) and IRGACURE 250, IRGACURE 270, and IRGACURE 290 manufactured by BASF.

The content of the photocationic polymerization initiator in the total solid content of the composition is preferably 0.1 to 50 mass%, more preferably 0.5 to 30 mass%, and still more preferably 1 to 20 mass%. The composition according to the embodiment of the present invention may include one photocationic polymerization initiator or two or more photocationic polymerization initiators. In a case where the composition includes two or more photocationic polymerization initiators, it is preferable that the total content of the two or more photocationic polymerization initiators is within the above-described range.

<<Pigment Derivative>>

The composition according to the embodiment of the present invention may further contain a pigment derivative. Examples of the pigment derivative include a compound having a structure in which a portion of a chromophore is substituted with an acidic group, a basic group, or a phthalimidomethyl group. Examples of the acid group include a sulfo group, a carboxyl group, and a quaternary ammonium salt group thereof. Examples of the basic group include an amino group. The details of the pigment derivative can be found in paragraphs "0162" to "0183" of JP2011-252065A, the content of which is incorporated herein by reference. The content of the pigment derivative is preferably 1 to 30 parts by mass and more preferably 3 to 20 parts by mass with respect to 100 parts by mass of the pigment. Among these pigment derivatives, one kind may be used alone, or two or more kinds may be used in combination. In a case where two or more pigment derivatives are used in combination, it is preferable that the total content of the pigment derivatives is within the above-described range.

<Anti-Coloring Agent>

The composition according to the embodiment of the present invention may contain an anti-coloring agent. The anti-coloring agent described in this specification may be used as a polymerization inhibitor. Examples of the anti-coloring agent include a phenol compound, a phosphite compound, and a thioether compound.

Among these, a phenol compound having a molecular weight of 500 or higher, a phosphite compound having a molecular weight of 500 or higher, or a thioether compound having a molecular weight of 500 or higher is more preferable. In addition, as the anti-coloring agent, a phenol compound is preferable, and a phenol compound having a molecular weight of 500 or higher is more preferable.

As the phenol compound, any phenol compound which is known as a phenol anti-coloring agent can be used. As the phenol compound, for example, a hindered phenol compound is preferable. In particular, a compound having a substituent at a position (ortho position) adjacent to a phenolic hydroxy group is preferable. As the substituent, a substituted or unsubstituted alkyl group having 1 to 22 carbon atoms is preferable. In addition, a compound having a phenol group and a phosphite group in the same molecule is also preferable.

As the phenolic hydroxy group-containing compound, in particular, a polysubstituted phenol compound is suitably used. The polysubstituted phenol compound can be classified into three types (a hindered type represented by the following Formula (A), a semi-hindered type represented by the following Formula (B), and a less-hindered type represented by the following Formula (C)) having different substitution sites and different structures in terms of reactivity to a peroxy radical trapped for the stable generation of a phenoxy radical.

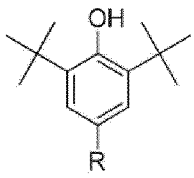
(A)

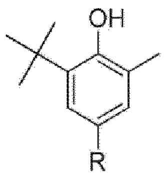
(B)

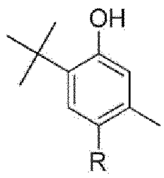
(C)

In Formulae (A) to (C) R represents a hydrogen atom or a substituent. R represents preferably a hydrogen atom, a halogen atom, an amino group which may have a substituent, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and more preferably an amino group which may have a substituent, an alkyl group which may have a substituent, an aryl group which may have a substituent, an alkoxy group which may have a substituent, an aryloxy group which may have a substituent, an alkylamino group which may have a substituent, or an arylamino group which may have a substituent.

A composite anti-coloring agent in which a plurality of structures represented by Formulae (A) to (C) having an anti-coloring function are present in the same molecule is still more preferable. Specifically, a compound in which 2 to 4 structures represented by Formulae (A) to (C) having an anti-coloring function are present in the same molecule is preferable. Among these, the semi-hindered type represented by Formula (B) is more preferable from the viewpoint of colorability. Representative examples of a commercially available product of (A) include SUMILIZER BHT (manufactured by Sumitomo Chemical Co., Ltd.), IRGANOX 1010 and 1222 (manufactured by BASF), and ADEKA STAB AO-20, AO-50, and AO-60 (manufactured by Adeka Corporation). Representative examples of a commercially available product of (B) include SUMILIZER BBM-S (manufactured by Sumitomo Chemical Co., Ltd.), IRGANOX 245 (manufactured by BASF), and ADEKA STAB AO-80 (manufactured by Adeka Corporation). Representative examples of a commercially available product of (C) include ADEKA STAB AO-30 and AO-40 (manufactured by Adeka Corporation).

Examples of the phosphite compound include tris[2-[[2,4,8,10-tetrakis(1,1-dimethylethyl)dibenzo[d,f][1,3,2]dioxaphosphepin-6-yl]oxy]ethyl ]amine,
tris[2-[[4,6,9,11-tetra-tert-butyldibenzo[d,fl[1,3,2]dioxaphosphepin-2-yl]oxy]ethyl]amine, and ethyl bis(2,4-di-tert-butyl-6-methylphenyl)phosphite. Representative examples of a commercially available product of a phosphite compound include ADEKA STAB PEP-36A (manufactured by Adeka Corporation).

Examples of the thioether compound include: dialkyl thiodipropionates such as dilauryl thiodipropionate, dimyristyl thiodipropionate, and distearyl thiodipropionate or pentaerythritol tetra(β-alkylthiopropionic acid) esters; pentaerythrityl tetrakis(3-laurylthiopropionate); and tetrakis[methylene-3-(laurylthio)propionate]methane, bis(methyl-4-[3-n-alkyl(C12/C14)thiopropionyloxoy]5-t-butylphenyl)sulfide, ditridecyl-3,3'-thiodipropionate, dilauryl-3,3'-thiodipropionate, dimyristyl 3,3'-thiodipropionate, distearyl 3,3'-thiodipropionate, lauryl/stearyl thiodipropionate, 4,4'-thiobis(6-t-butyl-metacresol), 2,2'-thiobis(6-t-butyl-paracresol), and distearyl-disulfide. Representative examples of a commercially available product of the thioether compound include ADEKA STAB AO-412S (CAS: 29598-76-3, manufactured by Adeka Corporation), ADEKA STAB AO-503 (CAS: 10595-72-9, manufactured by Adeka Corporation), and KEMINOX PLS (CAS: 29598-76-3, manufactured by Chemipro Kasei Ltd.).

In addition to the above-described representative examples, examples of a commercially available product of the anti-coloring agent include ADEKA STAB AO-50F, ADEKA STAB AO-60G, and ADEKA STAB AO-330 (manufactured by Adeka Corporation).

In addition, examples of the anti-coloring agent which can be used include:

N-oxide compounds such as 5,5-dimethyl-1-pyrroline N-oxide, 4-methylmorpholine N-oxide, pyridine N-oxide, 4-nitropyridine N-oxide, 3-hydroxypyridine N-oxide, picolinic acid N-oxide, nicotinic acid N-oxide, and isonicotinic acid N-oxide;
piperidine-1-oxyl free-radical compounds such as piperidine-1-oxyl free radical, 2,2,6,6-tetramethylpiperidine-1-oxyl free radical, 4-oxo-2,2,6,6-tetramethylpiperidine-1-oxyl free radical, 4-hydroxy-2,2,6,6-tetramethylpiperidine-1-oxyl free radical, 4-acetamide-2,2,6,6-tetramethylpiperidine-1-oxyl free radical, 4-maleimide-2,2,6,6-tetramethylpiperidine-1-oxyl free radical, and 4-phosphonooxy-2,2,6,6-tetramethylpiperidine-1-oxyl free radical;
pyrrolidine 1-oxyl free-radical compounds such as 3-carboxy proxyl free radical and 3-carboxy-2,2,5,5-tetramethylpyrrolidine 1-oxyl free radical;
N-nitrosophenylhydroxyamines such as N-nitrosophenylhydroxyamine cerous salt and N-nitrosophenylhydroxyamine aluminum salt;
diazonium compounds such as 4-diazophenyldimethylamine hydrogensulfate, 4-diazodiphenylamine tetrafluoroborate, and 3-methoxy-4-diazodiphenylamine hexafluorophosphate;

cationic dyes;

nitro group-containing compounds; and

transition metal compounds such as $FeCl_3$ and CuClz. The details can be found in the description of compounds described in paragraphs "0211' to "0223" of JP2015-034961A, the content of which is incorporated herein by reference.

From the viewpoints of colorability and solvent resistance, the content of the anti-coloring agent in the total solid content of the composition is preferably 0.01 to 20 mass%, more preferably 0.1 to 15 mass%, and still more preferably 0.3 to 5 mass%. As the anti-coloring agent, one kind may be used alone, or two or more kinds may be used in combination. In a case where two or more kinds thereof are used in combination, it is preferable that the total content of the two or more kinds thereof is within the above-described range.

«Ultraviolet Absorber»

The composition according to the embodiment of the present invention may contain an ultraviolet absorber. Examples of the ultraviolet absorber, include a conjugated diene compound, an aminobutadiene compound, a methyldibenzoyl compound, a coumarin compound, a salicylate compound, a benzophenone compound, a benzotriazole compound, an acrylonitrile compound, and a hydroxyphenyltriazine compound. The details of the ultraviolet absorber can be found in paragraphs "0052" to "0072" of JP2012-208374A and paragraphs "0317" to "0334" of JP2013-068814A, the contents of which are incorporated herein by reference. Examples of a commercially available product of the conjugated diene compound include UV-503 (manufactured by Daito Chemical Co., Ltd.). In addition, as the benzotriazole compound, MYUA series (manufactured by Miyoshi Oil&Fat Co., Ltd.; The Chemical Daily, February 1, 2016) may be used.

From the viewpoints of a pattern shape and solvent resistance, the content of the ultraviolet absorber in the total solid content of the composition is preferably 0.1 to 10 mass%, more preferably 0.1 to 7 mass%, still more preferably 0.1 to 5 mass%, and still more preferably 0.1 to 3 mass%. As the ultraviolet absorber, one kind may be used alone, or two or more kinds may be used in combination. In a case where two or more kinds thereof are used in combination, it is preferable that the total content of the two or more kinds thereof is within the above-described range.

<<Adhesive>>

The composition according to the embodiment of the present invention may contain an adhesive. As the Adhesive, well-known Adhesives can be used without any particular limitation. Examples of the Adhesive include a silane coupling agent.

In this specification, the silane coupling agent refers to a silane compound having a functional group other than a hydrolyzable group. In addition, the hydrolyzable group refers to a substituent directly linked to a silicon atom and capable of forming a siloxane bond due to at least one of a hydrolysis reaction or a condensation reaction. Examples of the hydrolyzable group include a halogen atom, an alkoxy group, and an acyloxy group.

Among these, an alkoxy group is preferable. That is, it is preferable that the silane coupling agent is a compound having an alkoxysilyl group. Examples of the functional group other than a hydrolyzable group include a vinyl group, a (meth)allyl group, a (meth)acryloyl group, a mercapto group, an epoxy group, an oxetanyl group, an amino group, an ureide group, a sulfide group, an isocyanate group, and a phenyl group. Among these, an amino group, a (meth)acryloyl group, or an epoxy group is preferable. Specific examples of the silane coupling agent include N-β-aminoethyl-γ-aminopropyl methyldimethoxysilane (trade name: KBM-602, manufactured by Shin-Etsu Chemical Co., Ltd.), N-β-aminoethyl-γ-aminopropyl trimethoxysilane (trade name: KBM-603, manufactured by Shin-Etsu Chemical Co., Ltd.), N-β-aminoethyl-γ-aminopropyl triethoxysilane (trade name: KBE-602, manufactured by Shin-Etsu Chemical Co., Ltd.), γ-aminopropyl trimethoxysilane (trade name: KBM-903, manufactured by Shin-Etsu Chemical Co., Ltd.), γ-aminopropyl triethoxysilane (trade name: KBE-903, manufactured by Shin-Etsu Chemical Co., Ltd.), 3-methacryloxypropyl methyldimethoxysilane (trade name: KBM-502, manufactured by Shin-Etsu Chemical Co., Ltd.), and 3-methacryloxypropyl trimethoxysilane (trade name: KBM-503, manufactured by Shin-Etsu Chemical Co., Ltd.). In addition, specific examples of the silane coupling agent include a compound described in paragraphs "0018" to "0036" of JP2009-288703A and a compound described in paragraphs "0056" to "0066" of JP2009-242604A, the contents of which are incorporated herein by reference.

The content of the adhesive in the total solid content of the composition is preferably 0.01 to 10 mass%, more preferably 0.1 to 7 mass%, and still more preferably 1 to 5 mass%. As the Adhesive, one kind may be used alone, or two or more kinds may be used in combination. In a case where two or more kinds thereof are used in combination, it is preferable that the total content of the two or more kinds thereof is within the above-described range.

«Polymerization Inhibitor»

The composition according to the embodiment of the present invention may contain a polymerization inhibitor. Examples of the polymerization inhibitor include hydroquinone, p-methoxyphenol, di-tert-butyl-p-cresol, pyrogallol, tert-butyl catechol, 1,4-benzoquinone, 4,4'-thiobis(3-methyl-6-tert-butylphenol), 2,2'-methylenebis(4-methyl-6-t-butylphenol), and an N-nitrosophenylhydroxylamine salt (an ammonium salt, a cerous salt, or the like). Among these, p-methoxyphenol is preferable. The content of the polymerization inhibitor in the total solid content of the composition is preferably 0.0001 to 5 mass%.

<<Chain Transfer Agent>>

The composition according to the embodiment of the present invention may contain a chain transfer agent. Examples of the chain transfer agent include N,N-dialkylamino benzoic acid alkyl ester and a thiol compound.

Among these, a thiol compound is preferable. As the thiol compound, a compound having 2 or more (preferably 2 to 8 and more preferably 3 to 6) mercapto groups in a molecule is preferable. Specific examples of the thiol compound include: a thiol compound having a heterocycle such as 2-mercaptobenzothiazole, 2-mercaptobenzoxazole, 2-mercaptobenzimidazole, N-phenylmercaptobenzimidazole, or 1,3,5-tris(3-mercaptobutyloxyethyl]-1,3,5-triazine-2,4,6(1H,3H,5H)-trione; and an aliphatic thiol compound such as pentaerythritol tetrakis(3-mercaptobutylate) or 1,4-bis(3-mercaptobutyryloxy)butane. In addition, examples of a commercially available product of the chain transfer agent include PEMP (a thiol compound, manufactured by SC Organic Chemical Co., Ltd.), SANCELER M (a thiol compound, manufactured by Sanshin Chemical Industry Co., Ltd.), and KARENZ MT BD1 (a thiol compound, manufactured by Showa Denko K.K.). In addition, it is also preferable that compounds having the following structures are used.

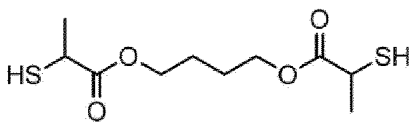

(S-1)

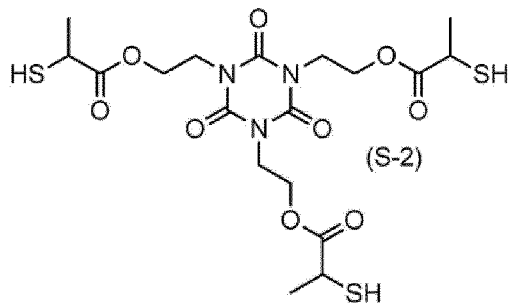

(S-2)

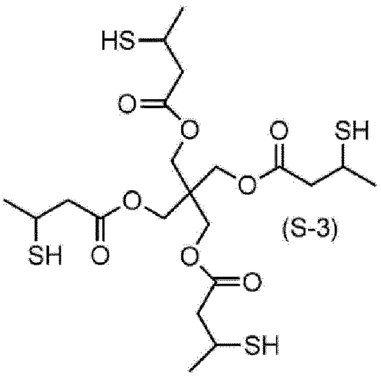

(S-3)

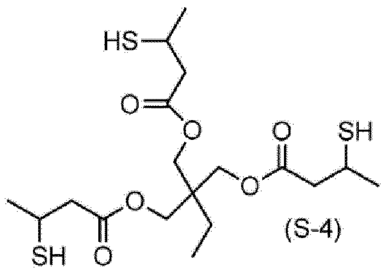

(S-4)

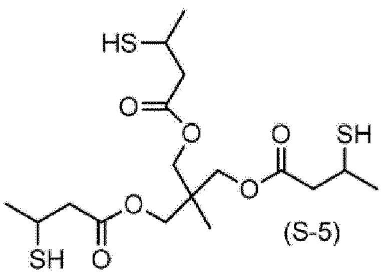

(S-5)

The content of the chain transfer agent in the total solid content of the composition is preferably 0.2 to 5.0 mass% and more preferably 0.4 to 3.0 mass%. In addition, the content of the chain transfer agent is preferably 1 to 40 parts by mass, and more preferably 2 to 20 parts by mass with respect to 100 parts by mass of the polymerizable monomer. As the chain transfer agent, one kind may be used alone, or two or more kinds may be used in combination. In a case where two or more kinds thereof are used in combination, it is preferable that the total content of the two or

more kinds thereof is within the above-described range.

<<Sensitizer>>

The composition according to the embodiment of the present invention may contain a sensitizer in order to improve the radical generation efficiency of the photopolymerization initiator and to increase a photosensitive wavelength. It is preferable that the sensitizer sensitizes the photopolymerization initiator using an electron migration mechanism or an energy-transfer mechanism. Examples of the sensitizer include a compound having an absorption in a wavelength range of 300 to 450 nm. With regard to the sensitizer, the details can be found in the description of paragraphs "0231" to "0253" of JP2010-106268A (corresponding to paragraphs "0256" to "0273" of US2011/0124824A), the content of which is incorporated herein by reference.

The content of the sensitizer in the total solid content of the composition is preferably 0.1 to 20 mass% and more preferably 0.5 to 15 mass%. As the sensitizer, one kind may be used alone, or two or more kinds may be used in combination. In a case where two or more kinds thereof are used in combination, it is preferable that the total content of the two or more kinds thereof is within the above-described range.

<<Co-Sensitizer>>

It is also preferable that the composition according to the embodiment of the present invention further contains a co-sensitizer. The co-sensitizer has a function of further improving sensitivity of the photopolymerization initiator or the sensitizer to radioactive ray, or of suppressing inhibition of polymerization of the polymerizable monomer due to oxygen. With regard to the co-sensitizer, the details can be found in the description of paragraphs "0254" to "0257" of JP2010-106268A (corresponding to paragraphs "0277" to "0279" of US2011/0124824A), the content of which is incorporated herein by reference.

The content of the co-sensitizer in the total solid content of the composition is preferably 0.1 to 30 mass%, more preferably 1 to 25 mass%, and still more preferably 1.5 to 20 mass%. As the co-sensitizer, one kind may be used alone, or two or more kinds may be used in combination. In a case where two or more kinds thereof are used in combination, it is preferable that the total content of the two or more kinds thereof is within the above-described range.

<<Surfactant>>

The composition according to the embodiment of the present invention may contain various surfactants from the viewpoint of further improving suitability for application. As the surfactants, various surfactants such as a fluorine-based surfactant, a nonionic surfactant, a cationic surfactant, an anionic surfactant, or a silicone surfactant can be used.

By the composition according to the embodiment of the present invention containing a fluorine-based surfactant, liquid characteristics (for example, fluidity) of a coating liquid prepared from the coloring composition are further improved, and the uniformity in coating thickness and liquid saving properties can be further improved. That is, in a case where a film is formed of a coating liquid prepared using the composition including a fluorine-based surfactant, the interfacial tension between a coated surface and the coating liquid decreases, the wettability on the coated surface is improved, and the suitability for application on the coated surface is improved. Therefore, a film having a uniform thickness with reduced unevenness in thickness can be formed more suitably.

The fluorine content in the fluorine-based surfactant is preferably 3 to 40 mass%, more preferably 5 to 30 mass%, and still more preferably 7 to 25 mass%. The fluorine-based surfactant in which the fluorine content is in the above-described range is effective from the viewpoints of the uniformity in the thickness of the coating film and liquid saving properties, and the solubility thereof in the composition is also excellent.

Examples of the fluorine-based surfactant include a surfactant described in paragraphs "0060" to "0064" of JP2014-041318A (paragraphs "0060" to "0064" of corresponding WO2014/017669A) and a surfactant described in paragraphs "0117" to "0132" of JP2011-132503A, the contents of which are incorporated herein by reference. Examples of a commercially available product of the fluorine-based surfactant include: MEGAFACE F171, F172, F173, F176, F177, F141, F142, F143, F144, R30, F437, F475, F479, F482, F554, F780, EXP, and MFS-330 (all of which are manufactured by DIC Corporation); FLUORAD FC430, FC431, and FC171 (all of which are manufactured by Sumitomo 3M Ltd.); SURFLON S-382, SC-101, SC-103, SC-104, SC-105, SC-1068, SC-381, SC-383, S-393, and KH-40 (all of which are manufactured by Asahi Glass Co., Ltd.); POLYFOX PF636, PF656, PF6320, PF6520, and PF7002 (all of which are manufactured by OMNOVA Solutions Inc.); and FTERGENT FTX218 (manufactured by NEOS COMPANY LIMITED).

In addition, as the fluorine-based surfactant, an acrylic compound in which, in a case where heat is applied to a molecular structure which has a functional group having a fluorine atom, the functional group having a fluorine atom is cut and a fluorine atom is volatilized can also be suitably used. Examples of such a fluorine-based surfactant include MEGAFACE DS series manufactured by DIC Corporation (The Chemical Daily (February 22, 2016) and Nikkei Business

Daily (February 23, 2016)), for example, MEGAFACE DS-21.

In addition, as the fluorine-based surfactant, a polymer of a fluorine atom-containing vinyl ether compound having a fluorinated alkyl group or a fluorinated alkylene ether group, and a hydrophilic vinyl ether compound can be preferably used. Examples of such a fluorine-based surfactant include fluorine-based surfactants described in JP2016-216602A, the contents of which are incorporated herein by reference.

As the fluorine-based surfactant, a block polymer can also be used. As the fluorine-based surfactant, a fluorine-containing polymer compound can be preferably used, the fluorine-containing polymer compound including: a repeating unit derived from a (meth)acrylate compound having a fluorine atom; and a repeating unit derived from a (meth)acrylate compound having 2 or more (preferably 5 or more) alkyleneoxy groups (preferably an ethyleneoxy group and a propyleneoxy group). In addition, fluorine-containing surfactants described in paragraph "0016" to "0037" of JP2010-032698A, or the following compounds are also exemplified as the fluorine-based surfactant used in the present invention.

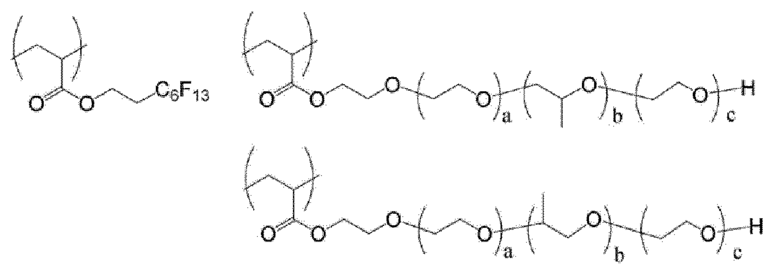

a+c=14
b=17

62% 38%

The weight-average molecular weight of the above-described compound is preferably 3000 to 50000, and is, for example, 14000. In the compound, "%" representing the proportion of a repeating unit is mol%.

In addition, as the fluorine-based surfactant, a fluorine-containing polymer having an ethylenically unsaturated bond-containing group at a side chain can also be used. Specific examples include a compound described in paragraphs "0050" to "0090" and paragraphs "0289" to "0295" of JP2010-164965A, for example, MEGAFACE RS-101, RS-102, RS-718K, and RS-72-K manufactured by DIC Corporation. In addition, as the fluorine-based surfactant, a compound described in paragraphs "0015" to "0158" of JP2015-117327A can also be used.

Examples of the silicone surfactant include: TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, and TORAY SILICONE SH8400 (all of which are manufactured by Dow Toray Co., Ltd.); TSF-4440, TSF-4300, TSF-4445, TSF-4460, and TSF-4452 (all of which are manufactured by Momentive Performance Materials Inc.); KP341, KF6001, and KF6002 (all of which are manufactured by Shin-Etsu Chemical Co., Ltd.); and BYK307, BYK323, and BYK330 (all of which are manufactured by BYK-Chemie Japan K.K.).

The content of the surfactant in the total solid content of the composition is preferably 0.001 to 2.0 mass% and more preferably 0.005 to 1.0 mass%. As the surfactant, one kind may be used alone, or two or more kinds may be used in combination. In a case where two or more kinds thereof are used in combination, it is preferable that the total content of the two or more kinds thereof is within the above-described range.

<<Other Additives>>

Further, a well-known additive such as a plasticizer or a sensitization agent may be added to the composition in order to improve physical properties of the film. Examples of the plasticizer include dioctyl phthalate, didodecyl phthalate, triethylene glycol dicaprylate, dimethyl glycol phthalate, tricresyl phosphate, dioctyl adipate, dibutyl sebacate, and triacetyl glycerin. The content of the plasticizer is preferably 10 mass% or less with respect to the total content of the compound (1), the polymerizable monomer, and the resin.

<Storage container>

A storage container of the composition according to the embodiment of the present invention is not particularly limited, and a well-known storage container can be used. In addition, as the storage container, in order to suppress infiltration of impurities into the raw materials or the composition, a multilayer bottle in which a container interior wall having a six-layer structure is formed of six kinds of resins or a bottle in which a container interior wall having a seven-layer structure is formed of six kinds of resins is preferably used. Examples of the container include a container described in JP2015-123351A. In addition, for the purpose of preventing metal elution from the container interior wall, improving

storage stability of the composition, suppressing the alteration of components, and the like, it is also preferable that the container interior wall is formed of glass, stainless steel, or the like.

<Method of Preparing Composition>

The composition according to the embodiment of the present invention can be prepared by mixing the above-described components with each other. During the preparation of the composition, the respective components may be mixed with each other collectively, or may be mixed with each other sequentially after at least dissolved or dispersed in a solvent. In addition, during mixing, the order of addition or working conditions are not particularly limited.

In addition, it is preferable that a process of dispersing the particles is provided in order to prepare the composition. Examples of a mechanical force used for dispersing the particles in the process of dispersing the particles include compression, squeezing, impact, shearing, and cavitation. Specific examples of the process include a beads mill, a sand mill, a roll mill, a ball mill, a paint shaker, a Microfluidizer, a high-speed impeller, a sand grinder, a project mixer, high-pressure wet atomization, and ultrasonic dispersion. During the pulverization of the particles using a sand mill (beads mill), it is preferable that the process is performed under conditions for increasing the pulverization efficiency, for example, by using beads having a small size and increasing the filling rate of the beads. In addition, it is preferable that rough particles are removed by filtering, centrifugal separation, and the like after pulverization. In addition, as the process and the disperser for dispersing the particles, a process and a disperser described in "Complete Works of Dispersion Technology, Johokiko Co., Ltd., July 15, 2005", "Dispersion Technique focusing on Suspension (Solid/Liquid Dispersion) and Practical Industrial Application, Comprehensive Reference List, Publishing Department of Management Development Center, October 10, 1978", and paragraph "0022" JP2015-157893A can be suitably used. In addition, in the process of dispersing the particles, the particles may be miniaturized in a salt milling step. A material, a device, process conditions, and the like used in the salt milling step can be found in, for example, JP2015-194521A and JP2012-046629A.

During the preparation of the composition, it is preferable that the composition is filtered through a filter, for example, in order to remove foreign matter or to reduce defects. As the filter, any filter which is used in the related art for filtering or the like can be used without any particular limitation. Examples of a material of the filter include: a fluororesin such as polytetrafluoroethylene (PTFE); a polyamide resin such as nylon (for example, nylon-6 or nylon-6,6); and a polyolefin resin (including a polyolefin resin having a high density and an ultrahigh molecular weight) such as polyethylene or polypropylene (PP). Among these materials, polypropylene (including high-density polypropylene) or nylon is preferable.

The pore size of the filter is preferably 0.01 to 10.0 μm, more preferably 0.05 to 3.0 μm, and still more preferably about 0.1 to 2.0 μm. With regard to the pore size value of the filter, reference can be made to a nominal value of filter manufacturers. As the filter, various filters provided by Nihon Pall Corporation (DFA4201NIEY and the like), Advantec Toyo Kaisha., Ltd., Nihon Entegris G.K. (formerly Nippon Microlith Co., Ltd.), Kitz Microfilter Corporation, and the like can be used.

It is preferable that a fibrous filter material is used as the filter. Examples of the fibrous filter material include polypropylene fiber, nylon fiber, and glass fiber. Examples of a commercially available product include SBP type series (SBP008 and the like), TPR type series (TPR002, TPR005, and the like), or SHPX type series (SHPX003 and the like), all manufactured by Roki Techno Co., Ltd.

In a case where a filter is used, a combination of different filters (for example, a first filter and a second filter) may be used. At this time, the filtering using each of the filters may be performed once, or twice or more. In addition, a combination of filters having different pore sizes in the above-described range may be used. In addition, the filtering using the first filter may be performed only on the dispersion liquid, and the filtering using the second filter may be performed on a mixture of the dispersion liquid and other components.

<Film>

A first aspect of the film according to the embodiment of the present invention is a film which is formed of the composition according to the embodiment of the present invention. In the film of the first aspect, the maximum value of the light transmittance of the film in a wavelength range of 400 to 700 nm is preferably 80% or less, more preferably 70% or less, still more preferably 60% or less, and particularly preferably 50% or less. The lower limit of the above-described maximum value of the light transmittance is preferably 1% or more, more preferably 5% or more, and still more preferably 10% or more.

In addition, a second aspect of the film according to the embodiment of the present invention is a film including particles having a refractive index of 2.0 or more and an average primary particle diameter of 200 nm or less, and a film-forming component including at least one selected from a resin or a polymerizable monomer or a cured substance derived from the film-forming component, in which a maximum value of a light transmittance in a wavelength range of 400 to 700 nm is 80% or less, the film-forming component includes two or more kinds of resins, or includes one or more

kinds of resins and one or more kinds of polymerizable monomers, and a phase-separated structure between a first phase including the particles and a second phase with a lower content of the particles than the first phase is formed in the film.

As the particles and the film-forming component included in the film of the second aspect, the materials described in the above-described sections of the composition according to the embodiment of the present invention can be mentioned, and preferred ranges thereof are also the same.

In the film of the second aspect, the above-described phase-separated structure is preferably a sea-island structure or a co-continuous phase structure. By forming these phase-separated structures, light can be effectively scattered between the first phase and the second phase, and particularly excellent light scattering properties can be easily obtained. In the sea-island structure, the second phase may form the sea and the first phase may form the island, or the first phase may form the sea and the second phase may form the island. The case where the first phase forms the sea and the second phase forms the island is preferable from the viewpoint of transmittance. The case where the first phase forms the island and the second phase forms the sea is preferable from the viewpoint of angle dependence.

In the film of the second aspect, the maximum value of the light transmittance of the film in a wavelength range of 400 to 700 nm is preferably 80% or less, more preferably 70% or less, still more preferably 60% or less, and particularly preferably 50% or less. The lower limit of the above-described maximum value of the light transmittance is preferably 1% or more, more preferably 5% or more, and still more preferably 10% or more.

In the film of the first aspect and the second aspect of the present invention (hereinafter, also simply referred to as the film according to the embodiment of the present invention), the maximum value of the light transmittance of the film at 400 to 1000 nm is preferably 80% or less, more preferably 60% or less, and still more preferably 50% or less. The lower limit of the above-described maximum value of the light transmittance is preferably 1% or more, more preferably 5% or more, and still more preferably 10% or more.

The haze of the film according to the embodiment of the present invention based on JIS K 7136 is preferably 30% to 100%. The upper limit is preferably 99% or less, more preferably 95% or less, and still more preferably 90% or less. The lower limit is preferably 35% or more, more preferably 40% or more, and still more preferably 50% or more. The haze of the film is a value measured according to the method in Examples described later.

The value of L* of the film according to the embodiment of the present invention in the L*a*b* color system of CIE 1976 is preferably 35 to 100. The value of L* is preferably 40 or higher, more preferably 50 or higher, and still more preferably 60 or higher. According to this aspect, a film having excellent whiteness can be formed. In addition, the value of L* is preferably 95 or lower, more preferably 90 or lower, and still more preferably 85 or lower. According to this aspect, a film having appropriate visible transparency can be formed.

In addition, the value of a* is preferably -15 or higher, more preferably -10 or higher, and still more preferably -5 or higher. In addition, the value of a* is preferably 10 or lower, more preferably 5 or lower, and still more preferably 0 or lower. According to this aspect, a film having excellent whiteness can be formed.

In addition, the value of b* is preferably -35 or higher, more preferably -30 or higher, and still more preferably -25 or higher. In addition, the value of b* is preferably 20 or lower, more preferably 10 or lower, and still more preferably 0 or lower. According to this aspect, a film having excellent whiteness can be formed.

The thickness of the film according to the embodiment of the present invention is preferably 2 to 40 μm. The upper limit of the film thickness is preferably 30 μm or less, more preferably 20 μm or less, and still more preferably 15 μm or less. The lower limit of the film thickness is preferably 3 μm or more, more preferably 4 μm or more, and still more preferably 5 μm or more. In a case where the film thickness is within the above-described range, an effect of improving a device optical sensitivity by reducing the thickness of a sensor and suppressing crosstalk can be expected.

The film according to the embodiment of the present invention can be suitably used for a scattering layer for a light emitting element, a scattering layer for a display element, and the like.

<Method of Forming Film>

The film according to the embodiment of the present invention can be formed through a step of applying the composition according to the embodiment of the present invention to a support. Examples of the support include a substrate formed of a material such as silicon, non-alkali glass, soda glass, PYREX (registered trade name) glass, or quartz glass. For example, an organic film or an inorganic film may be formed on the substrate. Examples of a material of the organic film include a resin. In addition, as the support, a substrate formed of the resin can also be used. In addition, a charge coupled device (CCD), a complementary metal-oxide semiconductor (CMOS), a transparent conductive film, or the like may be formed on the support. In addition, a black matrix that separates pixels from each other may be formed on the support. In addition, optionally, an undercoat layer may be provided on the support to improve adhesiveness with a layer above the support, to prevent diffusion of materials, or to make a surface of the substrate flat. In addition, in a case where a glass substrate is used as the support, it is preferable that an inorganic film is formed on the glass substrate or the glass substrate may be dealkalized to be used.

As a method of applying the composition to the support, a well-known method can be used. Examples of the well-known method include: a drop casting method; a slit coating method; a spray coating method; a roll coating method; a spin coating method; a cast coating method; a slit and spin method; a pre-wetting method (for example, a method described in JP2009-145395A); various printing methods including jet printing such as an ink jet method (for example, an on-demand method, a piezoelectric method, or a thermal method) or a nozzle jet method, flexographic printing, screen printing, gravure printing, reverse offset printing, and metal mask printing; a transfer method using a mold or the like; and a nanoimprinting method. The application method using an ink jet method is not particularly limited, and examples thereof include a method (in particular, pp. 115 to 133) described in "Extension of Use of Ink Jet - Infinite Possibilities in Patent-" (February, 2005, S.B. Research Co., Ltd.) and methods described in JP2003-262716A, JP2003-185831A, JP2003-261827A, JP2012-126830A, and JP2006-169325A. From the viewpoint of suitability for application, the application using a spin coating method is preferably spin coating at 300 to 6000 rpm and more preferably spin coating at 400 to 3000 rpm. In addition, the temperature of the support during spin coating is preferably 10°C to 100°C and more preferably 20°C to 70°C. In a case where the temperature of the support is in the above-described range, a film having excellent application uniformity is likely to be formed. In a case where the drop casting method is used, it is preferable that a drop range of the composition in which a photoresist is used as a partition wall is formed on the support such that a film having a predetermined uniform thickness can be obtained. A desired thickness can be obtained by controlling the drop amount and concentration of solid contents of the composition and the area of the drop range.

The composition layer formed on the support may be dried (pre-baked). For example, it is preferable that the film is dried under pre-baking conditions of a temperature of 60°C to 150°C and 30 seconds to 15 minutes.

The method of forming the film according to the embodiment of the present invention may further include a step of forming a pattern. Examples of a pattern forming method include a pattern forming method using a photolithography method and a pattern forming method using a dry etching method. In a case where the film according to the embodiment of the present invention is used as a flat film, the step of forming a pattern is not necessarily performed. Hereinafter, the step of forming a pattern will be described in detail.

(Case where Pattern is Formed using Photolithography Method)

It is preferable that the pattern forming method using a photolithography method includes: a step (exposure step) of exposing the composition layer, which is formed by applying the composition according to the embodiment of the present invention, in a patterned manner; and a step (development step) of forming a pattern by removing a non-exposed portion of the composition layer for development. Optionally, the pattern forming method may further include a step (post-baking step) of baking the developed pattern. Hereinafter, the respective steps will be described.

<<Exposure Step>>

In the exposure step, the composition layer is exposed in a patterned manner. For example, the composition layer can be exposed in a pattern shape using an exposure device such as a stepper through a mask having a predetermined mask pattern. As a result, an exposed portion can be cured. Examples of the radiation (light) which can be used during the exposure include g-rays and i-rays. In addition, light (preferably light having a wavelength of 180 to 300 nm) having a wavelength of 300 nm or less can also be used. Examples of the light having a wavelength of 300 nm or less include KrF-rays (wavelength: 248 nm) and ArF-rays (wavelength: 193 nm), and KrF-rays (wavelength: 248 nm) are preferable.

In addition, during the exposure, light may be continuously radiated for the exposure, or may be radiated in the form of a pulse for the exposure (pulse exposure). The pulse exposure refers to an exposing method in which light irradiation and resting are repeatedly performed in a short cycle (for example, millisecond-level or less). In a case of the pulse exposure, the pulse width is preferably 100 nanoseconds (ns) or less, more preferably 50 nanoseconds or less, and still more preferably 30 nanoseconds or less. The lower limit of the pulse width is not particularly limited, and may be 1 femtosecond (fs) or more or 10 femtoseconds or more. The frequency is preferably 1 kHz or more, more preferably 2 kHz or more, and still more preferably 4 kHz or more. The upper limit of the frequency is preferably 50 kHz or less, more preferably 20 kHz or less, and still more preferably 10 kHz or less. The maximum instantaneous illuminance is preferably 50000000 $W/m^2$ or more, more preferably 100000000 $W/m^2$ or more, and still more preferably 200000000 $W/m^2$ or more. In addition, the upper limit of the maximum instantaneous illuminance is preferably 1000000000 $W/m^2$ or less, more preferably 800000000 $W/m^2$ or less, and still more preferably 500000000 $W/m^2$ or less. The pulse width refers to a time during which light is irradiated in a pulse period. The frequency is the number of pulse periods per second. The maximum instantaneous illuminance is average illuminance within the time during which light is radiated in the pulse period. The pulse period is a period in which irradiation with light and resting are one cycle in the pulse exposure.

In addition, for example, the irradiation amount (exposure amount) is preferably 0.03 to 2.5 $J/cm^2$, more preferably 0.05 to 1.0 $J/cm^2$, and most preferably 0.08 to 0.5 $J/cm^2$. The oxygen concentration in a case of the exposure

can be appropriately selected. For example, the exposure may be performed in air, in a low-oxygen atmosphere having an oxygen concentration of 19 vol% or less (for example, 15 vol%, 5 vol%, or substantially oxygen-free), or in a high-oxygen atmosphere having an oxygen concentration of more than 21 vol% (for example, 22 vol%, 30 vol%, or 50 vol%). In addition, the exposure illuminance can be appropriately set, and is preferably selected in a range of 1000 to 100000 $W/m^2$. Conditions of the oxygen concentration and conditions of the exposure illuminance may be appropriately combined. For example, conditions are oxygen concentration: 10 vol% and illuminance: 10000 $W/m^2$, or oxygen concentration: 35 vol% and illuminance: 20000 $W/m^2$.

«Development step»

Next, a pattern is formed by removing a non-exposed portion of the exposed composition layer by development. The non-exposed portion of the composition layer can be removed by development using a developer. As a result, a non-exposed portion of the composition layer in the exposure step is eluted into the developer, and only the photocured portion remains on the support. For example, the temperature of the developer is preferably 20°C to 30°C. The development time is preferably 20 to 180 seconds. In addition, in order to further improve residues removing properties, a step of shaking the developer off per 60 seconds and supplying a new developer may be repeated multiple times.

Examples of the developer include an organic solvent and an alkali developer, and an alkali developer is preferably used. As the alkali developer, an alkaline aqueous solution (alkali developer) in which an alkaline agent is diluted with pure water is preferable. Examples of the alkaline agent include: organic alkaline compounds such as ammonia, ethylamine, diethylamine, dimethylethanolamine, diglycolamine, diethanolamine, hydroxyamine, ethylenediamine, tetramethylammonium hydroxide, tetraethylammonium hydroxide, tetrapropylammonium hydroxide, tetrabutylammonium hydroxide, ethyltrimethylammonium hydroxide, benzyltrimethylammonium hydroxide, dimethyl bis(2-hydroxyethyl)ammonium hydroxide, choline, pyrrole, piperidine, and 1,8-diazabicyclo[5.4.0]-7-undecene; and inorganic alkaline compounds such as sodium hydroxide, potassium hydroxide, sodium carbonate, sodium hydrogen carbonate, sodium silicate, and sodium metasilicate. In consideration of environmental aspects and safety aspects, the alkaline agent is preferably a compound having a high molecular weight. A concentration of the alkaline agent in the alkaline aqueous solution is preferably 0.001 to 10 mass% and more preferably 0.01 to 1 mass%. In addition, the developer may further contain a surfactant. Examples of the surfactant include the surfactants described above. Among these, a nonionic surfactant is preferable. From the viewpoint of easiness of transport, storage, and the like, the developer may be obtained by temporarily preparing a concentrated solution and diluting the concentrated solution to a necessary concentration during use. The dilution factor is not particularly limited and, for example, can be set to be in a range of 1.5 to 100 times. In a case where the alkaline aqueous solution is used as a developer, it is preferable that the layer is washed (rinsed) with pure water after development. In addition, it is preferable that the rinsing is performed by supplying a rinsing liquid to the composition layer after development while rotating the support on which the composition layer after development is formed. In addition, it is preferable that the rinsing is performed by moving a nozzle discharging the rinsing liquid from a center of the support to a peripheral edge of the support. In this case, in the movement of the nozzle from the center of the support to the peripheral edge of the support, the nozzle may be moved while gradually decreasing the moving speed of the nozzle. By performing rinsing in this manner, in-plane variation of rinsing can be suppressed. In addition, the same effect can be obtained by gradually decreasing the rotating speed of the support while moving the nozzle from the center of the support to the peripheral edge of the support.

After the development, it is preferable to perform an additional exposure treatment or a heating treatment (post-baking) after carrying out drying. The additional exposure treatment or the post-baking is a curing treatment after development in order to complete curing. The heating temperature in the post-baking is preferably, for example, 100°C to 260°C. The lower limit of the heating temperature is preferably 120°C or higher and more preferably 160°C or higher. The upper limit of the heating temperature is preferably 240°C or lower and more preferably 220°C or lower. The film after development is post-baked continuously or batchwise using a heating unit such as a hot plate, a convection oven (hot air circulation dryer), and a high-frequency heater under the above-described conditions. In a case of performing the additional exposure treatment, light used for the exposure is preferably light having a wavelength of 400 nm or less. In addition, the additional exposure treatment may be carried out by the method described in KR10-2017-0122130A.

(Case where Pattern is Formed using Dry Etching Method)

The formation of a pattern using a dry etching method can be performed using a method including: applying the composition according to the embodiment of the present invention to a support to form a composition layer; curing the composition layer to form a cured composition layer; forming a patterned resist layer on the cured composition layer; and dry-etching the cured composition layer with etching gas by using the patterned resist layer as a mask. The details of the pattern formation using the dry etching method can be found in paragraphs "0010" to "0067" of JP2013-064993A, the content of which is incorporated herein by reference.

<Optical Sensor>

An optical sensor according to the embodiment of the present invention includes the film according to the embodiment of the present invention. Examples of the type of the optical sensor include an ambient light sensor and an illuminance sensor, and the optical sensor is preferably used as an ambient light sensor. The ambient light sensor is a sensor which detects hue of ambient light.

It is also preferable that the optical sensor according to the embodiment of the present invention has an optical filter having at least one pixel selected from a colored pixel or a pixel of an infrared transmitting filter, in addition to the film according to the embodiment of the present invention. Examples of the colored pixel include a red pixel, a blue pixel, a green pixel, a yellow pixel, a cyan pixel, and a magenta pixel. In addition, it is preferable that the film according to the embodiment of the present invention is provided closer to a light incident side than the above-described optical filter. By providing the film according to the embodiment of the present invention closer to the light incident side than the optical filter, angle dependence can be further reduced for each pixel.

An embodiment of the optical sensor is shown with reference to the drawings. An optical sensor 1 shown in Fig. 1 is provided with an optical filter 110 having pixels 111 to 114 on a photoelectric conversion element 101. A film 121 according to the embodiment of the present invention is formed on the optical filter 110. As an example of the pixels 111 to 114 constituting the optical filter 110, a combination in which the pixel 111 is a red pixel, the pixel 112 is a blue pixel, the pixel 113 is a green pixel, and the pixel 114 is a pixel of an infrared transmitting filter can be mentioned. In the optical sensor 1 shown in Fig. 1, the optical filter 110 having four types of pixels (pixels 111 to 114) is used, but the types of pixels may be one to three types or may be five or more types. The types can be appropriately selected according to the application. In addition, a planarizing layer may be interposed between the photoelectric conversion element 101 and the optical filter 110, or between the optical filter 110 and the film 121 according to the embodiment of the present invention.

Fig. 2 shows another embodiment of the optical sensor. An optical sensor 2 shown in Fig. 2 is provided with an optical filter 110 having pixels 111 to 114 on a photoelectric conversion element 101. The optical filter 110 has the same configuration as that of the above-described embodiment. A member in which a film 122 according to the embodiment of the present invention is formed on a surface of a transparent support 130 is disposed on the optical filter 110. Examples of the transparent support 130 include a glass substrate and a resin substrate. In the optical sensor 2 shown in Fig. 2, the member in which the film 122 according to the embodiment of the present invention is formed on the surface of the transparent support 130 is disposed on the optical filter 110 at predetermined intervals, but the optical filter 110 and the member in which the film 122 according to the embodiment of the present invention is formed on the surface of the transparent support 130 may be in contact with each other. In addition, in the optical sensor 2 shown in Fig. 2, the film 122 according to the embodiment of the present invention is formed on only one surface of the transparent support 130, but the film 122 according to the embodiment of the present invention may be formed on both surfaces of the transparent support 130. In addition, in the optical sensor 2 shown in Fig. 2, the film 122 according to the embodiment of the present invention is formed on the surface of the transparent support 130 on the optical filter 110 side, but the film 122 according to the embodiment of the present invention may be formed on the surface of the transparent support 130 opposite to the optical filter 110 side. In addition, a planarizing layer may be interposed between the photoelectric conversion element 101 and the optical filter 110, or between the film 122 according to the embodiment of the present invention and the transparent support 130.

Examples

Hereinafter, the present invention will be described in more detail using Examples, but the present invention is not limited to these examples. Unless specified otherwise, "part(s)" and "%" represent "part(s) by mass" and "mass%".

<Measurement of average primary particle diameter of particles>

The primary particle diameter of the particles was obtained by observing particles with a transmission electron microscope (TEM) and observing a portion (primary particle) where the particles did not aggregate. Specifically, a particle size distribution was obtained by photographing a transmission electron micrograph of primary particles using a transmission microscope and measuring a particle size distribution with an image processing device using the micrograph. The average primary particle diameter of the particles refers to the number average particle size calculated from the particle size distribution. An electron microscope (H-7000, manufactured by Hitachi, Ltd.) was used as the transmission electron microscope, and a LUZEX AP (manufactured by Nireco Corporation) was used as the image processing device.

<Measurement of refractive index of particles>

A dispersion liquid was prepared using the particles, a resin (dispersant) having a known refractive index, and propylene glycol monomethyl ether acetate. Next, the prepared dispersion liquid and a resin having a known refractive index were mixed with each other to prepare coating liquids in which the concentrations of the particles in the total solid content of the coating liquids was 10 mass%, 20 mass%, 30 mass%, and 40 mass%. Using each of the coating liquids, a film having a thickness of 300 nm was formed on a silicon wafer, and the refractive index of the obtained film was measured by ellipsometry (LAMBDA ACE RE-3300, manufactured by SCREEN Holdings Co., Ltd.). Next, the concentration and refractive index of the particles were plotted on a graph to calculate the refractive index of the particles.

<Measurement of specific gravity of particles>

50 g of particles were put into a 100 mL volumetric flask. Subsequently, 100 mL of water was weighed using another 100 mL graduated cylinder. Thereafter, the weighed water was put into the volumetric flask to the extent that the particles were immersed, and then ultrasonic waves were applied to the volumetric flask to allow the particles and water to blend in. Next, additional water was added thereto until the marked line of the volumetric flask was reached, and the specific gravity was calculated as 50 g/(volume of water remaining in volumetric flask).

<Measurement of Weight-Average Molecular Weight>

The weight-average molecular weights of the dispersant and the resin were measured by gel permeation chromatography (GPC) using the following conditions.

Type of column: a column in which TOSOH TSK gel Super HZM-H, TOSOH TSK gel Super HZ4000, and TOSOH TSK gel Super HZ2000 were linked to each other
Developing solvent: tetrahydrofuran
Column temperature: 40°C
Flow rate (sample injection volume): 1.0 mL (sample concentration: 0.1 mass%)
Device name: HLC-8220 GPC (manufactured by Tosoh Corporation)
Detector: refractive index (RI) detector
Calibration curve base resin: a polystyrene resin

<Polymerizable group value>

The polymerizable group value of the resin was calculated from raw materials used for synthesis of the resin.

<Method of Measuring Acid Value>

The acid value indicates the mass of potassium hydroxide required to neutralize an acidic component per 1 g of solid content. A measurement sample was dissolved in a mixed solvent including tetrahydrofuran and water at a ratio (tetrahydrofuran/water) of 9/1, and the obtained solution was neutralized and titrated with a 0.1 mol/L sodium hydroxide aqueous solution at 25°C using a potentiometric titrator (trade name: AT-510, manufactured by Kyoto Electronics Manufacturing Co., Ltd.). An inflection point of a titration pH curve was set as a titration end point, and the acid value was calculated from the following expression.

$$A=56.11 \times Vs \times 0.5 \times f/w$$

A: acid value (mgKOH/g)
Vs: amount (mL) of the 0.1 mol/L sodium hydroxide aqueous solution used for the titration
f: titer of the 0.1 mol/L sodium hydroxide aqueous solution
w: mass (g) of the measurement sample (expressed in terms of solid contents)

<Production of dispersion liquid>

By using ULTRA APEX MILL (manufactured by Kotobuki Industries Co., Ltd.) as a circulation type dispersion apparatus (beads mill), a mixed solution having the following composition shown in the following table was dispersed. In this way, a dispersion liquid was produced.

Bead diameter: 0.2 mm
Bead filling rate: 65 vol%
Circumferential speed: 6 m/sec
Pump supply rate: 10.8 kg/hr
Cooling water: tap water
Inner volume of circular path of beads mill: 0.15 L
Amount of mixed Solution to be dispersed: 0.65 kg

[Table 1]

| | Particles | | Resin | | Solvent | |
|---|---|---|---|---|---|---|
| | Type | Parts by mass | Type | Parts by mass | Type | Parts by mass |
| Dispersion liquid 1 | P-1 | 35 | B-1 | 14 | S-1 | 51 |
| Dispersion liquid 2 | P-2 | 35 | B-1 | 14 | S-1 | 51 |
| Dispersion liquid 3 | P-3 | 35 | B-1 | 14 | S-1 | 51 |
| Dispersion liquid 4 | P-4 | 35 | B-1 | 14 | S-1 | 51 |
| Dispersion liquid 5 | P-5 | 35 | B-1 | 14 | S-1 | 51 |
| Dispersion liquid 6 | P-1 | 45 | B-1 | 18 | S-1 | 37 |
| Dispersion liquid 7 | P-1 | 25 | B-1 | 10 | S-1 | 65 |
| Dispersion liquid 8 | P-1<br>P-2 | 17.5<br>17.5 | B-1 | 14 | S-1 | 51 |
| Dispersion liquid 9 | P-1 | 35 | B-2 | 14 | S-1 | 51 |
| Dispersion liquid 10 | P-1 | 35 | B-1 | 10.5 | S-1 | 54.5 |
| Dispersion liquid 11 | P-1 | 35 | B-1 | 21 | S-1 | 44 |
| Dispersion liquid 12 | P-1 | 35 | B-1 | 14 | S-1<br>S-2 | 25.5<br>25.5 |
| Dispersion liquid 13 | P-1 | 35 | B-1 | 14 | S-3 | 51 |
| Dispersion liquid 14 | P-1 | 35 | B-5 | 14 | S-1 | 51 |
| Dispersion liquid 15 | P-6 | 35 | B-1 | 14 | S-1 | 51 |
| Dispersion liquid 16 | P-7 | 35 | B-1 | 14 | S-1 | 51 |

The raw materials shown above in the table are as follows.

(Particles)

[Table 2]

| Type | Name (manufacturer) | Type | Specific gravity ($g/cm^3$) | Refractive index | Average primary particle diameter (nm) |
|---|---|---|---|---|---|
| P-1 | MPT-141 (manufactured by Ishihara Sangyo Kaisha Ltd.) | Titanium oxide particles | 4.1 | 2.71 | 91 |
| P-2 | MPT-136 (manufactured by Ishihara Sangyo Kaisha Ltd.) | Titanium oxide particles | 4.1 | 2.71 | 80 |
| P-3 | TTO-80A (manufactured by Ishihara Sangyo Kaisha Ltd.) | Titanium oxide particles | 4.1 | 2.71 | 60 |

(continued)

| Type | Name (manufacturer) | Type | Specific gravity ($g/cm^3$) | Refractive index | Average primary particle diameter (nm) |
|---|---|---|---|---|---|
| P-4 | TTO-51 (manufactured by Ishihara Sangyo Kaisha Ltd.) | Titanium oxide particles | 4.1 | 2.71 | 20 |
| P-5 | Zirconeo-Cp (manufactured by ITEC Co., Ltd.) | Zirconium oxide particles | 5.7 | 2.11 | 10 |
| P-6 | CR-90-2 (manufactured by Ishihara Sangyo Kaisha Ltd.) | Titanium oxide particles | 4.1 | 2.71 | 250 |
| P-7 | Aluminum oxide nanoparticles (manufactured by EM Japan) | Aluminum oxide particles | 4.0 | 1.77 | 80 |

The value of the refractive index in the above tables is a refractive index for light having a wavelength of 589 nm.

(Resin (dispersant))

B-1: resin having the following structure (resin having a structure in which a substituent and a polymer chain including a poly(meth)acrylic structural repeating unit are bonded to a hexavalent linking group (group Z); weight-average molecular weight: 10000, acid value: 80.4 mgKOH/g, polymerizable group value: 0 mmol/g)

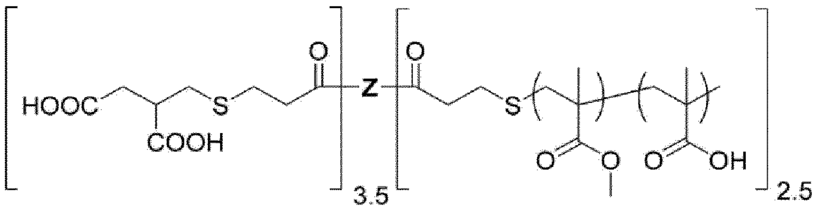

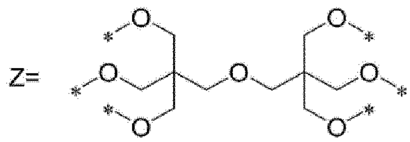

B-2: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 34000, acid value: 57.2 mgKOH/g, polymerizable group value: 0 mmol/g)

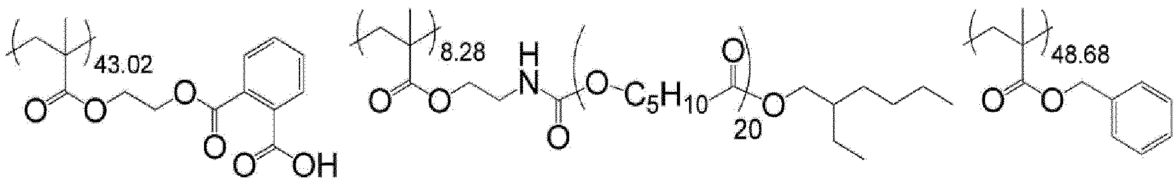

B-5: resin having the following structure (resin having a structure in which a substituent and a polymer chain including a poly(meth)acrylic structural repeating unit are bonded to a hexavalent linking group (group Z); weight-average molecular weight: 6000, acid value: 31 mgKOH/g, polymerizable group value: 1 mmol/g)

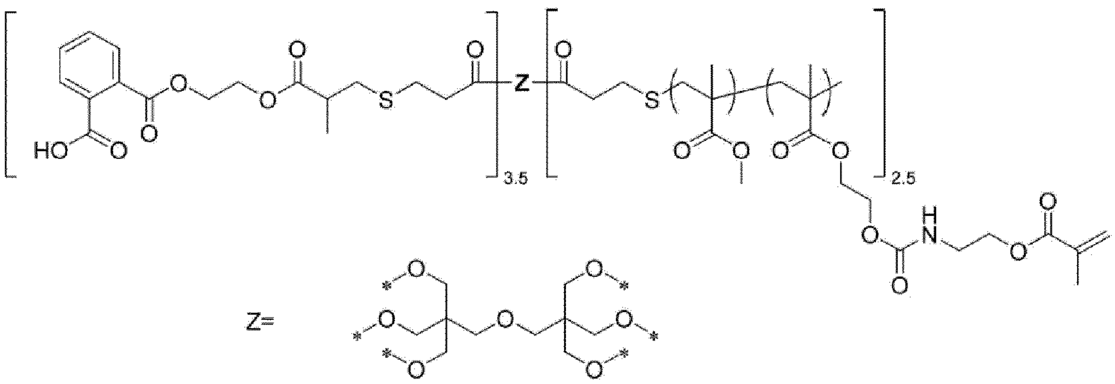

(Solvent)

S-1: propylene glycol monomethyl ether acetate (PGMEA)
S-2: propylene glycol monomethyl ether (PGME)
S-3: cyclohexanone

<Preparation of Composition>

Raw materials shown in the following tables were mixed with each other to prepare a composition.

[Table 3]

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 1 | Dispersion liquid 1 | 45 | M-1 | 9.4 | B-2 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 2 | Dispersion liquid 2 | 45 | M-1 | 9.4 | B-2 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 3 | Dispersion liquid 3 | 45 | M-1 | 9.4 | B-2 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 4 | Dispersion liquid 4 | 45 | M-1 | 9.4 | B-2 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 5 | Dispersion liquid 5 | 45 | M-1 | 9.4 | B-2 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 6 | Dispersion liquid 6 | 35 | M-1 | 9.4 | B-2 | 9.4 | 1-1 | 2.25 | A-1 | 0.45 | Su-1 | 0.0005 | In-1 | 0.045 | S-1 | 42.1 |
| | | | | | | | | | A-3 | 1.35 | | | | | | |
| | | | | | | | | | | | | | | | | |

(continued)

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 7 | Dispersion liquid 7 | 63 | M-1 | 9.4 | B-2 | 9.4 | 1-1 | 2.25 | A-1 | 0.45 | Su-1 | 0.0005 | In-1 | 0.045 | S-1 | 14.1 |
| | | | | | | | | | A-3 | 1.35 | | | | | | |
| | | | | | | | | | | | | | | | | |
| Example 8 | Dispersion liquid 8 | 45 | M-1 | 9.4 | B-2 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 9 | Dispersion liquid 9 | 45 | M-1 | 9.4 | B-1 | 9.4 | 1-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 10 | Dispersion liquid 10 | 45 | M-1 | 9.4 | B-2 | 11 | 1-1 | 2.25 | A-1 | 0.45 | Su-1 | 0.0005 | In-1 | 0.045 | S-1 | 30.5 |
| | | | | | | | | | A-3 | 1.35 | | | | | | |
| | | | | | | | | | | | | | | | | |
| Example 11 | Dispersion liquid 11 | 45 | M-1 | 9.4 | B-2 | 6.3 | 1-1 | 2.25 | A-1 | 0.45 | Su-1 | 0.0005 | In-1 | 0.045 | S-1 | 35.2 |
| | | | | | | | | | A-3 | 1.35 | | | | | | |
| | | | | | | | | | | | | | | | | |
| Example 12 | Dispersion liquid 12 | 45 | M-1 | 9.4 | B-2 | 6.3 | 1-1 | 2.25 | A-1 | 0.45 | Su-1 | 0.0005 | In-1 | 0.045 | S-1 | 35.2 |
| | | | | | | | | | A-3 | 1.35 | | | | | | |
| | | | | | | | | | | | | | | | | |

[Table 4]

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 13 | Dispersion liquid 13 | 45 | M-1 | 9.4 | B-2 | 6.3 | I-1 | 2.25 | A-1 | 0.45 | Su-1 | 0.0005 | In-1 | 0.045 | S-1 | 35.2 |
| | | | | | | | | | A-3 | 1.35 | | | | | | |
| | | | | | | | | | | | | | | | | |
| Example 14 | Dispersion liquid 14 | 45 | M-1 | 9.4 | B-2 | 6.3 | I-1 | 2.25 | A-1 | 0.45 | Su-1 | 0.0005 | In-1 | 0.045 | S-1 | 35.2 |
| | | | | | | | | | A-3 | 1.35 | | | | | | |
| | | | | | | | | | | | | | | | | |
| Example 15 | Dispersion liquid 1 | 55 | M-1 | 11.5 | B-2 | 11.5 | I-1 | 2.75 | A-1 | 0.55 | Su-1 | 0.0005 | In-1 | 0.055 | S-1 | 17 |
| | | | | | | | | | A-3 | 1.65 | | | | | | |
| | | | | | | | | | | | | | | | | |
| Example 16 | Dispersion liquid 1 | 30 | M-1 | 6.3 | B-2 | 6.3 | I-1 | 1.5 | A-1 | 0.3 | Su-1 | 0.0005 | In-1 | 0.03 | S-1 | 54.7 |
| | | | | | | | | | A-3 | 0.9 | | | | | | |
| | | | | | | | | | | | | | | | | |
| Example 17 | Dispersion liquid 1 | 58 | M-1 | 7.7 | B-2 | 4.8 | I-1 | 2.25 | A-1 | 0.45 | Su-1 | 0.0005 | In-1 | 0.045 | S-1 | 25.5 |
| | | | | | | | | | A-3 | 1.35 | | | | | | |
| | | | | | | | | | | | | | | | | |
| Example 18 | Dispersion liquid 1 | 32 | M-1 | 11.1 | B-2 | 14 | I-1 | 2.25 | A-1 | 0.45 | Su-1 | 0.0005 | In-1 | 0.045 | S-1 | 38.7 |
| | | | | | | | | | A-3 | 1.35 | | | | | | |
| | | | | | | | | | | | | | | | | |

(continued)

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 19 | Dispersion liquid 1 | 22.5 | M-1 | 9.4 | B-2 | 9.4 | I-1 | 2.25 | A-1 | 0.45 | Su-1 | 0.0005 | In-1 | 0.045 | S-1 | 32.1 |
| | Dispersion liquid 2 | 22.5 | | | | | | | A-3 | 1.35 | | | | | | |
| | | | | | | | | | | | | | | | | |
| Example 20 | Dispersion liquid 1 | 45 | M-2 | 9.4 | B-2 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 21 | Dispersion liquid 1 | 45 | M-3 | 9.4 | B-2 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 22 | Dispersion liquid 1 | 45 | M-1 | 4.7 | B-2 | 9.4 | I-1 | 2.25 | A-1 | 0.45 | Su-1 | 0.0005 | In-1 | 0.045 | S-1 | 32.1 |
| | | | M-2 | 4.7 | | | | | A-3 | 1.35 | | | | | | |
| | | | | | | | | | | | | | | | | |
| Example 23 | Dispersion liquid 1 | 45 | M-1 | 9.4 | B-3 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |

(continued)

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 24 | Dispersion liquid 1 | 45 | M-1 | 9.4 | B-4 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |

[Table 5]

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 25 | Dispersion liquid 1 | 45 | M-1 | 9.4 | B-3 | 1.6 | I-1 | 2.25 | A-1 | 0.45 | Su-1 | 0.0005 | In-1 | 0.045 | S-1 | 38.3 |
| | | | | | B-4 | 1.6 | | | A-3 | 1.35 | | | | | | |
| | | | | | | | | | | | | | | | | |
| Example 26 | Dispersion liquid 1 | 45 | M-1 | 9.4 | B-2 | 9.4 | I-2 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 27 | Dispersion liquid 1 | 45 | M-1 | 9.4 | B-2 | 9.4 | I-3 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 28 | Dispersion liquid 1 | 45 | M-1 | 9.4 | B-2 | 9.4 | I-1 | 1.125 | A-1 | 0.45 | Su-1 | 0.0005 | In-1 | 0.045 | S-1 | 32.1 |
| | | | | | | | I-3 | 1.125 | A-3 | 1.35 | | | | | | |
| | | | | | | | | | | | | | | | | |
| Example 29 | Dispersion liquid 1 | 45 | M-1 | 9.4 | B-2 | 9.4 | I-1 | 2.25 | A-2 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 30 | Dispersion liquid 1 | 45 | M-1 | 9.9 | B-2 | 10.3 | I-1 | 2.25 | A-1 | 0.45 | Su-1 | 0.0005 | In-1 | 0.045 | S-1 | 32.1 |
| | | | | | | | | | | | | | | | | |
| | | | | | | | | | | | | | | | | |

(continued)

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 31 | Dispersion liquid 1 | 45 | M-1 | 9.4 | B-2 | 9.4 | I-1 | 2.25 | A-1 | 0.45 | Su-2 | 0.0005 | In-1 | 0.045 | S-1 | 32.1 |
| | | | | | | | | | A-3 | 1.35 | | | | | | |
| | | | | | | | | | | | | | | | | |
| Example 32 | Dispersion liquid 1 | 45 | M-1 | 9.4 | B-2 | 9.4 | I-1 | 2.25 | A-1 | 0.45 | Su-1 | 0.00025 | In-1 | 0.045 | S-1 | 32.1 |
| | | | | | | | | | A-3 | 1.35 | Su-2 | 0.00025 | | | | |
| | | | | | | | | | | | | | | | | |
| Example 33 | Dispersion liquid 1 | 45 | M-1 | 9.4 | B-2 | 9.4 | I-1 | 2.25 | A-1 | 0.45 | Su-1 | 0.0005 | In-2 | 0.045 | S-1 | 32.1 |
| | | | | | | | | | A-3 | 1.35 | | | | | | |
| | | | | | | | | | | | | | | | | |
| Example 34 | Dispersion liquid 1 | 45 | M-1 | 9.4 | B-2 | 9.4 | I-1 | 2.25 | A-1 | 0.45 | Su-1 | 0.0005 | In-1 | 0.045 | S-1 | 32.1 |
| | | | | | | | | | A-3 | 1.35 | | | In-2 | 0.045 | | |
| | | | | | | | | | | | | | | | | |
| Example 35 | Dispersion liquid 1 | 45 | M-1 | 9.4 | B-2 | 9.4 | I-1 | 2.25 | A-1 | 0.45 | Su-1 | 0.0005 | In-1 | 0.045 | S-2 | 32.1 |
| | | | | | | | | | A-3 | 1.35 | | | | | | |
| | | | | | | | | | | | | | | | | |
| Example 36 | Dispersion liquid 1 | 45 | M-1 | 9.4 | B-2 | 9.4 | I-1 | 2.25 | A-1 | 0.45 | Su-1 | 0.0005 | In-1 | 0.045 | S-1 | 16.1 |
| | | | | | | | | | A-3 | 1.35 | | | | | S-3 | 16.1 |
| | | | | | | | | | | | | | | | | |

[Table 6]

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 37 | Dispersion liquid 1 | 45 | M-1 | 4.2 | B-2 | 14.7 | I-1 | 2.25 | A-1 | 0.45 | Su-1 | 0.0005 | In-1 | 0.045 | S-1 | 32 |
| | | | | | | | | | A-3 | 1.35 | | | | | | |
| | | | | | | | | | | | | | | | | |
| Example 38 | Dispersion liquid 1 | 45 | M-1 | 12.6 | B-2 | 6.3 | 1-1 | 2.25 | A-1 | 0.45 | Su-1 | 0.0005 | In-1 | 0.045 | S-1 | 32 |
| | | | | | | | | | A-3 | 1.35 | | | | | | |
| | | | | | | | | | | | | | | | | |
| Example 39 | Dispersion liquid 1 | 45 | M-1 | 9.9 | B-2 | 10.1 | I-1 | 1.125 | A-1 | 0.45 | Su-1 | 0.0005 | In-1 | 0.045 | S-1 | 32 |
| | | | | | | | | | A-3 | 1.35 | | | | | | |
| | | | | | | | | | | | | | | | | |
| Example 40 | Dispersion liquid 1 | 45 | M-1 | 8.3 | B-2 | 7.6 | 1-1 | 3.375 | A-1 | 2.25 | Su-1 | 0.0005 | In-1 | 0.045 | S-1 | 32.1 |
| | | | | | | | | | A-3 | 1.35 | | | | | | |
| | | | | | | | | | | | | | | | | |
| Example 41 | Dispersion liquid 1 | 45 | M-1 | 9.6 | B-2 | 9.7 | I-1 | 2.25 | A-3 | 1.35 | Su-1 | 0.0005 | In-1 | 0.045 | S-1 | 32.1 |
| | | | | | | | | | | | | | | | | |
| | | | | | | | | | | | | | | | | |
| Example 42 | Dispersion liquid 1 | 45 | M-1 | 9.4 | B-2 | 9.4 | I-1 | 2.25 | A-1 | 0.45 | Su-1 | 0.0001 | In-1 | 0.045 | S-1 | 32.1 |
| | | | | | | | | | A-3 | 1.35 | | | | | | |
| | | | | | | | | | | | | | | | | |

(continued)

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 43 | Dispersion liquid 1 | 45 | M-1 | 9.4 | B-2 | 9.4 | 1-1 | 2.25 | A-1 | 0.45 | Su-1 | 0.001 | In-1 | 0.045 | S-1 | 32.1 |
| | | | | | | | | | A-3 | 1.35 | | | | | | |
| | | | | | | | | | | | | | | | | |
| Example 44 | Dispersion liquid 1 | 45 | M-1 | 9.4 | B-2 | 9.3 | 1-1 | 2.25 | A-1 | 0.45 | Su-1 | 0.0005 | In-1 | 0.225 | S-1 | 32 |
| | | | | | | | | | A-3 | 1.35 | | | | | | |
| | | | | | | | | | | | | | | | | |
| Example 45 | Dispersion liquid 1 | 45 | M-1 | 9.4 | B-2 | 9.4 | 1-1 | 2.25 | A-1 | 0.45 | Su-1 | 0.0005 | | | S-1 | 32.1 |
| | | | | | | | | | A-3 | 1.35 | | | | | | |
| | | | | | | | | | | | | | | | | |
| Example 46 | Dispersion liquid 1 | 45 | | | B-2 | 18.9 | I-1 | 2.25 | A-1 | 0.45 | Su-1 | 0.0005 | In-1 | 0.045 | S-1 | 32 |
| | | | | | | | | | A-3 | 1.35 | | | | | | |
| | | | | | | | | | | | | | | | | |
| Example 47 | Dispersion liquid 1 | 45 | M-4 | 18.9 | | | I-1 | 2.25 | A-1 | 0.45 | Su-1 | 0.0005 | In-1 | 0.045 | S-1 | 32 |
| | | | | | | | | | A-3 | 1.35 | | | | | | |
| | | | | | | | | | | | | | | | | |

[Table 7]

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 48 | Dispersion liquid 1 | 45 | M-1 | 9.4 | B-7 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 49 | Dispersion liquid 1 | 45 | M-1 | 9.4 | B-8 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 50 | Dispersion liquid 1 | 45 | M-1 | 9.4 | B-9 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 51 | Dispersion liquid 1 | 45 | M-1 | 9.4 | B-10 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 52 | Dispersion liquid 1 | 45 | M-1 | 9.4 | B-11 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 53 | Dispersion liquid 1 | 45 | M-1 | 9.4 | B-12 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |

(continued)

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Example 54 | Dispersion liquid 1 | 45 | M-1 | 9.4 | B-13 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 55 | Dispersion liquid 1 | 45 | M-1 | 9.4 | B-14 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 56 | Dispersion liquid 1 | 45 | M-1 | 9.4 | B-15 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 57 | Dispersion liquid 1 | 45 | M-1 | 9.4 | B-16 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 58 | Dispersion liquid 1 | 45 | M-1 | 9.4 | B-17 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Example 59 | Dispersion liquid 1 | 45 | M-1 | 9.4 | B-18 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |

[Table 8]

| | Dispersion liquid | | Polymerizable monomer | | Resin | | Photopolymerization initiator | | Additive | | Surfactant | | Polymerization inhibitor | | Solvent | |
|---|---|---|---|---|---|---|---|---|---|---|---|---|---|---|---|---|
| | Type | Parts by mass | Type | Parts by mass | Type | Parts by mass | Type | Parts by mass | Type | Parts by mass | Type | Parts by mass | Type | Parts by mass | Type | Parts by mass |
| Comparative example 1 | Dispersion liquid 15 | 45 | M-1 | 9.4 | B-2 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Comparative example 2 | Dispersion liquid 16 | 45 | M-1 | 9.4 | B-2 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Comparative example 3 | Dispersion liquid 1 | 45 | M-1 | 9.4 | B-1 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Comparative example 4 | Dispersion liquid 9 | 45 | M-1 | 9.4 | B-2 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |
| Comparative example 5 | | | M-1 | 15.3 | B-2 | 25.6 | I-1 | 2.25 | A-1 | 0.45 | Su-1 | 0.0005 | In-1 | 0.045 | S-1 | 55 |
| | | | | | | | | | A-3 | 1.35 | | | | | | |
| | | | | | | | | | | | | | | | | |
| Comparative example 6 | Dispersion liquid 01 | 45 | M-1 | 9.4 | B-6 | 9.4 | I-1 | 2.25 | A-1 | 0.45 | Su-1 | 0.0005 | In-1 | 0.045 | S-1 | 32.1 |
| | | | | | | | | | A-3 | 1.35 | | | | | | |
| | | | | | | | | | | | | | | | | |

The raw materials shown above in the table are as follows.

(Dispersion Liquid)

Dispersion Liquids 1 to 16: dispersion liquids 1 to 16 described above

(Polymerizable Monomer)

M-1: KAYARAD DPHA (manufactured by Nippon Kayaku Co., Ltd., dipentaerythritol hexa(meth)acrylate)
M-2: KAYARAD RP-1040 (manufactured by Nippon Kayaku Co., Ltd.)
M-3: NK ESTER A-TMMT (manufactured by Shin-Nakamura Chemical Co., Ltd.)
M-4: Light Acrylate DCP-A (manufactured by KYOEISHA CHEMICAL Co., Ltd., dimethylol-tricyclodecane diacrylate)

(Resin (binder resin))

B-1, B-2, B-5: resins B-1, B-2, and B-5 described above

B-3: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 20000, acid value: 49 mgKOH/g, polymerizable group value: 0 mmol/g)

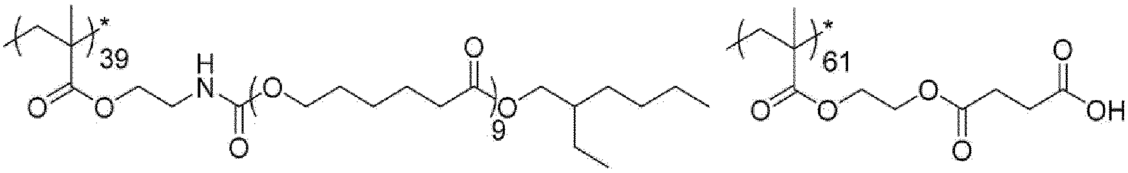

B-4: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 20000, acid value: 75 mgKOH/g, polymerizable group value: 0 mmol/g)

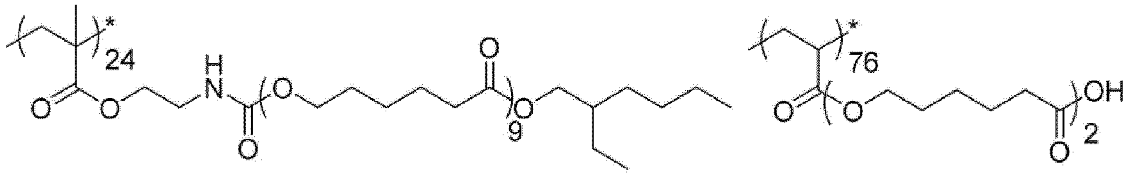

B-6: resin having the following structure (numerical value added to a main chain represents a molar ratio of a repeating unit; weight-average molecular weight: 11000, acid value 69 mgKOH/g, polymerizable group value: 1.4 mmol/g)

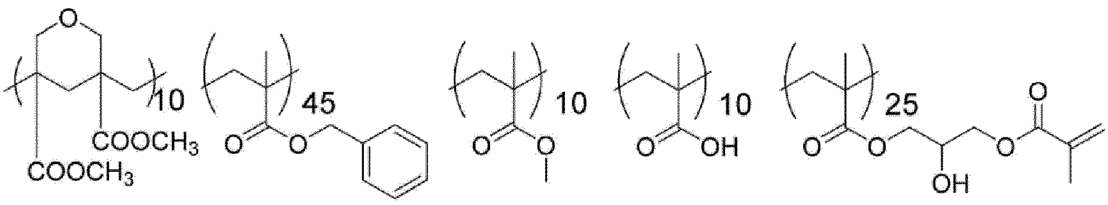

B-7: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 27500, acid value: 58 mgKOH/g, polymerizable group value: 0 mmol/g)

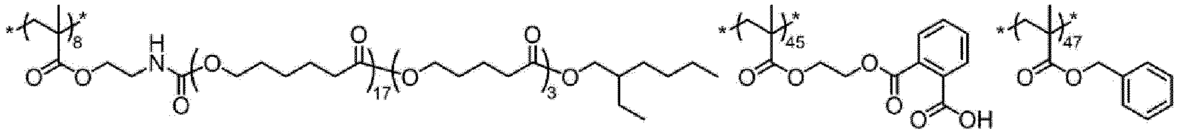

B-8: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 28600, acid value: 61 mgKOH/g, polymerizable group value: 0 mmol/g)

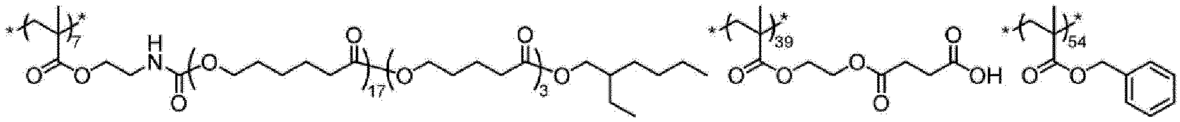

B-9: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 23800, acid value: 59 mgKOH/g, polymerizable group value: 0 mmol/g)

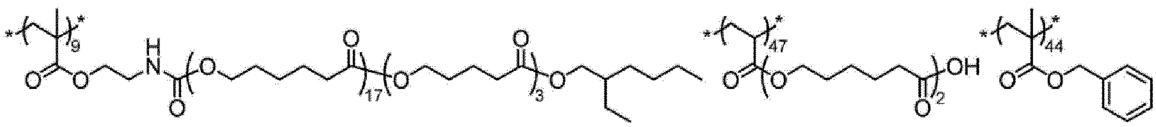

B-10: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 25300, acid value: 62 mgKOH/g, polymerizable group value: 0 mmol/g)

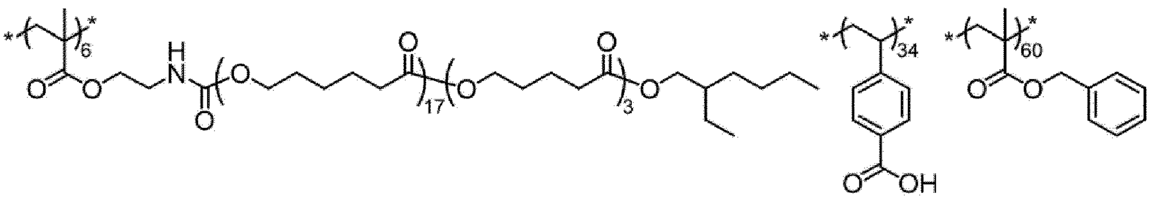

B-11: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 27700, acid value: 58 mgKOH/g, polymerizable group value: 0 mmol/g)

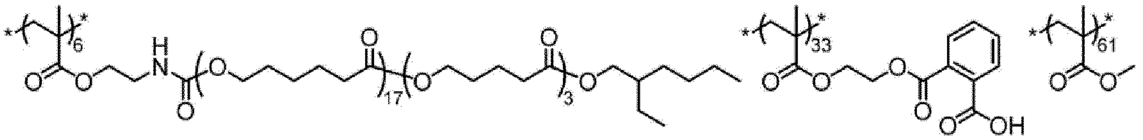

B-12: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 27900, acid value: 58 mgKOH/g, polymerizable group value: 0 mmol/g)

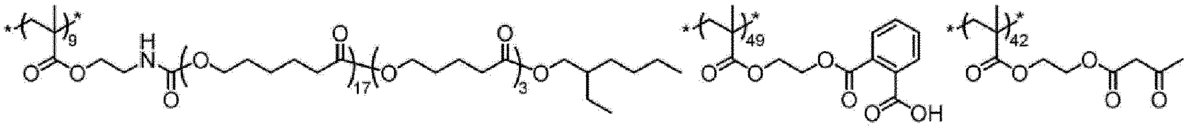

B-13: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 29000, acid value: 57 mgKOH/g, polymerizable group value: 0 mmol/g)

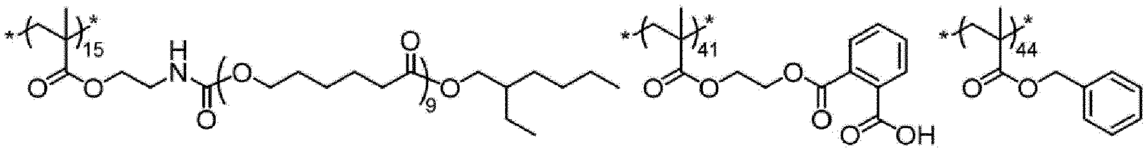

B-14: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 30100, acid value: 60 mgKOH/g, polymerizable group value: 0 mmol/g)

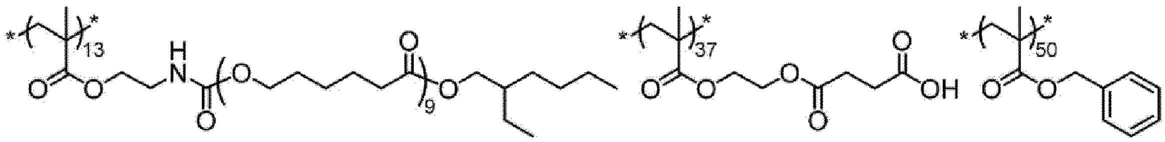

B-15: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 25300, acid value: 57 mgKOH/g, polymerizable group value: 0 mmol/g)

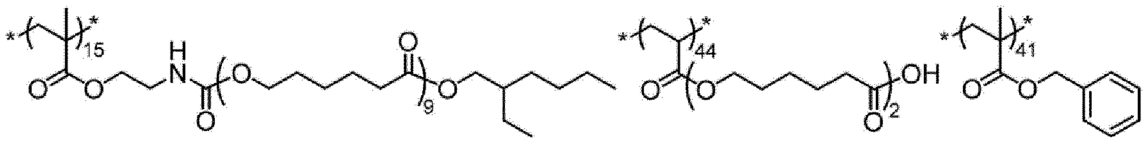

B-16: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 25900, acid value: 61 mgKOH/g, polymerizable group value: 0 mmol/g)

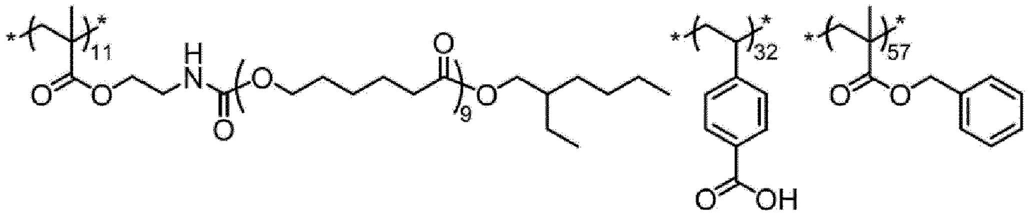

B-17: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 30900, acid value: 58 mgKOH/g, polymerizable group value: 0 mmol/g)

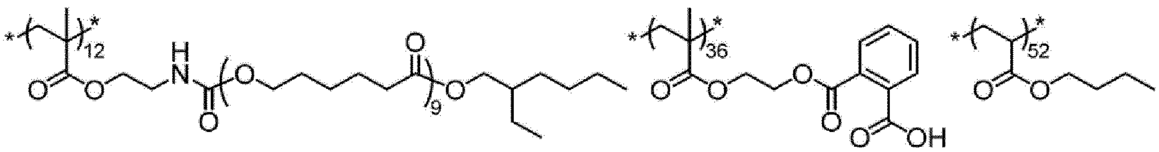

B-18: resin having the following structure (resin including a repeating unit having a graft chain, which includes a repeating unit of a polyester structure; numerical value added to a main chain represents a molar ratio of the repeating unit and numerical value added to a side chain represents the number of repeating units; weight-average molecular weight: 32500, acid value: 59 mgKOH/g, polymerizable group value: 0 mmol/g)

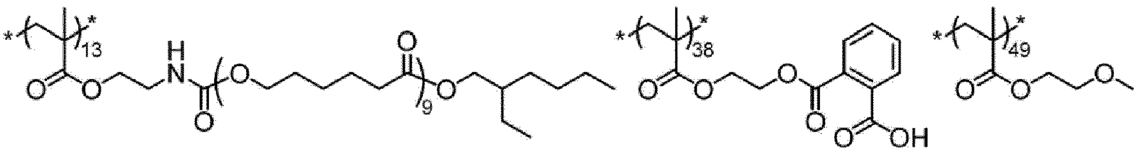

(Photopolymerization Initiator)

I-1: Irgacure OXE01 (manufactured by BASF)
I-2: Omnirad 369 (manufactured by IGM Resins B.V.)
I-3: Omnirad TPO (manufactured by IGM Resins B.V.)

(Additive)

A-1: ADEKA STAB AO-80 (manufactured by Adeka Corporation, anti-coloring agent)
A-2: Irganox 1010 (manufactured by BASF, anti-coloring agent)
A-3: KBM-502 (manufactured by Shin-Etsu Chemical Co., Ltd., silane coupling agent)

(Surfactant)

Su-1: compound shown below ("%" representing the proportion of a repeating unit is mol%; weight-average molecular weight: 14000)

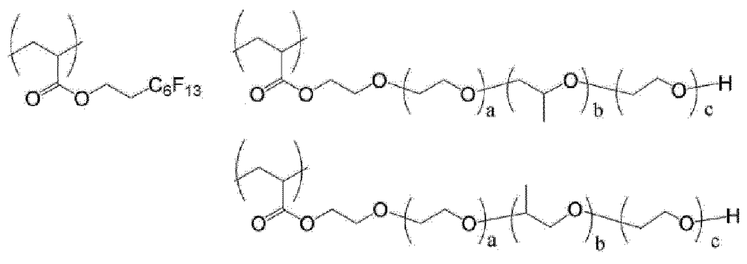

a+c=14
b=17

62% 38%

Su-2: FTERGENT FTX218 (manufactured by NEOS COMPANY LIMITED)

(Polymerization Inhibitor)

In-1: p-methoxyphenol
In-2: 1,4-benzoquinone

(Solvent)

S-1: propylene glycol monomethyl ether acetate (PGMEA)
S-2: propylene glycol monomethyl ether (PGME)
S-3: cyclohexanone

<Maximum value of transmittance>

Each of the compositions was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 110°C for 30 minutes. Next, using an i-ray stepper exposure device FPA-3000 i5+ (manufactured by Canon Corporation), the coating film was exposed to light having a wavelength of 365 nm at an exposure amount of 1000 mJ/$cm^2$. Thereafter, a heating treatment (post-baking) was performed for 5 minutes used a hot plate at 200°C to form a film having a thickness of 4 μm.
Using a spectrophotometer (manufactured by Hitachi High-Technologies Corporation, U-4100), the light transmittance of the obtained film in a wavelength range of 400 to 700 nm was measured, and the maximum value of the transmittance in the range was measured. The maximum value of the transmittance was evaluated based on the following standard.

5: maximum value of the transmittance was 50% or less.
4: maximum value of the transmittance was more than 50% and 60% or less.
3: maximum value of the transmittance was more than 60% and 70% or less.
2: maximum value of the transmittance was more than 70% and 80% or less.
1: maximum value of the transmittance was more than 80%.

<Light scattering properties>

Each of the compositions was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 110°C for 30 minutes. Next, using an i-ray stepper exposure device FPA-3000 i5+ (manufactured by Canon Corporation), the coating film was exposed to light having a wavelength of 365 nm at an exposure amount of 1000 mJ/$cm^2$. Thereafter, a heating treatment (post-baking) was performed for 5 minutes used a hot plate at 200°C to form a film. The haze value Hz of the obtained film was measured using a haze meter (NDH7000, manufactured by NIPPON DENSHOKU INDUSTRIES Co., Ltd.). As the haze value Hz is larger, the light scattering properties are better. The scattering performance was evaluated based on the following standard.

5: haze value Hz was 60% or more.
4: haze value Hz was 40% or more and less than 60%.
3: haze value Hz was 20% or more and less than 60%.
2: haze value Hz was 10% or more and less than 20%.
1: haze value Hz was less than 10%.

<Phase separation state>

Each of the compositions was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 110°C for 30 minutes. Next, using an i-ray stepper exposure device FPA-3000 i5+ (manufactured by Canon Corporation), the coating film was exposed to light having a wavelength of 365 nm at an exposure amount of 1000 mJ/$cm^2$. Thereafter, a heating treatment (post-baking) was performed for 5 minutes used a hot plate at 200°C to form a film.
Using a scanning electron microscope (SEM) (S-4800H, manufactured by Hitachi High-Technologies Corporation), a cross section of the obtained film in a thickness direction was observed (magnification: 10000 times), and the uneven distribution state of the particles was confirmed to check whether a phase-separated state was formed.

A: phase-separated structure between a first phase including the particles and a second phase with a lower content

of the particles than the first phase was formed in the film.

B: phase-separated structure was not formed.

<Storage stability>

Each composition obtained above was placed in a container having a liquid height of 20 cm and allowed to stand in a refrigerator (4 ± 1°C) for 12 months. After standing, a 1 cm solution from the top and a 1 cm solution from the bottom were sampled, and each sample was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after post-baking was 4 μm. The coating film was heat-treated (pre-baked) using a hot plate at 110°C for 120 minutes.

Next, using an i-ray stepper exposure device FPA-3000 i5+ (manufactured by Canon Corporation), the coating film was exposed to light having a wavelength of 365 nm at an exposure amount of 1000 $mJ/cm^2$. Thereafter, a heating treatment (post-baking) was performed for 5 minutes used a hot plate at 200°C to form a film.

Using a spectrophotometer (manufactured by Hitachi High-Technologies Corporation, U-4100), the transmittance of the obtained film at a wavelength of 400 to 700 nm was measured.

The maximum value (T1) of the transmittance of the film formed of the 1 cm solution from the top at a wavelength of 400 to 700 nm, the maximum value (T2) of the transmittance of the film formed of the 1 cm solution from the bottom at a wavelength of 400 to 700 nm, and ΔT which is the difference (T1 - T2) were determined, and storage stability was evaluated based on the following standard. As ΔT is smaller, the storage stability is better.

5: ΔT was 3% or less.
4: ΔT was more than 3% and 5% or less.
3: ΔT was more than 5% and 10% or less.
2: ΔT was more than 10% and 20% or less.
1: ΔT was more than 20% and 100% or less.

<Adhesiveness>

Each of the compositions was applied to an 8-inch (= 203.2 mm) glass wafer with an undercoat layer (manufactured by Fujifilm Electronic Materials Co., Ltd., CT-4000L, thickness: 0.1 μm) using a spin coater such that the thickness after pre-baking was 4 μm. The coating film was heat-treated (pre-baked) using a hot plate at 110°C for 120 minutes.

Next, using an i-ray stepper exposure device FPA-3000 i5+ (manufactured by Canon Corporation), the coating film was exposed to light having a wavelength of 365 nm (exposure amount: 50 to 1700 $mJ/cm^2$) through a pattern mask which forms 25 lines with a width of 100 μm and a length of 1000 μm.

Next, the composition layer after exposure was developed using a developing device (Act8 manufactured by Tokyo Electron Limited.). Shower development was performed at 23°C for 60 seconds using, as a developer, a tetramethylammonium hydroxide (TMAH) 0.3 mass% aqueous solution. Thereafter, the resultant was rinsed by a spin shower using pure water, spin-dried, and then heat-treated (post-baked) for 5 minutes using a hot plate at 200°C to obtain a pattern.

The difference ΔE (E2 - E1) between the minimum exposure amount E1 required to form the pattern with a width of 100 μm and a length of 1000 μm and the minimum exposure amount E2 required for all the patterns to adhere is obtained, and adhesiveness was evaluated based on the following standard. As ΔE is smaller, the adhesiveness is better. The close adhesion of the patterns and the size of the patterns were observed using an optical microscope (magnification: 200 times).

5: ΔE was more than 100 $mJ/cm^2$.
4: ΔE was more than 0 $mJ/cm^2$ and 100 $mJ/cm^2$ or less.
3: ΔE was 0 $mJ/cm^2$.
2: at the exposure amount of 50 to 1700 $mJ/cm^2$, at least one line pattern with a width of 100 μm and a length of 1000 μm could be formed, but not all 25 patterns could be formed.
1: at the exposure amount of 50 to 1700 $mJ/cm^2$, a pattern with a width of 100 μm and a length of 1000 μm could not be formed.

[Table 9]

| | Maximum value of transmittance | Light scattering properties | Phase separation state | Storage stability | Adhesiveness |
|---|---|---|---|---|---|
| Example 1 | 5 | 5 | A | 4 | 4 |
| Example 2 | 5 | 5 | A | 4 | 4 |
| Example 3 | 5 | 5 | A | 4 | 4 |
| Example 4 | 3 | 3 | A | 4 | 4 |
| Example 5 | 4 | 4 | A | 4 | 4 |
| Example 6 | 5 | 5 | A | 4 | 4 |
| Example 7 | 5 | 5 | A | 4 | 4 |
| Example 8 | 5 | 5 | A | 4 | 4 |
| Example 9 | 5 | 5 | A | 4 | 4 |
| Example 10 | 5 | 5 | A | 4 | 4 |
| Example 11 | 5 | 5 | A | 4 | 4 |
| Example 12 | 5 | 5 | A | 4 | 4 |
| Example 13 | 5 | 5 | A | 4 | 4 |
| Example 14 | 5 | 5 | A | 4 | 5 |
| Example 15 | 5 | 5 | A | 5 | 4 |
| Example 16 | 5 | 5 | A | 3 | 4 |
| Example 17 | 5 | 5 | A | 4 | 4 |
| Example 18 | 4 | 4 | A | 5 | 4 |
| Example 19 | 5 | 5 | A | 4 | 4 |
| Example 20 | 5 | 5 | A | 4 | 4 |
| Example 21 | 5 | 5 | A | 4 | 4 |
| Example 22 | 5 | 5 | A | 4 | 4 |

(continued)

| | Maximum value of transmittance | Light scattering properties | Phase separation state | Storage stability | Adhesiveness |
|---|---|---|---|---|---|
| Example 23 | 3 | 3 | A | 4 | 4 |
| Example 24 | 3 | 3 | A | 4 | 4 |
| Example 25 | 3 | 3 | A | 4 | 4 |
| Example 26 | 5 | 5 | A | 4 | 4 |
| Example 27 | 5 | 5 | A | 4 | 4 |
| Example 28 | 5 | 5 | A | 4 | 4 |
| Example 29 | 5 | 5 | A | 4 | 4 |
| Example 30 | 5 | 5 | A | 4 | 3 |
| Example 31 | 5 | 5 | A | 4 | 4 |
| Example 32 | 5 | 5 | A | 4 | 4 |
| Example 33 | 5 | 5 | A | 4 | 4 |
| Example 34 | 5 | 5 | A | 4 | 4 |
| Example 35 | 5 | 5 | A | 4 | 4 |
| Example 36 | 5 | 5 | A | 4 | 4 |
| Example 37 | 4 | 4 | A | 4 | 4 |
| Example 38 | 4 | 4 | A | 4 | 4 |
| Example 39 | 5 | 5 | A | 4 | 4 |
| Example 40 | 5 | 5 | A | 4 | 4 |

[Table 10]

| | Maximum value of transmittance | Light scattering properties | Phase separation state | Storage stability | Adhesiveness |
|---|---|---|---|---|---|
| Example 41 | 5 | 5 | A | 4 | 4 |
| Example 42 | 5 | 5 | A | 4 | 4 |
| Example 43 | 5 | 5 | A | 4 | 4 |

(continued)

| | Maximum value of transmittance | Light scattering properties | Phase separation state | Storage stability | Adhesiveness |
|---|---|---|---|---|---|
| Example 44 | 5 | 5 | A | 4 | 4 |
| Example 45 | 5 | 5 | A | 4 | 4 |
| Example 46 | 4 | 4 | A | 4 | 4 |
| Example 47 | 3 | 3 | A | 4 | 4 |
| Example 48 | 5 | 5 | A | 4 | 4 |
| Example 49 | 5 | 5 | A | 4 | 4 |
| Example 50 | 5 | 5 | A | 4 | 4 |
| Example 51 | 5 | 5 | A | 4 | 4 |
| Example 52 | 5 | 5 | A | 4 | 4 |
| Example 53 | 5 | 5 | A | 4 | 4 |
| Example 54 | 5 | 5 | A | 4 | 4 |
| Example 55 | 5 | 5 | A | 4 | 4 |
| Example 56 | 5 | 5 | A | 4 | 4 |
| Example 57 | 5 | 5 | A | 4 | 4 |
| Example 58 | 5 | 5 | A | 4 | 4 |
| Example 59 | 5 | 5 | A | 4 | 4 |
| Comparative example 1 | 5 | 5 | A | 1 | 4 |
| Comparative example 2 | 1 | 1 | A | 4 | 4 |
| Comparative example 3 | 2 | 2 | B | 4 | 4 |
| Comparative example 4 | 2 | 2 | B | 4 | 4 |
| Comparative example 5 | 1 | 1 | B | 5 | 4 |
| Comparative example 6 | 2 | 2 | B | 5 | 4 |

As shown in the above tables, Examples were excellent in evaluation of storage stability and light scattering properties.

In addition, in Example 1 using the resin B-2 and Examples 48 to 53 using the resins B-7 to B-12, the light scattering properties were evaluated as 5, but among these, Examples 48 to 53 had a higher haze value Hz than that of Example 1 and were more excellent in light scattering properties. Since the resins B-7 to B-12 had a polyester structural graft chain composed of two types of repeating units, crystallinity was slightly lower than that of the resin B-2 having a polyester structural graft chain composed of one type of repeating unit. Therefore, it is assumed that it was possible to prevent a phase separation size from being excessively large in the film, and the light scattering properties were excellent.

In addition, as compared with Examples 23 and 24 using the resins B-3 and B-4, Examples 54 to 59 using the resins B-13 to B-18 were excellent in light scattering properties. Since the resins B-13 to B-18 had a repeating unit including neither a polyester structural graft chain nor an acid group, compatibility with the dispersed resin was slightly higher than that of the resins B-3 and B-4 not having such a repeating unit. Therefore, it is assumed that it was possible to prevent a phase separation size from being excessively large in the film, and the light scattering properties were excellent.

Explanation of References

1, 2: optical sensor
101: photoelectric conversion element
111 to 114: pixels
110: optical filter
121, 122: film
130: transparent support

## Claims

1. A composition comprising:

   particles having a refractive index of 2.0 or more and an average primary particle diameter of 200 nm or less as measured according to the method in the description using a transmission electron microscope;
   a film-forming component including at least one selected from a resin or a polymerizable monomer; and
   a solvent,
   wherein the film-forming component includes two or more kinds of resins, or includes one or more kinds of resins and one or more kinds of polymerizable monomers, and
   in a case where a film having a thickness of 4 $\mu$m is formed by heating the composition at 200°C for 5 minutes, a maximum value of a light transmittance of the film in a wavelength range of 400 to 700 nm is 80% or less, and a phase-separated structure between a first phase including the particles and a second phase with a lower content of the particles than the first phase is formed in the film.

2. The composition according to claim 1,
   wherein the film-forming component includes a resin as a dispersant for the particles, and a resin as a binder.

3. The composition according to claim 1 or 2,
   wherein the film-forming component includes two or more kinds of resins selected from a resin A1 having a structure in which a polymer chain is bonded to a tri- or higher valent linking group and a resin A2 having a repeating unit having a graft chain.

4. The composition according to claim 3,

   wherein the film-forming component includes a resin A1-1 having a structure in which a polymer chain is bonded to a tri- or higher valent linking group and a resin A1-2 having a structure in which a polymer chain including a repeating unit having a structure different from a structure of the polymer chain of the resin A1-1 is bonded to a tri- or higher valent linking group,
   the film-forming component includes a resin A2-1 having a repeating unit having a graft chain and a resin A2-2 having a repeating unit having a graft chain, which includes a repeating unit having a structure different from a structure of the graft chain of the resin A2-1, or
   the film-forming component includes a resin A1-3 having a structure in which a polymer chain is bonded to a tri- or higher valent linking group and a resin A2-3 having a repeating unit having a graft chain, which includes a repeating unit having a structure different from a structure of the polymer chain of the resin A1-3.

5. The composition according to any one of claims 1 to 4,
   wherein the film-forming component includes at least one kind selected from a resin having a structure in which a polymer chain including a repeating unit of a polyester structure is bonded to a tri- or higher valent linking group or a resin having a repeating unit having a graft chain, which includes a repeating unit of a polyester structure.

6. The composition according to any one of claims 1 to 5,
   wherein the film-forming component includes a polymerizable monomer including a ring structure.

7. The composition according to claim 2,
   wherein the resin as a binder is included in an amount of 40 to 250 parts by mass with respect to 100 parts by mass

of the resin as a dispersant for the particles.

**8.** The composition according to any one of claims 1 to 7, wherein the particles are inorganic particles.

**9.** The composition according to any one of claims 1 to 8, wherein the average primary particle diameter of the particles is 100 nm or less.

**10.** The composition according to any one of claims 1 to 9, wherein the composition includes two or more kinds of the particles.

**11.** A film which is formed of the composition according to any one of claims 1 to 10.

**12.** An optical sensor comprising: the film according to claim 11.

## Patentansprüche

**1.** Zusammensetzung, umfassend:

Partikel mit einem Brechungsindex von 2,0 oder mehr und einem durchschnittlichen Primärpartikeldurchmesser von 200 nm oder weniger, gemessen nach dem Verfahren in der Beschreibung unter Verwendung eines Transmissionselektronenmikroskops;
eine filmbildende Komponente, einschließlich mindestens eines, ausgewählt aus einem Harz oder einem polymerisierbaren Monomer; und
ein Lösungsmittel,
wobei die filmbildende Komponente zwei oder mehr Arten von Harzen einschließt oder eine oder mehrere Arten von Harzen und eine oder mehrere Arten von polymerisierbaren Monomeren einschließt und
in einem Fall, in dem ein Film mit einer Dicke von 4 μm durch Erhitzen der Zusammensetzung auf 200 °C für 5 Minuten gebildet wird, ein Maximalwert einer Lichtdurchlässigkeit des Films in einem Wellenlängenbereich von 400 bis 700 nm 80 % oder weniger beträgt und eine phasengetrennte Struktur zwischen einer ersten Phase einschließlich der Partikel und einer zweiten Phase mit einem geringeren Gehalt der Partikel als die erste Phase in dem Film gebildet wird.

**2.** Zusammensetzung nach Anspruch 1, wobei die filmbildende Komponente ein Harz als Dispergiermittel für die Partikel und ein Harz als Bindemittel einschließt.

**3.** Zusammensetzung nach Anspruch 1 oder 2, wobei die filmbildende Komponente zwei oder mehr Arten von Harzen einschließt, ausgewählt aus einem Harz A1 mit einer Struktur, in der eine Polymerkette an eine drei- oder höherwertige Verbindungsgruppe gebunden ist, und einem Harz A2 mit einer Wiederholungseinheit mit einer Pfropfkette.

**4.** Zusammensetzung nach Anspruch 3,

wobei die filmbildende Komponente ein Harz A1-1 mit einer Struktur, in der eine Polymerkette an eine drei- oder höherwertige Verbindungsgruppe gebunden ist, und ein Harz A1-2 mit einer Struktur, in der eine Polymerkette einschließlich einer Wiederholungseinheit mit einer Struktur, die sich von einer Struktur der Polymerkette des Harzes A1-1 unterscheidet, an eine drei- oder höherwertige Verbindungsgruppe gebunden ist, einschließt,
die filmbildende Komponente ein Harz A2-1 mit einer Wiederholungseinheit mit einer Pfropfkette und ein Harz A2-2 mit einer Wiederholungseinheit mit einer Pfropfkette, die eine Wiederholungseinheit mit einer Struktur einschließt, die sich von einer Struktur der Pfropfkette des Harzes A2-1 unterscheidet, einschließt oder
die filmbildende Komponente ein Harz A1-3 mit einer Struktur, in der eine Polymerkette an eine drei- oder höherwertige Verbindungsgruppe gebunden ist, und ein Harz A2-3 mit einer Wiederholungseinheit mit einer Pfropfkette, die eine Wiederholungseinheit mit einer Struktur einschließt, die sich von einer Struktur der Polymerkette des Harzes A1-3 unterscheidet, einschließt.

**5.** Zusammensetzung nach einem der Ansprüche 1 bis 4, wobei die filmbildende Komponente mindestens eine Art einschließt, ausgewählt aus einem Harz mit einer Struktur, in der eine Polymerkette einschließlich einer Wiederholungseinheit einer Polyesterstruktur an eine drei- oder höherwertige Verbindungsgruppe gebunden ist, oder einem Harz mit einer Wiederholungseinheit mit einer Pfropfkette, die eine Wiederholungseinheit einer Polyesterstruktur einschließt.

**6.** Zusammensetzung nach einem der Ansprüche 1 bis 5, wobei die filmbildende Komponente ein polymerisierbares Monomer einschließlich einer Ringstruktur einschließt.

**7.** Zusammensetzung nach Anspruch 2, wobei das Harz als Bindemittel in einer Menge von 40 bis 250 Masseteilen bezogen auf 100 Masseteile des Harzes als Dispergiermittel für die Partikel eingeschlossen ist.

**8.** Zusammensetzung nach einem der Ansprüche 1 bis 7, wobei die Partikel anorganische Partikel sind.

**9.** Zusammensetzung nach einem der Ansprüche 1 bis 8, wobei der durchschnittliche Primärpartikeldurchmesser der Partikel 100 nm oder weniger beträgt.

**10.** Zusammensetzung nach einem der Ansprüche 1 bis 9, wobei die Zusammensetzung zwei oder mehr Arten der Partikel einschließt.

**11.** Film, der aus der Zusammensetzung nach einem der Ansprüche 1 bis 10 gebildet ist.

**12.** Optischer Sensor, umfassend: den Film nach Anspruch 11.

## Revendications

**1.** Composition comprenant :

des particules ayant un indice de réfraction de 2,0 ou plus et un diamètre moyen de particules primaires de 200 nm ou moins, tel que mesuré selon le procédé dans la description à l'aide d'un microscope électronique à transmission ;
un composant filmogène comprenant au moins l'un choisi parmi une résine ou un monomère polymérisable ; et un solvant,
dans laquelle le composant filmogène comprend deux types de résines ou plus, ou comprend un ou plusieurs types de résines et un ou plusieurs types de monomères polymérisables, et
dans le cas où un film ayant une épaisseur de 4 $\mu$m est formé en chauffant la composition à 200° C pendant 5 minutes, une valeur maximale d'une transmission lumineuse du film dans une plage de longueurs d'onde de 400 à 700 nm est de 80 % ou moins, et une structure à séparation de phases entre une première phase comprenant les particules et une seconde phase ayant une teneur en particules inférieure à celle de la première phase est formée dans le film.

**2.** Composition selon la revendication 1, dans laquelle le composant filmogène comprend une résine comme dispersant pour les particules, et une résine comme liant.

**3.** Composition selon la revendication 1 ou 2, dans laquelle le composant filmogène comprend deux types ou plus de résines sélectionnées parmi une résine A1 ayant une structure dans laquelle une chaîne polymère est liée à un groupe de liaison trivalent ou de valence supérieure et une résine A2 ayant une unité répétitive ayant une chaîne greffée.

**4.** Composition selon la revendication 3,

dans laquelle le composant filmogène comprend une résine A1-1 ayant une structure dans laquelle une chaîne polymère est liée à un groupe de liaison trivalent ou de valence supérieure et une résine A1-2 ayant une structure

dans laquelle une chaîne polymère comprenant une unité répétitive ayant une structure différente d'une structure de la chaîne polymère de la résine A1-1 est liée à un groupe de liaison trivalent ou de valence supérieure,
le composant filmogène comprend une résine A2-1 ayant une unité répétitive ayant une chaîne greffée et une résine A2-2 ayant une unité répétitive ayant une chaîne greffée, qui comprend une unité répétitive ayant une structure différente d'une structure de la chaîne greffée de la résine A2-1, ou
le composant filmogène comprend une résine A1-3 ayant une structure dans laquelle une chaîne polymère est liée à un groupe de liaison trivalent ou de valence supérieure et une résine A2-3 ayant une unité répétitive ayant une chaîne greffée, qui comprend une unité répétitive ayant une structure différente d'une structure de la chaîne polymère de la résine A1-3.

**5.** Composition selon l'une quelconque des revendications 1 à 4 ;
dans laquelle le composant filmogène comprend au moins un type choisi parmi une résine ayant une structure dans laquelle une chaîne polymère comprenant une unité répétitive d'une structure polyester est liée à un groupe de liaison trivalent ou de valence supérieure ou une résine ayant une unité répétitive ayant une chaîne greffée, qui comprend une unité répétitive d'une structure en polyester.

**6.** Composition selon l'une quelconque des revendications 1 à 5,
dans laquelle le composant filmogène comprend un monomère polymérisable comprenant une structure cyclique.

**7.** Composition selon la revendication 2,
dans laquelle la résine en tant que liant est incluse en une quantité de 40 à 250 parties en masse par rapport à 100 parties en masse de la résine en tant que dispersant pour les particules.

**8.** Composition selon l'une quelconque des revendications 1 à 7,
dans laquelle les particules sont des particules inorganiques.

**9.** Composition selon l'une quelconque des revendications 1 à 8,
dans laquelle le diamètre moyen de particules primaires des particules est de 100 nm ou moins.

**10.** Composition selon l'une quelconque des revendications 1 à 9,
dans laquelle la composition comprend deux types ou plus des particules.

**11.** Film qui est formé de la composition selon l'une quelconque des revendications 1 à 10.

**12.** Capteur optique comprenant :
le film selon la revendication 11.

FIG. 1

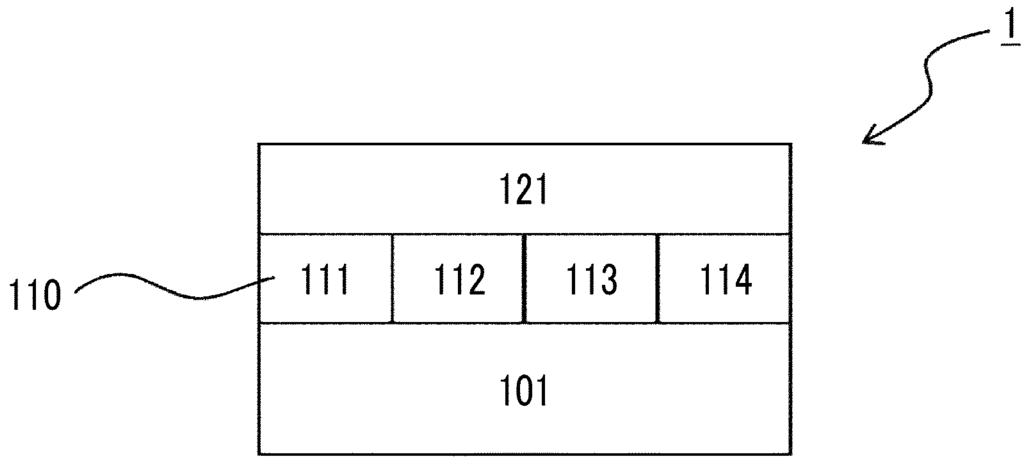


FIG. 2

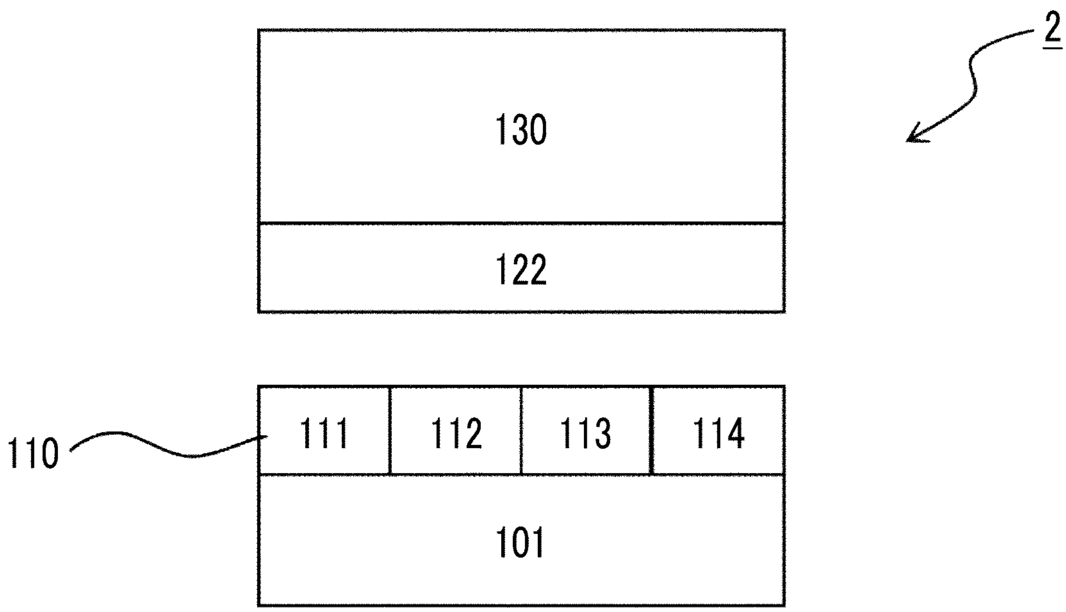

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016161859 A
- EP 3431513 A1
- JP 2015067794 A
- JP 2013237593 A
- WO 2007060884 A
- JP 2012208494 A
- US 20120235099 A
- JP 2012198408 A
- JP 2010168539 A
- JP 2013029760 A
- JP 2014177613 A
- JP 2013043962 A
- WO 2018163668 A
- JP 2012137564 A
- JP 2017194662 A
- JP 2007269779 A
- JP 2014089408 A
- JP 2010054632 A
- WO 2015166779 A
- JP 2014130173 A
- JP 6301489 B
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- JP 2014137466 A
- WO 2013083505 A
- JP 2010262028 A
- JP 2014500852 A
- JP 2013164471 A
- JP 2013114249 A
- JP 4223071 B
- WO 2015036910 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 2009258603 A
- JP 2011252065 A
- JP 2015034961 A
- JP 2012208374 A
- JP 2013068814 A
- JP 2009288703 A
- JP 2009242604 A
- JP 2010106268 A
- US 20110124824 A
- JP 2014041318 A
- WO 2014017669 A
- JP 2011132503 A
- JP 2016216602 A
- JP 2010032698 A
- JP 2010164965 A
- JP 2015117327 A
- JP 2015123351 A
- JP 2015157893 A
- JP 2015194521 A
- JP 2012046629 A
- JP 2009145395 A
- JP 2003262716 A
- JP 2003185831 A
- JP 2003261827 A
- JP 2012126830 A
- JP 2006169325 A
- KR 1020170122130 A
- JP 2013064993 A


### Non-patent literature cited in the description


- **MANABU KIYONO.** Titanium Oxide - Physical Properties and Applied Technology. Gihodo Shuppan Co., Ltd, 25 June 1991, 13-45
- Ultrafine Particles and Materials. SHOKABO Co., Ltd, 1993
- Manufacturing & Application of Microspheres & Powders. CMC Publishing Co., Ltd, 2005
- The Chemical Daily. Toyo Gosei Co., Ltd, 13 November 2015
- *J. C. S. Perkin II,* 1979, 1653-1660

- *J. C. S. Perkin II,* 1979, 156-162
- *Journal of Photopolymer Science and Technology,* 1995, 202-232
- *CHEMICAL ABSTRACTS,* 29598-76-3
- *CHEMICAL ABSTRACTS,* 10595-72-9
- The Chemical Daily. Miyoshi Oil&Fat Co., Ltd, 01 February 2016
- The Chemical Daily. DIC Corporation, 22 February 2016
- *Nikkei Business Daily,* 23 February 2016
- Complete Works of Dispersion Technology. Johokiko Co., Ltd, 15 July 2005
- Dispersion Technique focusing on Suspension (Solid/Liquid Dispersion) and Practical Industrial Application, Comprehensive Reference List. Publishing Department of Management Development Center, 10 October 1978
- Extension of Use of Ink Jet - Infinite Possibilities in Patent. S.B. Research Co., Ltd, February 2005, 115-133